(19) Europäisches Patentamt / European Patent Office / Office européen des brevets

(11) EP 1 849 042 B1

# (12) EUROPEAN PATENT SPECIFICATION

(45) Date of publication and mention of the grant of the patent:
**10.12.2008 Bulletin 2008/50**

(21) Application number: **06701509.9**

(22) Date of filing: **01.02.2006**

(51) Int Cl.:
***G03F 7/32*** *(2006.01)*

(86) International application number:
**PCT/EP2006/000878**

(87) International publication number:
**WO 2006/087102 (24.08.2006 Gazette 2006/34)**

(54) **PROCESS FOR THE PRODUCTION OF LITHOGRAPHIC PRINTING PLATES**

VERFAHREN ZUR HERSTELLUNG VON LITHOGRAPHISCHEN DRUCKPLATTEN

PROCEDE DE PRODUCTION DE CLICHES LITHOGRAPHIQUES

(84) Designated Contracting States:
**FR GB**

(30) Priority: **18.02.2005 DE 102005007615**

(43) Date of publication of application:
**31.10.2007 Bulletin 2007/44**

(73) Proprietor: **Kodak Graphic Communications GmbH**
**37520 Osterode/Harz (DE)**

(72) Inventors:
- **BAUMANN, Harald**
  **37520 Osterode (DE)**
- **FIEBAG, Ulrich**
  **31688 Nienstaedt (DE)**
- **DWARS, Udo**
  **37412 Herzberg (DE)**
- **STREHMEL, Bernd**
  **13585 Berlin (DE)**
- **FLUGEL, Michael**
  **37520 Osterode (DE)**
- **TIMPE, Hans-Joachim**
  **37520 Osterode (DE)**

(74) Representative: **Englbrecht, Ursula**
**Vossius & Partner**
**Siebertstrasse 4**
**81675 München (DE)**

(56) References cited:
**EP-A- 0 320 945**
**EP-A- 1 115 035**
**EP-A- 1 253 472**
**EP-A- 1 503 247**
**JP-A- 2003 162 072**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 849 042 B1

## Description

The present invention relates to a process for the production of lithographic printing plates. The invention furthermore relates to printing plates produced according to this process.

Lithographic printing is based on the immiscibility of oil and water, wherein the oily material or the printing ink is preferably accepted by the image area, and the water or fountain solution is preferably accepted by the non-image area. When an appropriately produced surface is moistened with water and a printing ink is applied, the background or non-image area accepts the water and repels the printing ink, while the image area accepts the printing ink and repels the water. The printing ink in the image area is then transferred to the surface of a material such as paper, fabric and the like, on which the image is to be formed. Generally, however, the printing ink is first transferred to an intermediate material, referred to as blanket, which then in turn transfers the printing ink onto the surface of the material on which the image is to be formed; this technique is referred to as offset lithography.

A frequently used type of lithographic printing plate precursor comprises a photosensitive coating applied onto a substrate on aluminum basis. The coating can react to radiation such that the exposed portion becomes so soluble that it is removed during the developing process. Such a plate is referred to as positive working. On the other hand, a plate is referred to as negative working if the exposed portion of the coating is hardened by the radiation. In both cases, the remaining image area accepts printing ink, i.e. is oleophilic, and the non-image area (background) accepts water, i.e. is hydrophilic. The differentiation between image and non-image areas takes place during exposure, for which a film is attached to the printing plate precursor - under vacuum in order to guarantee good contact. The plate is then exposed by means of a radiation source. When a positive plate is used, the area on the film corresponding to the image on the plate is so opaque that the light does not reach the plate, while the area on the film corresponding to the non-image area is clear and allows light to permeate the coating, whose solubility increases. In the case of a negative plate, the opposite takes place: The area on the film corresponding to the image on the plate is clear, while the non-image area is opaque. The coating beneath the clear film area is hardened due to the incident light, while the area not reached by the light is removed during developing. The light-hardened surface of a negative working plate is therefore oleophilic and accepts printing ink, while the non-image area that used to be coated with the coating removed by the developer is desensitized and therefore hydrophilic.

Alternatively, the plate can also be exposed digitally without a film, e.g. with a UV laser.

Photosensitive mixtures have been used for years in photopolymerizable compositions for the production of photosensitive materials such as e.g. printing plate precursors.

However, an improved sensitivity in particular in the UV and visible spectral ranges as well as a high processing speed are required for new and advanced applications (e.g. exposure by means of lasers). Furthermore, the plates should transfer consistent tonal values during printing and print without a tendency to toning. Tests have shown that these properties are influenced to a high degree by the type of liquid used for developing. Therefore, there is high demand for improved printing plate developers.

The document DE 32 23 386 A1 describes a process for developing positive working radiation-sensitive coatings comprising o-naphthoquinone diazide. The developer used for this purpose comprises e.g. ethoxylated alkanediols as tensides. The developer is intended to prevent an attack of the substrate surface due to the high degree of alkalinity of the developers necessary for o-naphthoquinone diazides.

Documents EP-A1-1 115 035 and US 6,455,234 B1 describe alkoxylated acetylenic diols which cause a low surface tension in developers as tensides during the production of semiconductors and at the same time reduce foaming. The aqueous photoresist developers comprise 10 to 10,000 ppm of the alkoxylated derivatives as well as 0.1 to 3 wt.-% tetramethyl ammonium hydroxide. It has been found that such developers lead to strong dot sharpening in lithographic printing plates.

EP-A2-1 253 472 discloses alkaline developers for IR-sensitive positive working lithographic printing plate precursors comprising for example silicates or non-reducing sugars and acetylene glycols or ethoxylated derivatives thereof. It has been found that the use of silicate results in plates with a tendency to toning during printing; furthermore, the use of reducing sugars leads to a sludging of the developing machine.

Aqueous alkaline developers comprising an alkali silicate or metasilicate, a non-ionic tenside and an anionic or amphoteric tenside are described in EP-A1-0 732 628. A number of examples are given for non-ionic tensides, *inter alia* ethoxylated tetramethyl decinediol. However, it has been found that the use of such developers leads to toning problems during printing.

JP 2000-056480 describes resist strippers which comprise, in addition to water, hydroxyl amine, amines with pKa=7.5 to 13, a water-soluble organic solvent and acetylene alcohol/alkylene oxide adducts. However, it has been found that these solutions lead to strong dot sharpening in lithographic printing plates.

DE 44 11 176 A1 is directed to developers for pre-sensitized lithographic printing plates comprising an alkali silicate and a water-soluble ethylene oxide adduct of a sugar alcohol.

In document EP-A1-1 199 606 developer solutions comprising, in addition to an inorganic alkali reagent, a non-ionic tenside with a polyoxyalkylene ether group are used for developing negative working lithographic printing plate precursors. Other developers with a non-ionic tenside comprising a polyoxyalkylene ether group are described in EP 1 353 235 A1, US 6,686,126 B2, EP 1 172 699 A1, US 3,586,504, EP 1 346 843 A1 and US 6,641,980 B2.

US 4,098,712 discloses alkaline developer solutions which may comprise alkyl and alkylaryl ethers of polyethylene glycol as tensides.

US 4,959,296 describes developers for the production of lithographic printing plates which print without fountain solution; these developers may comprise non-ionic tensides with polyoxyethylene units.

Documents EP 0 111 136 A2 and EP 0 269 760 A1 describe fountain solution compositions for offset printing; these compositions can for example comprise ethoxylation products of 2,4,7,9-tetramethyl-5-decine-4,7-diol as wetting agent.

US 2004/0,053,172 A1 suggests solutions of alkoxylated acetylene diols for improving the surface wettability of substrate materials prior to coating them.

Documents JP 08-286386 and JP 2000-194135 describe positive resist compositions comprising a component which upon irradiation releases an acid, as well as a resin which is broken down by the acid and thus becomes soluble in the developer. Solutions of tetramethyl ammonium hydroxide comprising a tenside with acetylene-polyoxyethylene structure are used as developers; such a developer is also described in JP 10-171128.

JP 2003-162072 describes negative working planographic printing plate precursors comprising a titanocene initiator in the radiation-sensitive coating. The developers used for these precursors comprise several alkali reagents as well as an acetylene alcohol and/or an acetylene glycol together with a polyoxyalkylene ether tenside.

EP 1 260 867 A1 describes developers for negative working IR-sensitive coatings comprising non-ionic tensides; the tensides listed comprise polyoxyalkylene units.

US 6,638,687 B2 and EP 1 213 619 A1 describe negative working lithographic printing plate precursors whose coating comprises a special urethane binder which is difficult to produce and therefore expensive. The developers used for these precursors comprise a non-ionic tenside with a polyoxyalkylene ether group.

WO 02/31599 describes aqueous developers for negative working lithographic printing plate precursors comprising one or more filter dyes or one or more free-radical inhibitors. With the help of these components the formation of sludge in the processor can be considerably reduced or prevented.

DE 198 45 605 A1 is directed to an alkaline aqueous developer concentrate comprising an amphoteric tenside, an anionic tenside, a complexing agent, an amino alcohol and an N-alkoxylated mono- or polyfunctional amine. According to this document, developers can be produced from this concentrate that are suitable for positive working, negative working and reversal process coatings of printing plate precursors etc. and which do not lead to sludging in the processor.

EP 0 080 042 A1 discloses developers for light-hardenable coatings with a highly molecular organic polymer with an acid number of 10 to 200 and a diazo resin; the developer comprises an organic solvent, an alkali reagent, a tenside and a water-softening agent; polyglycol alkylphenyl ethers and polyglycol alkyl ethers are e.g. mentioned as non-ionic tensides. The water-softening agent is supposed to prevent the formation of sludge in the developer.

It is the object of the present invention to provide a process for the production of lithographic printing plates which allows a high developing speed and causes no or very little formation of sludge in the processor; at the same time, no toning problems should arise when the plates are used for printing and the relative dot sharpening should be low. Furthermore, the printing plate precursors should exhibit yellow light stability and the developer used in the process should not attack the seals of the pump valves. Also, the developer should require as few components as possible.

The object of the invention is achieved by a process for the production of lithographic printing plates comprising

(a) providing a lithographic substrate with a hydrophilic surface and

(b) applying a negative working radiation-sensitive composition onto the hydrophilic surface, wherein the composition comprises

(i) one or more types of monomers and/or oligomers and/or polymers, each comprising at least one ethylenically unsaturated group accessible to a free-radical polymerization,
(ii) at least one sensitizer which in the presence of at least one coinitiator and upon irradiation with radiation of a wavelength of 300 to <480 nm or >750 to 1,100 nm initiates the free-radical polymerization of component (i); and
(iii) at least one binder with acidic functional groups
and is substantially not sensitive to the wavelength range of 480 to 750 nm;

(c) image-wise exposure of the resulting negative working lithographic printing plate precursor to radiation selected from the wavelength range of 300 to <480 nm or >750 to 1,100 nm depending on the sensitizer or initiator system used; and

(d) removing the non-irradiated areas by means of a treatment with an alkaline developer with a pH value in the range of 9 to 14 comprising

(i) water,
(ii) one or more alkali hydroxides in an amount sufficient for adjusting a pH value in the range of 9 to 14, and
(iii) 1 to 30 wt.-% of at least one compound of formula (I)

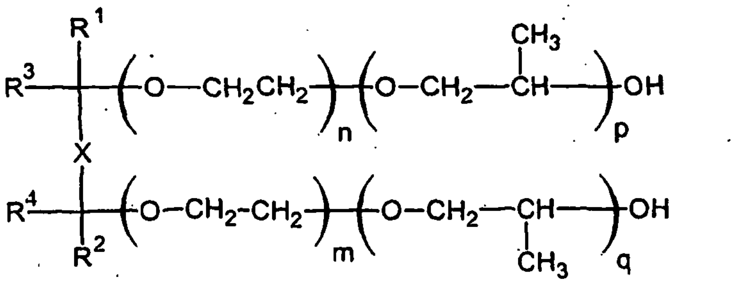

(I)

wherein $R^1$, $R^2$, $R^3$ and $R^4$ are each independently selected from $C_1$-$C_{12}$ alkyl groups and aryl groups,
X is selected from -CH=CH-, -C≡C-,

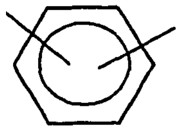

,

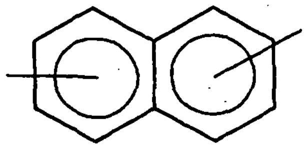

and

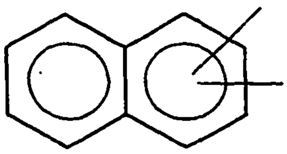

,

n + m results in a value of 2 to 30 and
p + q results in a value of 0 to 30, wherein in the case of $p + q \neq 0$ the ethylene oxide and propylene oxide units are present as blocks or randomly distributed.

As used in the present invention, the term lithographic printing plate (also referred to as "lithographic printing form") refers to an imaged printing plate produced from a lithographic printing plate precursor.

Unless defined otherwise, the term "alkyl group" as used in the present invention refers to a straight-chain, branched or cyclic saturated hydrocarbon group preferably comprising 1 to 18 carbon atoms, especially preferred 1 to 10 carbon atoms and most preferred 1 to 6 carbon atoms. The alkyl group can optionally comprise one or more substituents (preferably 0 or 1 substituent) selected for example from halogen atoms (fluorine, chlorine, bromine, iodine), CN, $NO_2$, $NR^7_2$, $COOR^7$ and $OR^7$ ($R^7$ independently represents a hydrogen atom, an alkyl group or an aryl group). The above definition also applies to the alkyl unit of an aralkyl group and an alkoxy group.

Unless defined otherwise, the term "aryl group" as used in the present invention refers to an aromatic carbocyclic group with one or more fused rings, which preferably comprises 5 to 14 carbon atoms. The aryl group can optionally comprise one or more substituents (preferably 0 to 3) selected for example from halogen atoms, alkyl groups, alkoxy groups, CN, $NO_2$, $NR^7_2$, $COOR^7$ and $OR^7$ (wherein each $R^7$ is independently selected from hydrogen, alkyl and aryl). The above definition also applies to the aryl unit of an aralkyl group and the aryl unit of an aryloxy group. Preferred examples include a phenyl group and a naphthyl group which can optionally be substituted.

*Free-radical polymerizable component*

All monomers, oligomers and polymers which are free-radical polymerizable and comprise at least one C-C double bond can be used as ethylenically unsaturated monomers, oligomers and polymers. Monomers/oligomers/polymers with C-C triple bonds can also be used, but they are not preferred. Suitable compounds are well known to the person skilled in the art and can be used in the present invention without any particular limitations. Esters of acrylic and methacrylic acids, itaconic acid, crotonic acid, isocrotonic acid, maleic acid and fumaric acid with one or more unsaturated groups in the form of monomers, oligomers or prepolymers are preferred. Furthermore, monomers, oligomers and prepolymers comprising styrene groups can be used. They may be present in solid or liquid form, with solid and highly viscous forms being preferred. Compounds suitable as monomers include for instance trimethylol propane triacrylate and trimethacrylate, pentaerythritol triacrylate and trimethacrylate, dipentaerythritolmonohydroxy pentaacrylate and pentamethacrylate, dipentaerythritol hexaacrylate and methacrylate, pentaerythritol tetraacrylate and tetramethacrylate, ditrimethylol propane tetraacrylate and tetramethacrylate, diethyleneglycol diacrylate and dimethacrylate, triethyleneglycol diacrylate and dimethacrylate or tetraethyleneglycol diacrylate and dimethacrylate. Suitable oligomers and/or prepolymers are for example urethane acrylates and methacrylates, epoxide acrylates and methacrylates, polyester acrylates and methacrylates, polyether acrylates and methacrylates or unsaturated polyester resins.

In addition to monomers and/or oligomers, use can also be made of polymers comprising free-radical polymerizable C-C double bonds in the main or side chains. Examples thereof include reaction products of maleic acid anhydride copolymers and hydroxyalkyl(meth)acrylates (cf. e.g. DE-A-4 311 738); (meth)acrylic acid polymers, partially or fully esterified with allyl alcohol (cf. e.g. DE-A-3 332 640); reaction products of polymeric polyalcohols and isocyanatoalkyl (meth)acrylates; unsaturated polyesters; (meth)acrylate-terminated polystyrenes; polymers with styrene side groups (cf. US 6,746,820); poly(meth)acrylic acid esters, poly(meth)acrylic acids, poly(meth)acrylamides; (meth)acrylic acid polymers, partially or fully esterified with epoxides comprising free-radical polymerizable groups; and polymers with allyl side-groups which can for example be obtained by polymerization of allyl(meth)acrylate, optionally with further comonomers.

Free-radical polymerizable compounds that can be used in the present invention also include compounds that have a molecular weight of 3,000 or less and are reaction products obtained by reacting a diisocyanate with (i) an ethylenically unsaturated compound with a hydroxy group, and at the same time (ii) a saturated organic compound with one NH group and one OH group, wherein the reactants are used in amounts according to the following condition:

Number of moles of isocyanate groups ≤ number of moles of OH plus NH groups. Examples of diisocyanates are represented by the following formula:

$$O = C = N -(GR^8_2)_a- D -(CR^8_2)_b- N = C = O \qquad (II)$$

wherein a and b independently represent 0 or an integer from 1 to 3, each $R^8$ is independently selected from H and $C_1$-$C_3$ alkyl and D is a saturated or unsaturated spacer which can optionally comprise further substituents in addition to the two isocyanate groups. D can be a chain-shaped or a ring-shaped unit. As used in the present invention, the term "diisocyanate" refers to an organic compound comprising two isocyanate groups but no OH groups and no secondary or primary amino groups.

$R^8$ is preferably H or $CH_3$.
a and b are preferably independently 0 or 1.

D can for example be an alkylene group $(CH_2)_w$, wherein w is an integer from 1 to 12, preferably 1 to 6, and one or more hydrogen atoms are optionally replaced with substituents such as e.g. alkyl groups (preferably $C_1$-$C_6$), a cycloalkylene group, an arylene group or a saturated or unsaturated heterocyclic group.

Suitable diisocyanates are for example the following:

Trimethylhexamethylene diisocyanate
1,6-bis-[isocyanate]-hexane
5-isocyanate-3-(isocyanatomethyl)-1,1,3-trimethylcyclohexane
1,3-bis-[5-isocyanate-1,1,3-trimethyl-phenyl]-2,4-dioxo-1,3-diazetidine
3,6-bis-[9-isocyanatononyl]-4,5-di-(1-heptenyl)-cyclohexene
bis-[4-isocyanate-cyclohexyl]-methane
trans-1,4-bis-[isocyanate]-cyclohexane
1,3-bis-[isocyanatomethyl]-benzene
1,3-bis-[1-isocyanate-1-methyl-ethyl]-benzene
1,4-bis-[2-isocyanatoethyl]-cyclohexane
1,3-bis-[isocyanatomethyl]-cyclohexane
1,4-bis-[1-isocyanate-1-methyl-ethyl]benzene

bis-[isocyanate]-isododecyl-benzene
1,4-bis-[isocyanate]-benzene
2,4-bis-[isocyanate]-toluene
2,6-bis-[isocyanate]-toluene
N,N'-bis-[3-isocyanate-4-methyl-phenyl] urea
1,3-bis-[3-isocyanate-4-methyl-phenyl]-2,4-dioxo-1,3-diazetidine
bis-[2-isocyanate-phenyl]-methane
(2-isocyanate-phenyl)-(4-isocyanate-phenyl)-methane
bis-[4-isocyanate-phenyl]-methane
1,5-bis-[isocyanate]-naphthalene
4,4'-bis-[isocyanate]-3,3'-dimethyl-biphenyl

The ethylenically unsaturated compound (i), which comprises a hydroxy group, comprises at least one non-aromatic C-C double bond, which is preferably terminal. The hydroxy group is preferably not bonded to a doubly bonded carbon atom; the hydroxy group is not part of a carboxy group. In addition to the one OH group, the ethylenically unsaturated compound (i) does not comprise any further functional groups, such as e.g. NH, which can react with the isocyanate.

Examples of the ethylenically unsaturated compound (i) include

Hydroxy($C_1$-$C_{12}$)alkyl(meth)acrylates (e.g. 2-hydroxyethyl(meth)acrylate, 2- or 3-hydroxypropyl(meth)acrylate, 2-, 3- or 4-hydroxybutyl(meth)acrylate), hydroxy($C_1$-$C_{12}$)alkyl(meth)acrylamides (e.g. 2-hydroxyethyl(meth)acrylamide, 2- or 3-hydroxypropyl(meth)acrylamide, 2-, 3- or 4-hydroxybutyl(meth)acrylamide), mono(meth)acrylates of oligomeric or polymeric ethylene glycols or propylene glycols (e.g. polyethylene glycol mono(meth)acrylate, triethylene glycol mono(meth)acrylate), allyl alcohol, pentaerythritol tri(meth)acrylate, 4-hydroxy($C_1$-$C_{12}$)alkyl-styrene (e.g. 4-hydroxymethylstyrene), 4-hydroxystyrene, hydroxycyclohexyl(meth)acrylate.

The term "(meth)acrylate" etc. as used in the present invention indicates that both methacrylate and acrylate etc. are meant.

The saturated organic compound (ii) is a compound with one OH and one NH group.

The saturated organic compound (ii) can for example be represented by the following formula (III) or (IV)

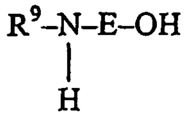

(III)

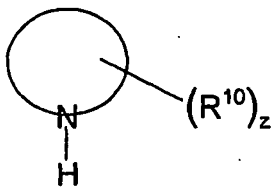

(IV)

wherein $R^9$ is a straight-chain (preferably $C_1$-$C_{12}$, especially preferred $C_1$-$C_4$), branched (preferably $C_3$-$C_{12}$, especially preferred $C_3$-$C_6$) or cyclic (preferably $C_3$-$C_8$, especially preferred $C_5$-$C_6$) alkyl group,
E is a straight-chain (preferably $C_1$-$C_6$, especially preferred $C_1$-$C_2$), branched (preferably $C_3$-$C_{12}$, especially preferred $C_3$-$C_6$) or cyclic (preferably $C_3$-$C_8$, especially preferred $C_5$-$C_6$) alkylene group,

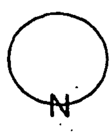

represents a saturated heterocyclic ring with 5 to 7 ring atoms, which in addition to the nitrogen atom shown above optionally comprises another heteroatom selected from S, O and $NR^{11}$, wherein $R^{11}$ is an alkyl group optionally substituted with an OH group, $R^{10}$ is OH or a straight-chain, branched or cyclic alkyl group substituted with an OH group, and z = 0 if the heterocyclic ring comprises $NR^{11}$ and $R^{11}$ is an alkyl group substituted with OH and z = 1 if the saturated heterocyclic ring does not comprise $NR^{11}$ or if the saturated heterocyclic ring comprises $NR^{11}$ and $R^{11}$ is an unsubstituted alkyl group.

Of the compounds of formula (III), those are preferred wherein E represents $-CH_2CH_2-$ and $R^9$ is a straight-chain $C_1$-$C_{12}$ (preferably $C_1$-$C_4$) alkyl group.

Of the compounds of formula (IV), those are preferred wherein either no additional heteroatom is present in the ring and $R^{10}$ is an alkyl group substituted with OH (i.e. hydroxyalkyl-substituted piperidines), or a group $NR^{11}$ is present in the ring and $R^{11}$ is an alkyl group substituted with OH (i.e. N-hydroxyalkyl-substituted piperazines).

In particular, the following compounds should be mentioned as compound (ii):

2- or 3-(2-hydroxyethyl)piperidine,
2- or 3-hydroxymethylpiperidine,
N-(2-hydroxyethyl)piperazine and
N-(2-hydroxymethyl)piperazine.

The number of moles of isocyanate groups must not exceed the number of moles of OH groups and NH groups combined since the product should not comprise any more free isocyanate groups.

The reaction of the diisocyanate and the ethylenically unsaturated compound (i) and the saturated compound (ii) usually takes place in an aprotic solvent such as a ketone (e.g. acetone, methyl ethyl ketone, diethyl ketone, cyclopentanone and cyclohexanone), an ether (e.g. diethyl ether, diisopropyl ether, tetrahydrofuran, dioxane and 1,2-dioxolane) and an ester (e.g. ethyl acetate, methyl acetate, butyl acetate, ethylene glycol diacetate, methyl lactate and ethyl lactate) or in a technical solvent such as ethylene glycol monomethyl ether acetate, propylene glycol monomethyl ether acetate etc.

It is preferred to use a catalyst for condensation reactions. All known catalysts suitable for condensation reactions can be used. Examples include tertiary amines, such as triethylamine, pyridine etc. and tin compounds, such as dibutyltin dilaurate.

The reaction preferably takes place at 10 to 120°C, especially preferred at 30 to 70°C.

Under optimized synthesis conditions a uniform product can be obtained. However, as a rule it has to be assumed that a mixed product is formed. The molecular weight of the product should be 3,000 or less. In the case of a mixed product, the molecular weight is the weight-average molecular weight. Both a uniform reaction product and a mixed product can be used as a free-radical polymerizable compound in the present invention.

Additional suitable C-C unsaturated free-radical polymerizable compounds are described e.g. in EP 1 176 007 A1.

It is of course possible to use different kinds of monomers, oligomers or polymers in the mixture; furthermore, mixtures of monomers and oligomers and/or polymers can be used in the present invention, as well as mixtures of oligomers and polymers. The free-radical polymerizable monomers/oligomers/polymers are preferably present in an amount of 5 to 95 wt.-%; if monomers/oligomers are used, especially preferred 20 to 85 wt.-%, based on the dry layer weight of a radiation-sensitive coating prepared from the radiation-sensitive composition of the present invention. As used in the present invention, the term "dry layer weight of the radiation-sensitive coating" is therefore synonymous with the term "solids of the radiation-sensitive composition".

*Sensitizer and coinitiator*

As another essential component, the radiation-sensitive coating comprises a sensitizer which upon irradiation in the presence of a coinitiator initiates the free-radical polymerization of the free-radical polymerizable monomers. It depends on the type of sensitizer whether the radiation-sensitive element according to the present invention can be imaged by means of UV radiation (300 to <480 nm) or IR radiation (>750 to 1,100 nm).

Photoinitiators which directly form free radicals upon absorption of UV radiation (300 to <480 nm) are known to the person skilled in the art and are for example described in K.K. Dietliker: "Chemistry & Technology of UV &EB formulation for coatings, inks & prints", Vol. 3 (SITA Technology, London (1991)). These photoinitiators which form free radicals directly upon irradiation with UV radiation result in a low degree of photosensitivity. Therefore, the more efficient combinations of a sensitizer and a coinitiator are used in the present invention. In order to obtain efficient combinations of sensitizers and coinitiators, the person skilled in the art, based on this technical knowledge, selects combinations wherein the excitation energy absorbed by the sensitizers is converted into free radicals with a high degree of efficiency with the help of the coinitiators, which free radicals then initiate the polymerization of the monomers, oligomers and/or

reactive binders. In the selection of sensitizers and coinitiators, parameters such as excitation wavelength, singlet and triplet energies, lifetimes of the excited states, fluorescence and phosphorescence quantum yields and absorption coefficients of the sensitizers as well as half-wave reduction and half-wave oxidation potentials of the sensitizers and coinitiators have to be taken into account. Furthermore, the sensitizer/coinitiator systems have to be adjusted to the corresponding radiation source and suitable concentrations have to be selected in the layer such that sufficient radiation, including a sufficient portion of radiation in the vicinity of the substrate surface, is absorbed.

Within the framework of the present invention, a sensitizer/coinitiator combination is efficient when the following components are combined:

(a) at least one sensitizer which absorbs UV or IR radiation (i.e. radiation from the range of 300 to <480 nm or >750 to 1,100 nm) but does not form free radicals on its own, and

(b) at least one coinitiator which does not essentially absorb UV or IR radiation (300 to <480 nm or >750 to 1,100 nm) by itself but forms free radicals together with the sensitizer.

Within the framework of the present invention, these sensitizer/coinitiator combinations are divided into two groups, namely those wherein the at least one sensitizer absorbs radiation from the range of 300 to <480 nm and preferably shows an absorption maximum in that range (also briefly referred to as "UV sensitizer" or "UV absorber"), and those wherein the at least one sensitizer absorbs radiation from the range of >750 to 1,100 nm and preferably shows an absorption maximum in that range (also briefly referred to as "IR absorber").

If a sensitizer/coinitiator combination of the former group is used, an IR-sensitive element is obtained, while the use of an initiator system of the latter group leads to a UV-sensitive element.

Whenever the terms "IR-sensitive composition or coating" are used in the following, they refer to compositions or coatings sensitive to radiation of >750 to 1,100 nm. Whenever the terms "UV-sensitive composition or coating" are used in the following, they refer to compositions or coatings sensitive to radiation of 300 to <480 nm.

The term "sensitive" in this context means that radiation of the mentioned wavelength range is absorbed to such a degree that a polymerization of the coating of the printing plate precursor can be initiated in the irradiated areas and thus a difference in the dissolution rate of irradiated and non-irradiated areas is obtained during developing which is sufficient for producing an imaged printing plate.

1,4-Dihydropyridines, oxazoles, bisoxazoles and analogues, and coumarins can for example be used as UV-absorbing sensitizers. Such sensitizers are e.g. described in DE 42 17 495 A1, DE 44 18 645 C1, DE 3 801 065 C2, EP 1 041 074 A1 and DD 287 796 A. One or more UV sensitizers can be used; when two or more sensitizers are used, combinations of UV sensitizers from different chemical classes can be used as well.

Compounds of formula (V) are preferably used as UV sensitizers of the 1,4-dihydropyridine type

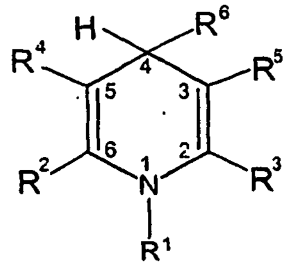

(V)

wherein

$R^1$ is selected from a hydrogen atom, -C(O)OR$^7$, an optionally substituted alkyl group, an optionally substituted aryl group and an optionally substituted aralkyl group,

$R^2$ and $R^3$ are independently selected from optionally substituted alkyl groups, optionally substituted aryl groups, CN and a hydrogen atom,

$R^4$ and $R^5$ are independently selected from -C(O)OR$^7$, -C(O)R$^7$, -C(O)NR$^8$R$^9$ and CN,

or $R^2$ and $R^4$ together form an optionally substituted phenyl ring or a 5- to 7-membered carbocyclic or heterocyclic ring, wherein the unit

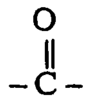

is present in the carbocyclic or heterocyclic ring adjacent to position 5 of the dihydropyridine ring and wherein the carbocyclic or heterocyclic ring optionally comprises additional substituents,
or both $R^2$ and $R^4$ as well as $R^3$ and $R^5$ form either optionally substituted phenyl rings or 5- to 7-membered carbocyclic or heterocyclic rings, wherein the unit

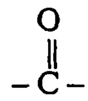

is present in the carbocyclic or heterocyclic rings adjacent to positions 3 and 5 of the dihydropyridine ring and wherein the carbocyclic or heterocyclic rings optionally comprise additional substituents,
or one of the pairs $R^2/R^4$ and $R^3/R^5$ forms a 5- to 7-membered carbocyclic or heterocyclic ring, wherein the unit

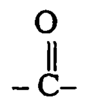

is present in the carbocyclic or heterocyclic ring adjacent to position 5 or 3 of the dihydropyridine ring and wherein the carbocyclic or heterocyclic ring optionally comprises additional substituents and the other pair forms an optionally substituted phenyl ring,
or $R^2$ and $R^1$ or $R^3$ and $R^1$ form a 5- to 7-membered heterocyclic ring which can optionally comprise one or more substituents and which, in addition to the nitrogen atom it shares with the 1,4-dihydropyridine ring, optionally comprises additional nitrogen atoms, $-NR^{13}$ groups, -S- or -O-,
$R^{13}$ is selected from a hydrogen atom, an alkyl group, aryl group and aralkyl group,
$R^6$ is selected from an alkyl group optionally substituted with a halogen atom or a- C(O) group, an optionally substituted aryl group, an optionally substituted aralkyl group, an optionally substituted heterocyclic group and the group

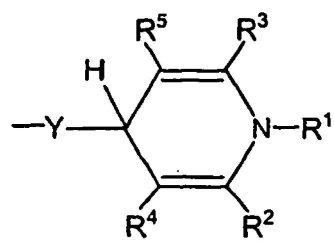

wherein
Y is an alkylene or arylene group,
$R^7$ is a hydrogen atom, aryl group, aralkyl group or alkyl group, wherein the alkyl group and the alkyl unit of the aralkyl group optionally comprise one or more C-C double and/or C-C triple bonds,
and $R^8$ and $R^9$ are independently selected from a hydrogen atom, an optionally substituted alkyl group, an optionally substituted aryl group and an optionally substituted aralkyl group.

According to a preferred embodiment, $R^1$ is a hydrogen atom.

If $R^2$ and $R^3$ do not form rings with adjacent substituents, they are preferably independently selected from $C_1$-$C_5$ alkyl groups or aryl groups.

If $R^4$ and $R^5$ do not form rings with adjacent substituents, they are preferably independently selected from -C(O)O$R^7$.

$R^6$ is preferably selected from $C_1$-$C_5$ alkyl groups or aryl groups.

$R^7$ is preferably selected from $C_1$-$C_5$ alkyl groups and it is especially preferred that it represent a methyl group.

According to one embodiment, the substitution of the 1,4-dihydropyridine ring with $R^2/R^4$ and $R^3/R^5$ is symmetrical, i.e. $R^2 = R^3$ and $R^4 = R^5$.

According to a preferred embodiment, $R^2$ and $R^3$ are independently selected from optionally substituted alkyl groups, optionally substituted aryl groups, CN and a hydrogen atom, and $R^4$ and $R^5$ are independently selected from $-C(O)OR^7$, $-C(O)R^7$, $-C(O)NR^8R^9$ and CN.

Specific 1,4-dihydropyridine derivatives suitable as UV sensitizers are those of formula (Va)

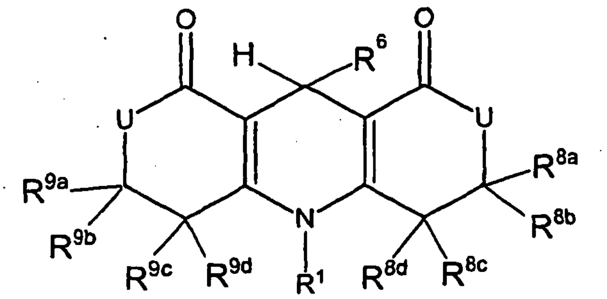

(Va)

wherein $R^1$ and $R^6$ are as defined above,
the groups $R^{8a}$ to $R^{8d}$ and $R^{9a}$ to $R^{9d}$ are independently selected from a hydrogen atom, alkyl groups and aryl groups, wherein two groups $R^9$ or $R^8$ of adjacent ring carbon atoms can also form a saturated or unsaturated carbocyclic or heterocyclic ring or fused aromatic ring together,
each U is independently selected from $CR^{13}_2$, O, S and $NR^{13}$ and
each $R^{13}$ independently represents a hydrogen atom, alkyl, aralkyl or aryl group, of formula (Vb)

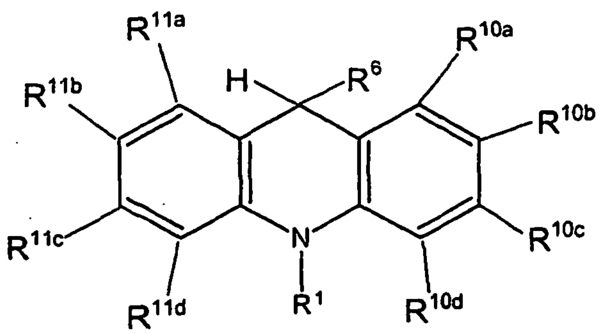

(Vb)

wherein $R^1$ and $R^6$ are as defined above, and
$R^{10a}$ to $R^{10d}$ and $R^{11a}$ to $R^{11d}$ are independently selected from a hydrogen atom, alkyl groups, aryl groups, aralkyl groups, halogen atoms (fluorine, chlorine, bromine, iodine), CN, $NR^{13}_2$, $C(O)OR^{13}$ and $OR^{13}$ (each $R^{13}$ independently represents a hydrogen atom, an alkyl group, aryl group or aralkyl group), wherein two groups $R^{11}$ or $R^{10}$ of adjacent ring carbon atoms can also form an unsaturated carbocyclic or heterocyclic ring or fused aromatic ring together,
of formula (Vc)

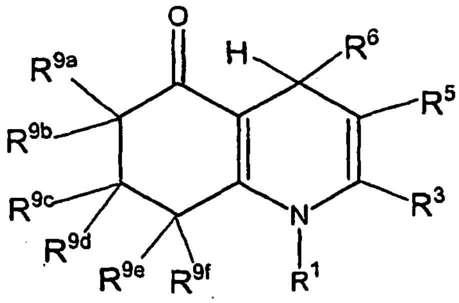

(Vc)

wherein $R^1$, $R^3$, $R^5$ and $R^6$ are as defined above and the groups $R^{9a}$ to $R^{9f}$ are independently selected from a hydrogen atom, alkyl groups, aryl groups, aralkyl groups, halogen atoms (fluorine, chlorine, bromine, iodine), CN, $NR^{13}_2$, C(O) $OR^{13}$ and $OR^{13}$ ($R^{13}$ independently represents a hydrogen atom, an alkyl group, aryl group or aralkyl group), wherein two groups $R^9$ of adjacent ring carbon atoms can also form a saturated or unsaturated carbocyclic or heterocyclic ring or fused aromatic ring together,
of formula (Vd)

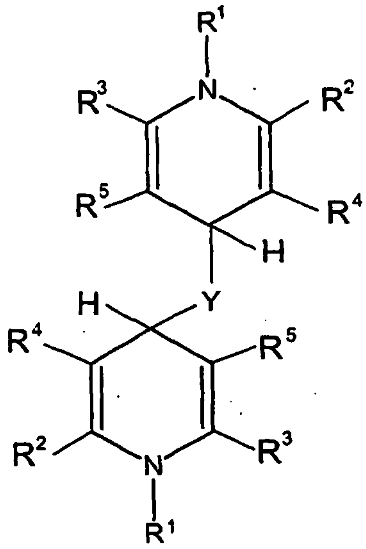

(Vd)

wherein each $R^1$, $R^2$, $R^3$, $R^4$ and $R^5$ independently is as defined above and Y is selected from alkylene and arylene,
of formula (Ve)

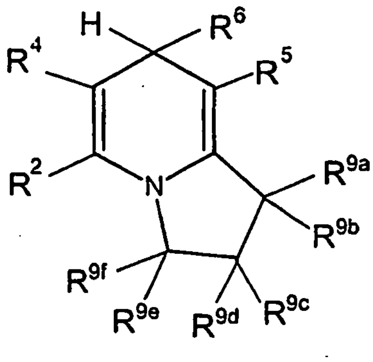

(Ve)

wherein $R^2$, $R^4$, $R^5$ and $R^6$ are as defined above and groups $R^{9a}$ to $R^{9f}$ are defined as are groups $R^{9a}$ to $R^{9d}$ of formula (Va) above,
of formula (Vf)

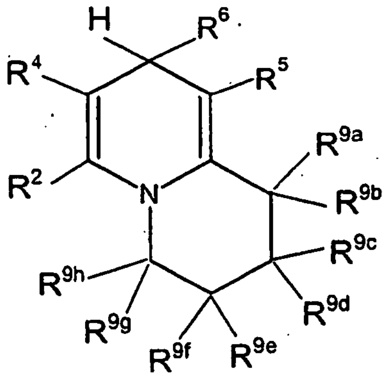

(Vf)

wherein $R^2$, $R^4$, $R^5$ and $R^6$ are as defined above and groups $R^{9a}$ to $R^{9h}$ are defined as are groups $R^{9a}$ to $R^{9d}$ of formula (Va) above
and of formula (Vg)

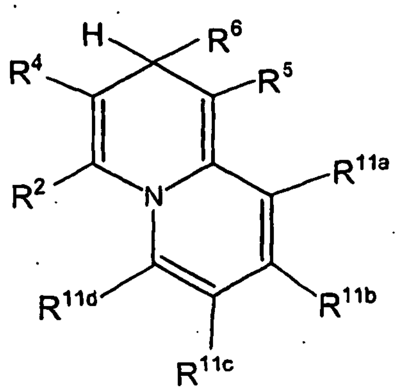

(Vg)

wherein $R^2$, $R^4$, $R^5$ and $R^6$ are as defined above and the groups $R^{11a}$ to $R^{11d}$ are independently selected from hydrogen, alkyl groups, aryl groups, aralkyl groups, halogen atoms (fluorine, chlorine, bromine, iodine), CN, $NR^{13}_2$, $C(O)OR^{13}$ and $OR^{13}$ ($R^{13}$ independently represents a hydrogen atom, an alkyl group, aryl group or aralkyl group), wherein two groups $R^{11}$ of adjacent ring carbon atoms can also form an unsaturated carbocyclic or heterocyclic ring or fused aromatic ring together.

It goes without saying that the number of groups $R^8$ or $R^9$ in formulas (Va), (Vc), (Ve) and (Vf) is reduced if two groups $R^8$ or $R^9$ of adjacent ring carbon atoms together form a fused aromatic ring.

In the 1,4-dihydropyridine derivatives of formula (Va), $R^1$ is preferably a hydrogen atom, $R^6$ is a methyl or phenyl group and U is preferably O or $CH_2$; the substituents $R^{8a}$ to $R^{8d}$ and $R^{9a}$ to $R^{9d}$ are independently preferably selected from hydrogen atoms and methyl groups. Of the derivatives of formula (Va) those with symmetrical substitution at the dihydropyridine ring are especially preferred.

In the derivatives of formula (Vb), $R^1$ is preferably a hydrogen atom and $R^6$ is preferably a methyl or phenyl group. The substituents $R^{10a}$ to $R^{10d}$ and $R^{11a}$ to $R^{11d}$ are independently preferably selected from $C_1$-$C_5$ alkyl groups, $OR^{13}$ and halogen atoms; a symmetrical substitution of the two aromatic rings is especially preferred.

In the 1,4-dihydropyridine derivatives of formula (Vc), $R^1$ is preferably a hydrogen atom, $R^6$ is preferably a methyl or phenyl group, $R^3$ is preferably a methyl group and $R^5$ is preferably $C(O)OR^7$ (wherein $R^7$ is as defined above). The substituents $R^{9a}$ to $R^{9f}$ are independently preferably selected from $C_1$-$C_5$ alkyl groups. A methyl group is especially preferred.

In the derivatives of formula (Vd), Y is preferably a 1,4-phenylene or 1,2-ethylene group. Furthermore, it is preferred that both groups $R^1$ be the same, both groups $R^2$ be the same, both groups $R^3$ be the same, both groups $R^4$ be the same and both groups $R^5$ be the same; the preferred definitions given with respect to formula (V) apply to all groups $R^1$ to $R^5$.

In the derivatives of formula (Ve), $R^2$ is preferably $C_1$-$C_5$ alkyl; $R^4$ is preferably -C(O)OR$^7$, $R^5$ is preferably C(O)OR$^7$ and $R^6$ is preferably $C_1$-$C_5$ alkyl or phenyl ($R^7$ is as defined above). The substituents $R^{9a}$ to $R^{9f}$ are preferably independently selected from $C_1$-$C_5$ alkyl groups.

In the derivatives of formula (Vf), $R^2$ is preferably $C_1$-$C_5$ alkyl, $R^4$ is preferably C(O)OR$^7$, $R^5$ is preferably C(O)OR$^7$ and $R^6$ is preferably a $C_1$-$C_5$ alkyl or a phenyl group (wherein $R^7$ is as defined above). The substituents $R^{9a}$ to $R^{9b}$ are preferably independently selected from $C_1$-$C_5$ alkyl groups.

In the derivatives of formula (Vg), $R^2$ is preferably $C_1$-$C_5$ alkyl, $R^4$ is preferably C(O)OR$^7$, $R^5$ is preferably C(O)OR$^7$ and $R^6$ is preferably a $C_1$-$C_5$ alkyl or a phenyl group. The substituents $R^{11}$ are preferably independently selected from $C_1$-$C_5$ alkyl groups.

Of the 1,4-dihydropyridine derivatives of formulas (Va) to (Vg) those of formulas (Va) and (Vd) are especially preferred.

The 1,4-dihydropyridine derivatives that can be used as UV sensitizers in the present invention can be prepared according to processes well known to the person skilled in the art, such as the Hantzsch synthesis. As an example, reference is made to J. Org. Chem. 30 (1965), p. 1914 et seqq., and Angew. Chem. [Applied Chemistry] (Intern.) 20 (1981), p. 762 et seqq.; the processes described therein can also be used for the synthesis of 1,4-dihydropyridines not explicitly disclosed therein by varying the starting compounds accordingly.

Compounds of formula (VI) are preferably used as UV sensitizers of the oxazole type

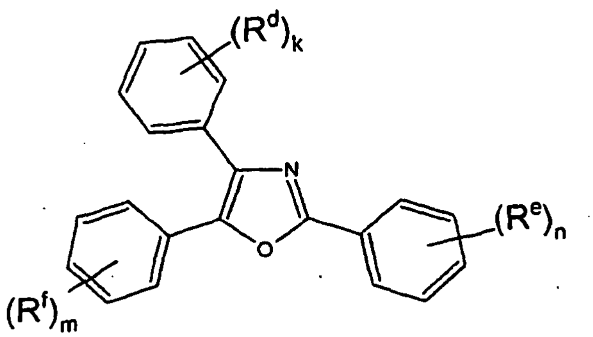

(VI)

wherein each $R^d$, $R^e$ and $R^f$ is independently selected from a halogen atom, an optionally substituted alkyl group, an optionally substituted aryl group, which may also be fused, an optionally substituted aralkyl group, a group -NR'R" and a group -OR"',

wherein R' and R" are independently selected from a hydrogen atom, an alkyl, aryl or aralkyl group,

R"' is an optionally substituted alkyl, aryl or aralkyl group or a hydrogen atom, and k, m and n are independently 0 or an integer from 1 to 5.

Preferably, $R^d$, $R^e$ and $R^f$ are independently selected from a halogen atom, a $C_1$-$C_8$ alkyl and a group NR'R", wherein R' and R" are preferably independently selected from hydrogen atoms and $C_1$-$C_6$ alkyl.

k, m and n are preferably independently 0 or 1, preferably, $k + m + n \geq 1$.

Oxazole derivatives of formula (VI), wherein at least one of $R^d$, $R^e$ and $R^f$ represents a group NR'R" wherein R' and R" are preferably independently selected from hydrogen atoms and $C_1$-$C_6$ alkyl, and especially preferred R' = R"= $C_1$-$C_6$ alkyl, are especially preferred.

The oxazole derivatives used in the present invention as UV absorbers can be prepared according to processes well known to the person skilled in the art. In this connection, reference is made to DE 120 875 A1 and EP 129 059 A1; the processes described in these documents can also be used for the synthesis of oxazoles not explicitly described therein by varying the starting compounds accordingly.

According to the present invention, a compound of formula (VII), i.e. bisoxazoles and analogues thereof, can also be used as a UV sensitizer

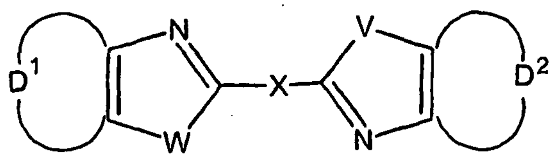

(VII)

wherein X is a spacer group comprising at least one C-C double bond conjugated to the heterocycles, $D^1$ and $D^2$ independently represent an optionally substituted fused aromatic ring and V and W are independently selected from O, S and NR, wherein R is selected from an alkyl, aryl and aralkyl group which can optionally be mono- or polysubstituted.

Preferably, V = W and represents O or NR.

R is preferably $C_1$-$C_{12}$ alkyl.

The spacer group X can be a chain-like or cyclic unit or a combination thereof. It is preferably selected from:

Phenylene, optionally comprising one or more benzofused aromatic rings (e.g. naphthylene),

wherein the binding sites to the two heterocycles can be located at the same ring or at different rings,

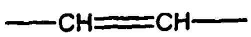

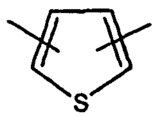

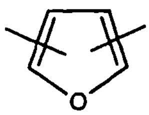

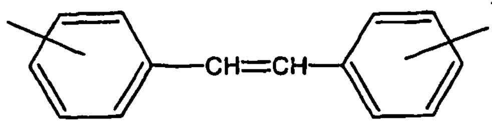

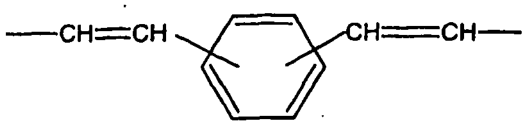

and

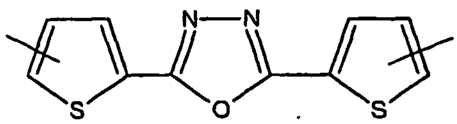

In the six-membered rings shown above, it is preferred that the binding sites be in the 1,4-position, in the five-membered rings, the 2,5-position is preferred. The five- and six-membered rings shown above can optionally comprise one or more substituents such as e.g. $C_1$-$C_{10}$ alkyl and halogen atoms, even if they are not shown in the above formulas.

$D^1$ and $D^2$ preferably represent fused aromatic rings which can optionally be substituted.

Preferred UV sensitizers of formula (VII) are represented by formulas (VIIa), (VIIb) and (VTIc):

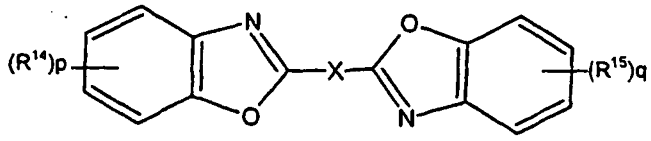

(VIIa)

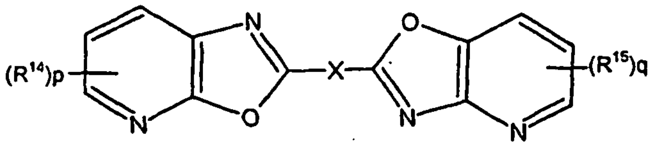

(VIIb)

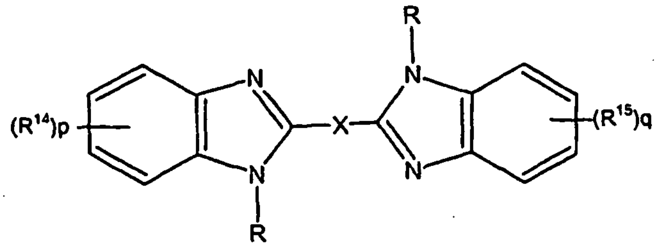

(VIIc)

wherein p and q are independently an integer from 1 to 4, each group $R^{14}$ und $R^{15}$ is independently selected from a halogen atom, an alkyl, aryl, aralkyl, alkoxy, aryloxy, aralkyloxy group, a saturated or non-aromatic unsaturated carbocyclic ring, a fused aryl group, $-SO_3H$, $-NR^{16}_2$, $-COOR^{17}$ and $-COR^{17}$;
each group $R^{16}$ is independently a hydrogen atom or an alkyl group and each group $R^{17}$ is independently selected from a hydrogen atom, an alkyl and an aryl group, and
X and R are as defined above.

$R^{14}$ and $R^{15}$ are preferably independently selected from $-NR^3_2$, an alkoxy group and an aryl group.

$R^{16}$ is preferably a $C_1$-$C_{10}$ alkyl group.

$R^{17}$ is preferably a $C_1$-$C_{10}$ alkyl group.

The compounds of formula (VII) that can be used in the present invention as UV sensitizers can be prepared according to processes well known to the person skilled in the art. In this connection, reference is made to A. Dorlars et al., Angew. Chemie [Applied Chemistry], Vol. 87 (1975), 693-707; the processes described therein can also be used for the synthesis of compounds not explicitly disclosed therein by varying the starting compounds accordingly.

Furthermore, a coumarin compound of formula (VIII) can be used as a UV sensitizer in the radiation-sensitive coating

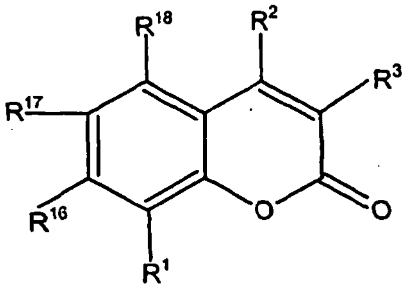

(VIII)

wherein
$R^1$, $R^{16}$, $R^{17}$ and $R^{18}$ are independently selected from -H, a halogen atom, $C_1$-$C_{20}$ alkyl, -OH, $-O-R^4$ and $-NR^5R^6$, wherein $R^4$ is $C_1$-$C_{20}$ alkyl, $C_5$-$C_{10}$ aryl or $C_6$-$C_{30}$ aralkyl (preferably $C_1$-$C_6$ alkyl) and $R^5$ and $R^6$ are independently selected from a hydrogen atom and $C_1$-$C_{20}$ alkyl,

or $R^1$ and $R^{16}$, $R^{16}$ and $R^{17}$ or $R^{17}$ and $R^{18}$ together form a 5- or 6-membered heterocyclic ring with a heteroatom, selected from N and O, in one or both positions adjacent to the phenyl ring shown in formula (VIII),

or $R^{16}$ or $R^{17}$ forms, together with each of its two adjacent substituents, a 5- or 6-membered heterocyclic ring with a heteroatom, selected from N and O, in one or both positions adjacent to the phenyl ring shown in formula (VIII), wherein each formed 5- or 6-membered heterocyclic ring can independently be substituted with one or more $C_1$-$C_6$ alkyl groups,

with the proviso that at least one of $R^1$, $R^{16}$, $R^{17}$ and $R^{18}$ is not hydrogen or $C_1$-$C_{20}$ alkyl,

$R^2$ is a hydrogen atom, $C_1$-$C_{20}$ alkyl, $C_5$-$C_{10}$ aryl or $C_6$-$C_{30}$ aralkyl and

$R^3$ is a hydrogen atom or a substituent selected from -COOH, -COOR$^7$, -COR$^8$, -CONR$^9$R$^{10}$, -CN, $C_5$-$C_{10}$ aryl, $C_6$-$C_{30}$ aralkyl, a 5- or 6-membered heterocyclic optionally benzofused group, a group -CH=CH-R$^{12}$ and

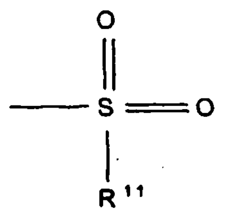

wherein $R^7$ is $C_1$-$C_{20}$ alkyl, $R^8$ is $C_1$-$C_{20}$ alkyl or a 5- or 6-membered heterocyclic group, $R^9$ and $R^{10}$ are independently selected from a hydrogen atom and $C_1$-$C_{20}$ alkyl, $R^{11}$ is $C_1$-$C_{12}$ alkyl or alkenyl, a heterocyclic non-aromatic ring or $C_5$-$C_{20}$ aryl optionally with a heteroatom, selected from O, S and N, and $R^{12}$ is $C_5$-$C_{10}$ aryl or a 5- or 6-membered heterocyclic, optionally aromatic, ring;

or $R^2$ and $R^3$, together with the carbon atoms to which they are bonded, form a 5- or 6-membered, optionally aromatic, ring.

In one embodiment, one of $R^1$, $R^{16}$, $R^{17}$ and $R^{18}$ is a group -NR$^5$R$^6$, and especially preferred a dimethylamino group or a diethylamino group. Preferably, the other groups are then all hydrogen atoms.

In another embodiment, $R^1$ and $R^6$, $R^{16}$ and $R^{17}$ or $R^{17}$ and $R^{18}$ together form a 5- or 6-membered, preferably 6-membered, heterocyclic ring with a heteroatom selected from N and O (preferably N) in one or both positions (preferably one) adjacent to the phenyl ring; preferably, the formed heterocyclic ring is a saturated 6-membered ring with a nitrogen atom. In this embodiment, the remaining groups ($R^{17}$ and $R^{18}$, $R^1$ and $R^{18}$ or $R^1$ and $R^{16}$) preferably represent hydrogen atoms. The formed heterocyclic ring can comprise one or more substituents, independently selected from $C_1$-$C_6$ alkyl groups (preferably $CH_3$), which are preferably not bonded at the heteroatom.

According to another embodiment, $R^{16}$ or $R^{17}$ forms, together with each of its two adjacent substituents, a 5- or 6-membered (preferably 6-membered) heterocyclic ring with a heteroatom selected from N and O (preferably N), in one or both positions (preferably one) adjacent to the phenyl ring; preferably, the two formed heterocyclic rings are two saturated 6-membered rings with a common nitrogen atom, i.e. the two formed heterocyclic rings, together with the phenyl ring shown in formula (VIII), form a julolidine unit. In this embodiment, the remaining group ($R^{18}$ or $R^1$) preferably represents a hydrogen atom. The two formed heterocyclic rings, which preferably represent a julolidine unit together with the phenyl ring, can be substituted with one or more substituents, whereby the substituents are independently selected from $C_1$-$C_6$ alkyl groups (preferably -$CH_3$).

The substituent $R^2$ is preferably a hydrogen atom or an optionally substituted $C_1$-$C_6$ alkyl, especially preferred H, -$CH_3$ or -$CF_3$.

$R^3$ is preferably an acceptor substituent selected from -COOH, -$COOCH_2CH_3$, -$COOCH_3$, -CN and -CO-$CH_3$.

Examples of the most preferred UV sensitizers of formula (VIII) include the following:

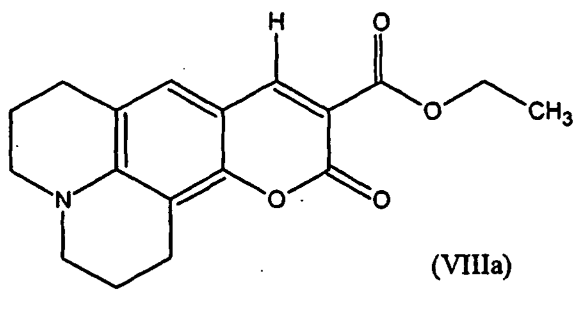

(VIIIa)

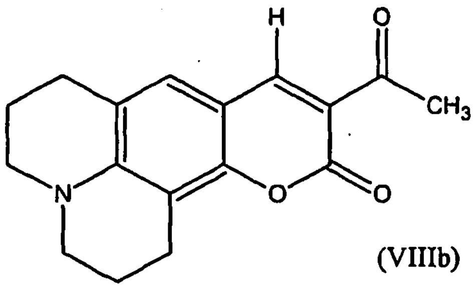

(VIIIb)

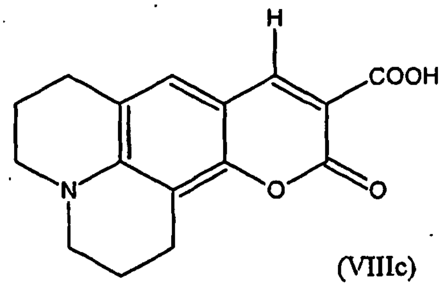

(VIIIc)

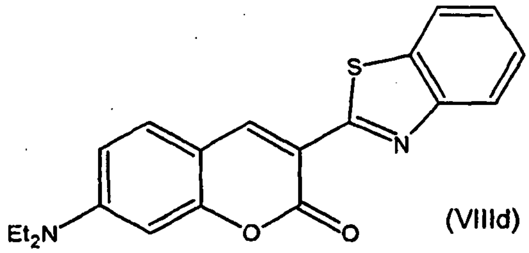

(VIIId)

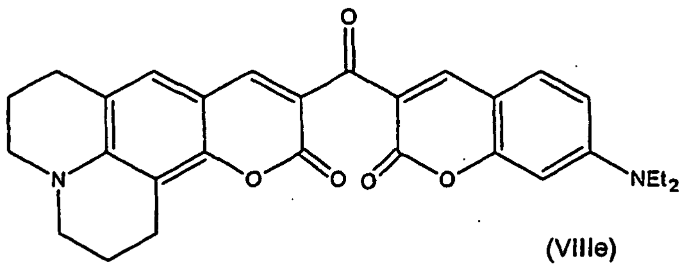

(VIIIe)

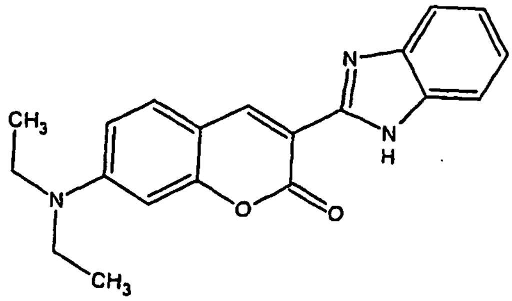

(VIIIf)

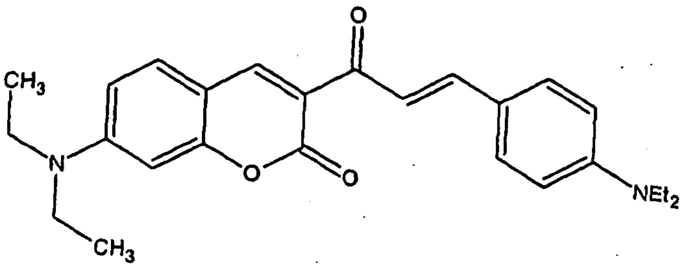

(VIIIg)

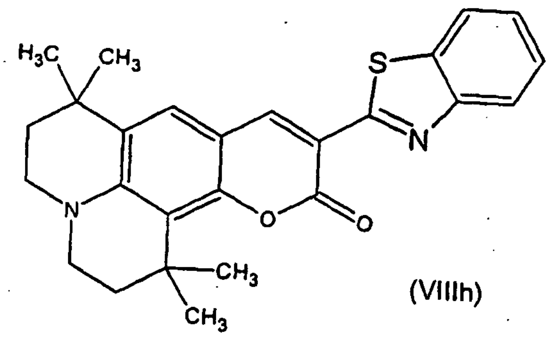

(VIIIh)

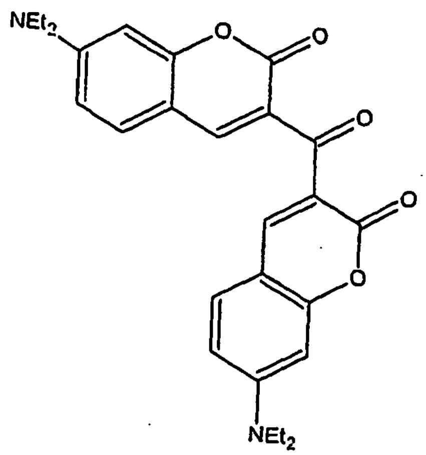

(VIIIj)

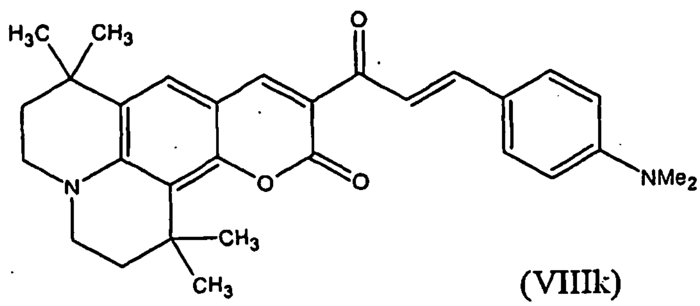

(VIIIk)

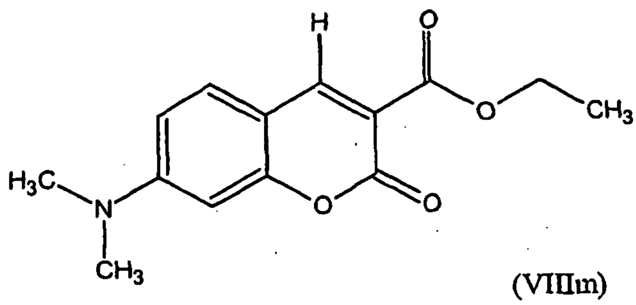

(VIIIm)

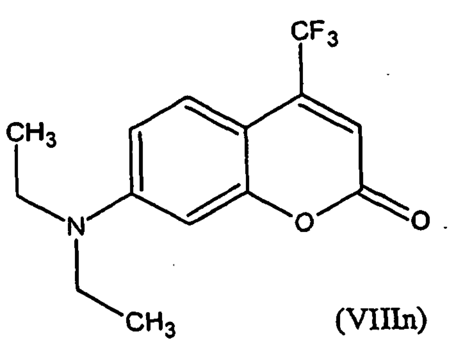

(VIIIn)

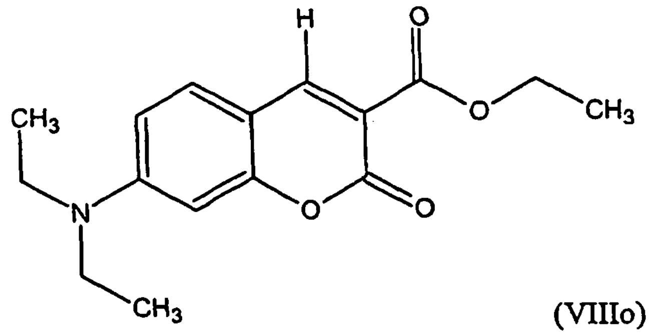

(VIIIo)

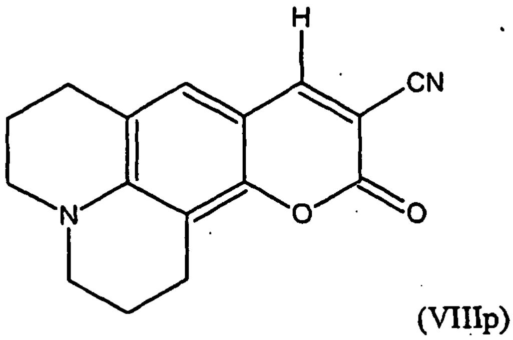

(VIIIp)

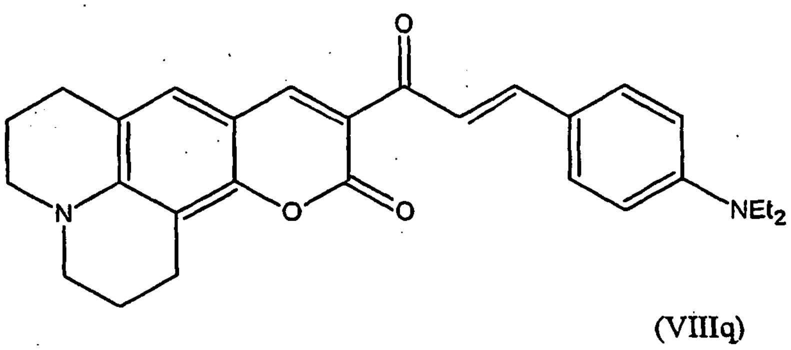

(VIIIq)

Furthermore, a compound of formula (IX) can be used as a UV sensitizer, i.e. for the range of 300 to <480 nm, in the present invention:

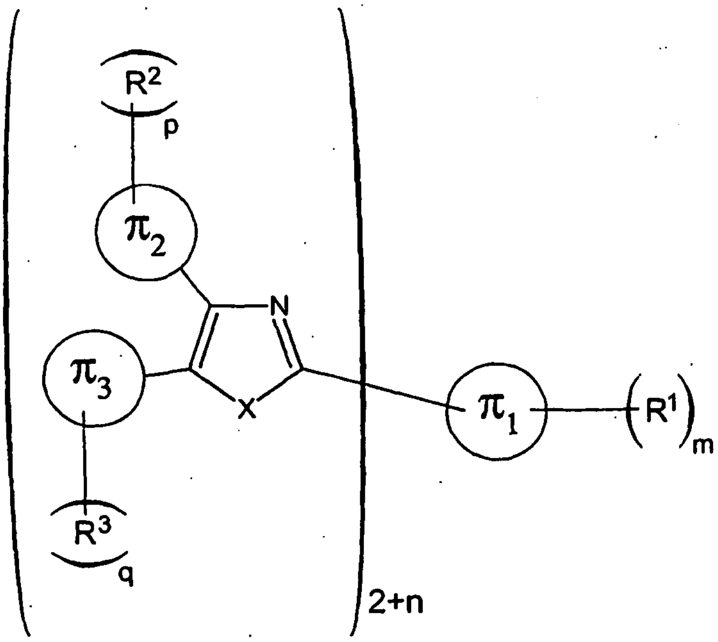

(IX)

wherein
X is selected from O, S and Se;
n represents 0 or a positive integer;
m, p and q are independently 0 or a positive integer;

the $\pi$-units 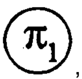, 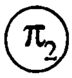 and 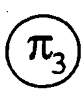
are independently unsaturated units, each with a conjugated $\pi$-electron system, which are covalently bonded to the heterocyclic unit

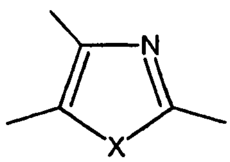

and together with this unit again form a conjugated $\pi$-electron system and
each group $R^1$, $R^2$ and $R^3$ is independently selected from a hydrogen atom, a halogen atom, an alkyl group, an aralkyl group, a group $-NR^4R^5$ and a group $-OR^6$,
wherein $R^4$, $R^5$ and $R^6$ are independently selected from an alkyl group, aryl group and aralkyl group.

For the person skilled in the art, it goes without saying that due to the number of binding sites available at the $\pi$-units 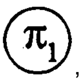, 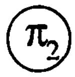 and 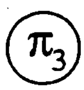 the maximum number of substituents $R^1$, $R^2$ und $R^3$ (i.e. m, p and q) is limited; the same of course applies to the maximum number (2+n) of the heterocyclic units bonded to 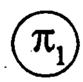
If X = O, 2,4,5-substituted oxazoles are obtained,
accordingly, if X = S, 2,4,5-substituted thiazoles are obtained and
accordingly, if X = Se, 2,4,5-substituted selenazoles are obtained; of those compounds, oxazoles and thiazoles are preferred, and oxazoles are especially preferred.
n is preferably 0, 1 or 2, especially preferred 0 or 1.

The substituted heterocyclic unit

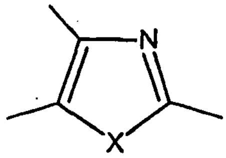

is bonded at least twice (n=0) to 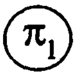 ; it is not necessary that these substituents of 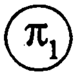 all be the same, i.e. for every substituent of 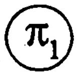 each X, 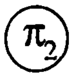 , 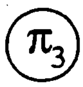 $R^2$, $R^3$, p and q is selected independently.

The unsaturated unit 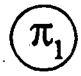 is preferably selected from:
a polyene group SUS-1 with alternating double bonds:

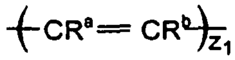

SUS-1

wherein $z_1$ is a positive integer (preferably 1 to 3, especially preferred 1 or 2), and
$R^a$ and $R^b$ are independently selected from H, alkyl, aryl, halogen, -CN, -COOH and -COO-alkyl (preferably H, -CN and $CH_3$),
a polyyne group SUS-2 with alternating triple bonds:

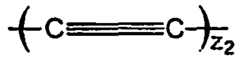

SUS-2

wherein $z_2$ is a positive integer (preferably 1 or 2, especially preferred 1),
a group SUS-3, which is a π-branched aromatic unit with (4n+2) π-electrons, preferably one of the structures SUS-3-a, SUS-3-b and SUS-3-c:

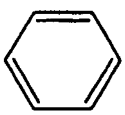

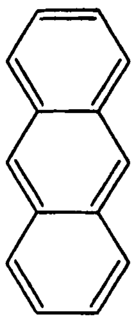

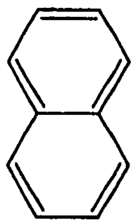

SUS-3-a SUS-3-b SUS-3-c

a group SUS-4, which is a π-branched electron-deficient heteroaromatic unit, preferably a group SUS-4-a, SUS-4-b,

SUS-4-c, SUS-4-d and SUS-4-e

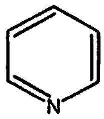
SUS-4-a
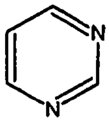
SUS-4-b
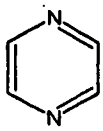
SUS-4-c
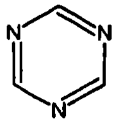
SUS-4-d
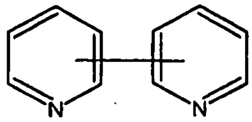
SUS-4-e

a group SUS-5, which is a π-branched electron-rich heteroaromatic unit, preferably a group SUS-5-a, SUS-5-b or SUS-5-c

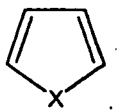
SUS-5-a
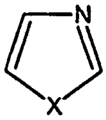
SUS-5-b
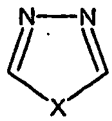
SUS-5-c

wherein X is selected from O, S and Se and
a group SUS-6, which is a π-branched electron-rich heteroaromatic unit with two fused aromatic rings,

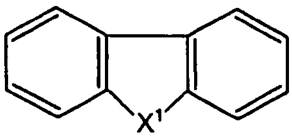

SUS-6

wherein $X^1$ represents a heteroatom, preferably O, S, Se, NH or N-alkyl (wherein the alkyl group preferably comprises 1 to 5 carbon atoms), especially preferred O or S;

combinations of the above-mentioned groups SUS-1 to SUS-6 can also be used as unit 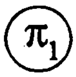 as long as the π-conjugation in the unit 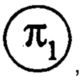, and the entire system (IX) is not lost due to the combination.

The optional substituents $R^1$ are not shown in the groups SUS-1 to SUS-6.

It is especially preferred that 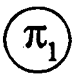 represent:

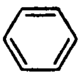
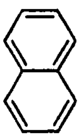
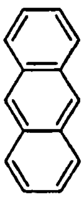
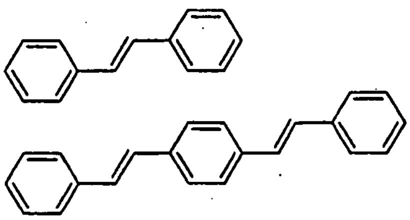
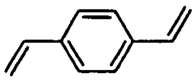
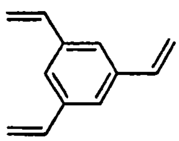
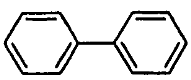

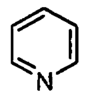 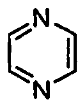 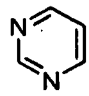 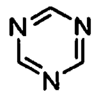

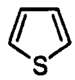 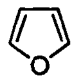 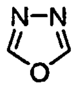 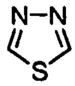

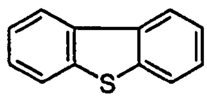 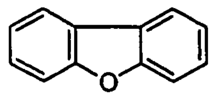 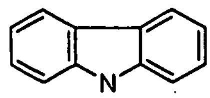

 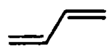 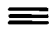

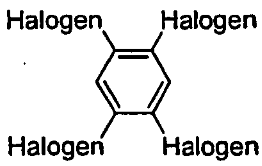 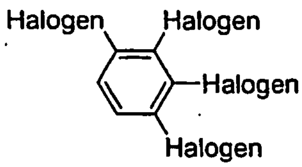 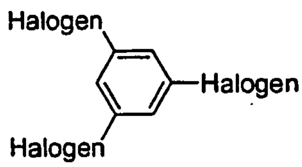 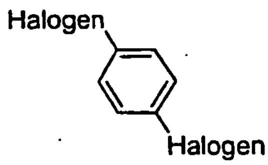

It is particularly preferred that 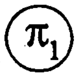 represent:

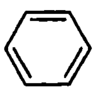 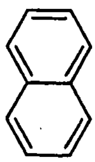 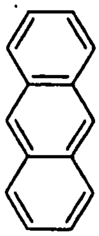 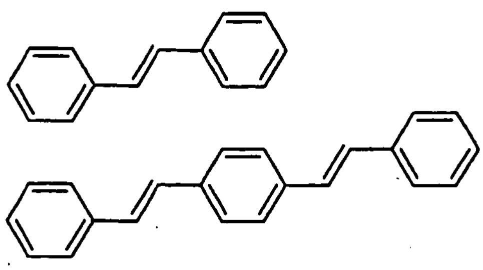

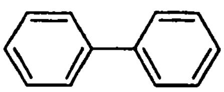 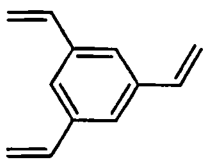

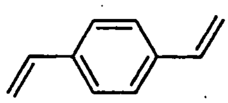 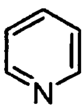

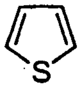 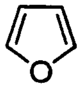 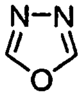

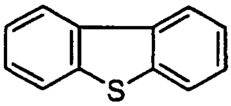 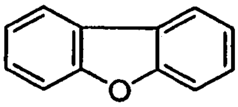

 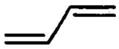

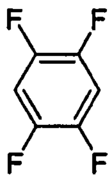 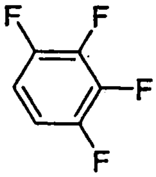 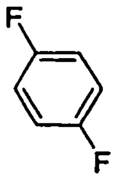 ,

The units 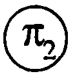 and 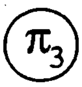 preferably also represent structures SUS-1 to SUS-6; the optional substituents $R^2$ and $R^3$ are not shown. It is especially preferred that 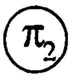 and 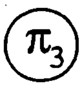 each represent optionally substituted aryl groups, in particular phenyl groups, which are optionally mono- or polysubstituted with a halogen atom or a group $NR^7_2$ (each $R^7$ is preferably independently selected from alkyl and aryl). Compounds with a covalent bond between 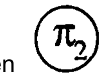 and 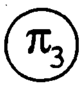 as depicted below

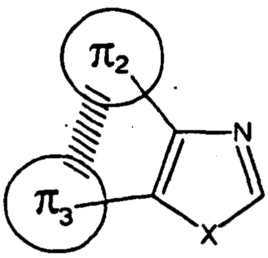

are not UV sensitizers according to the present invention; the interaction between $\pi_2$ and $\pi_3$ results in chromophores which do not lead to a highly sensitive photosystem. The optional substituents $R^1$, $R^2$ and $R^3$ are independently selected from a hydrogen atom, a halogen atom, an alkyl group (preferably $C_1$-$C_8$), an aralkyl group, a group $-NR^4R^5$ (wherein $R^4$ and $R^5$ are independently selected from alkyl (preferably $C_1$-$C_8$), aryl and aralkyl) and a group $-OR^6$ (wherein $R^6$ is selected from alkyl (preferably $C_1$-$C_8$), aryl and aralkyl).

The following compounds of formula (IX) are especially preferred:

4-(5-(2-Chlorophenyl)-2-(4-(5-(2-chlorophenyl)-4-(4-(diethylamino)phenyl)oxazole-2-yl)phenyl)oxazole-4-yl)-*N,N*-diethylbenzeneamine

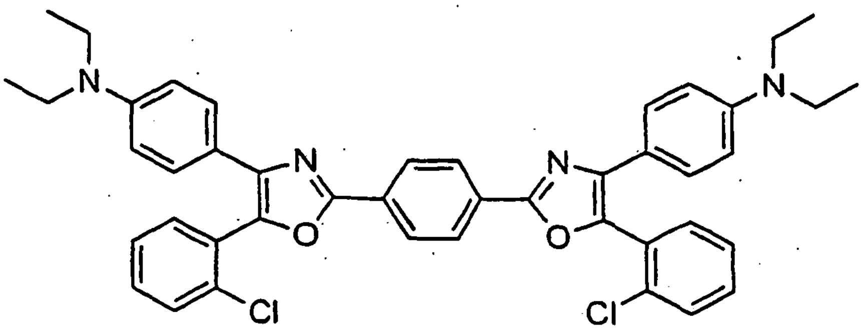

(IXa)

4-(2-(4-(4-(4-(dimethylamino)phenyl)-5-phenyloxazole-2-yl)phenyl)-5-phenyloxazole-4-yl)-N,N-dimethylbenzeneamine

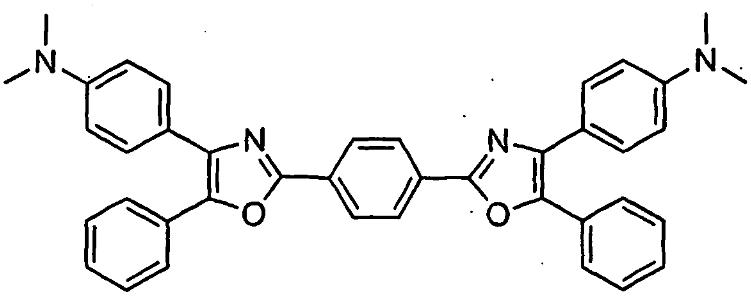

(IXb)

4-(5-(2-chlorophenyl)-2-(4-(5-(2-chlorophenyl)-4-(4-(diethylamino)phenyl)oxazole-2-yl)-2,3,5,6-tetrafluorophenyl) oxazole-4-yl)-*N,N*-diethylbenzeneamine

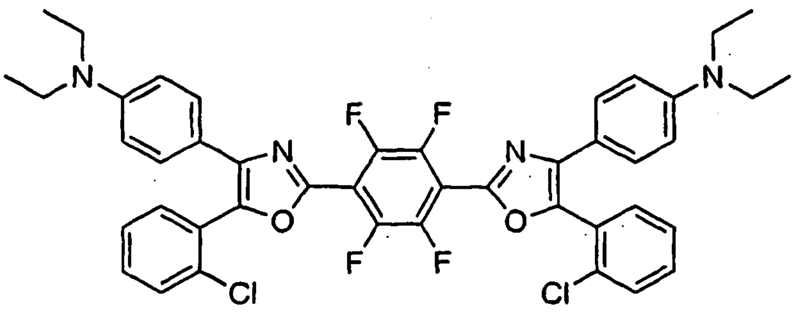

(IXc)

4-(5-(2-chlorophenyl)-2-(9-(5-(2-chlorophenyl)-4-(4-(diethylamino)phenyl)oxazole-2-yl)anthracene-10-yl)oxazole-4-yl)-*N,N*-diethylbenzeneamine

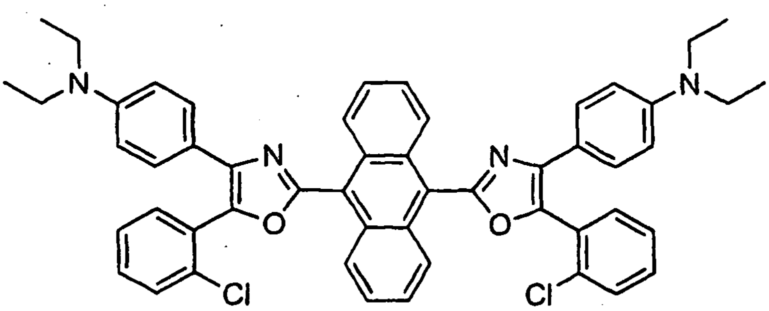

(IXd)

4-(2-(2-((1*E*,13*E*)-4-((*E*)-2-(4-(4-(dimethylamino)phenyl)-5-phenyloxazole-2-yl)styryl)styryl)phenyl)-5-phenyloxazole-4-yl)-*N,N*-dimethylbenzeneamine

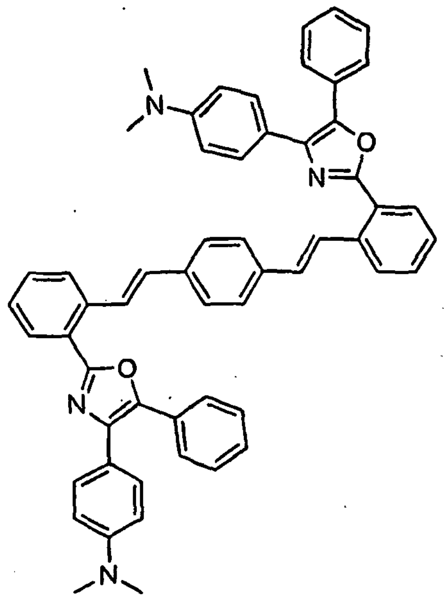

(IXe)

4-(2-(4-((1*E*,13*E*)-4-((*E*)-2-(4-(4-(dimethylamino)phenyl)-5-phenyloxazole-2-yl)styryl)styryl)phenyl)-5-phenyloxazole-4-yl)-*N,N*-dimethylbenzeneamine

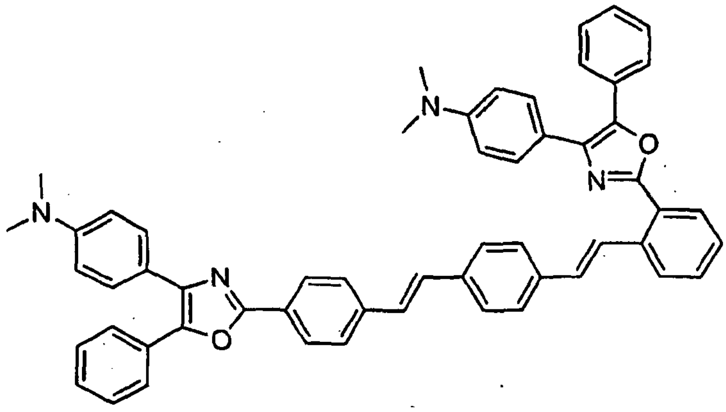

(IXf)

4-(5-(2-chlorophenyl)-2-(2-(5-(2-chlorophenyl)-4-(4-(diethylamino)phenyl)oxazole-2-yl)-3,4,5,6-tetrafluorophenyl) oxazole-4-yl)-*N,N*-diethylbenzeneamine

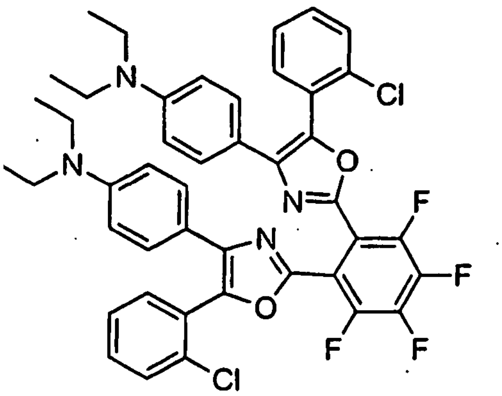

(IXg)

4-(2-((1*E*,28*E*)-4-((*E*)-2-(4-(4-(dimethylamino)phenyl)-5-phenyloxazole-2-yl)vinyl)styryl)-5-phenyloxazole-4-yl)-*N,N*-dimethylbenzeneamine

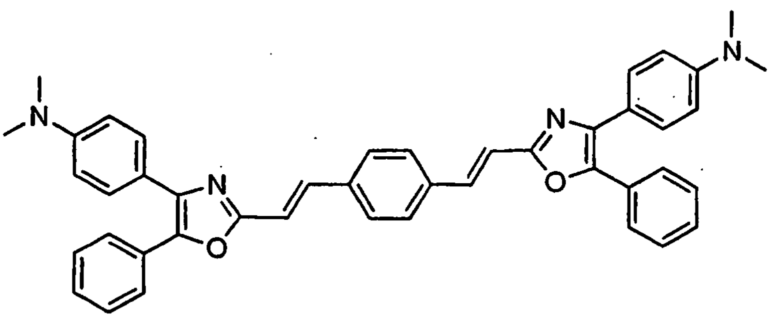

(IXh)

(*E*)-4-(2-(4-(4-(4-(4-(dimethylamino)phenyl)-5-phenyloxazole-2-yl)styryl)phenyl)-5-phenyloxazole-4-yl)-*N,N*-dimethylbenzeneamine

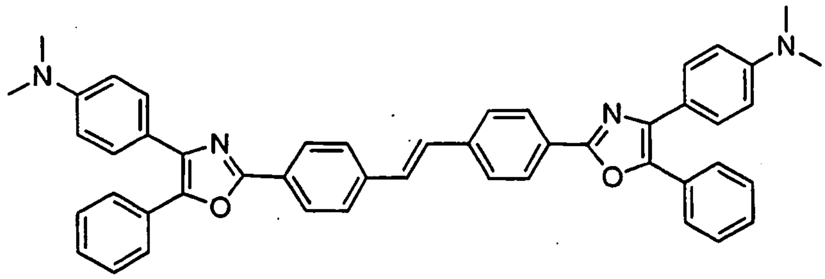

(IXj)

4-(2-(4-((1*E*,26*E*)-4-((*E*)-4-(4-(4-(dimethylamino)phenyl)-5-phenyloxazole-2-yl)styryl)styryl)phenyl)-5-phenyloxazole-4-yl)-*N,N*-dimethylbenzeneamine

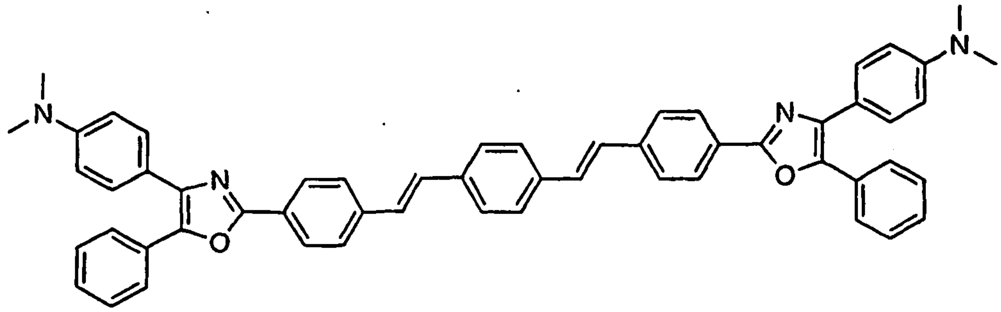

(IXk)

4-(2-((*E*)-2-(5-((*E*)-2-(4-(4-(dimethylamino)phenyl)-5-phenyloxazole-2-yl)vinyl)thiophene-2-yl)vinyl)-5-phenyloxazole-4-yl)-*N,N*-dimethylbenzeneamine

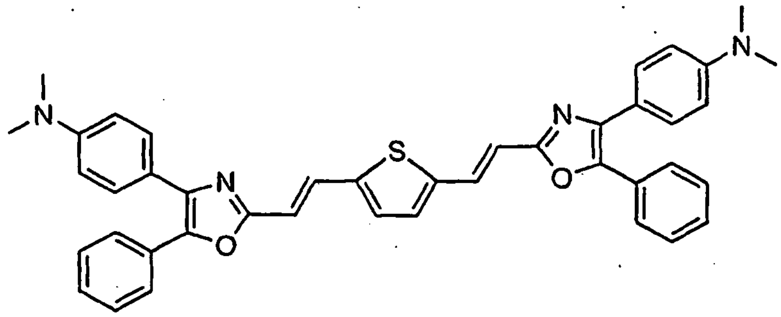

(IXm)

*N*-(4-(2-(4-(4-(4-(diphenylamino)phenyl)-5-(perfluorophenyl)oxazole-2-yl)phenyl)-5-(perfluorophenyl)oxazole-4-yl) phenyl)-*N*-phenylbenzeneamine

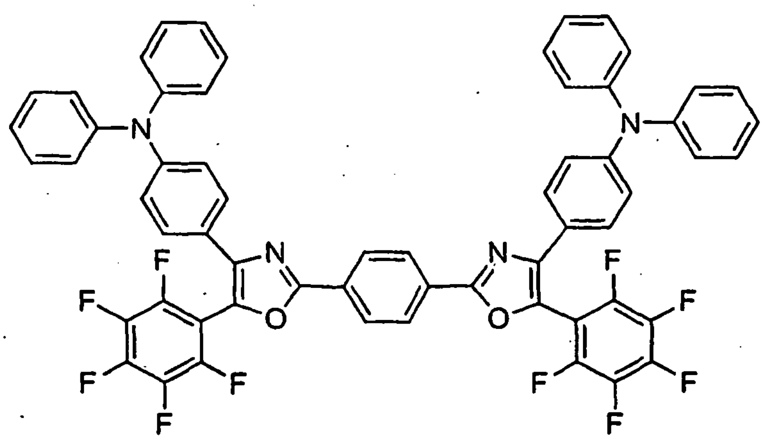

(IXn)

4-(5-(2-chlorophenyl)-2-(6-(5-(2-chlorophenyl)-4-(4-(diethylamino)phenyl)oxazole-2-yl)pyridine-2-yl)oxazole-4-yl)-*N,N*-diethylbenzeneamine

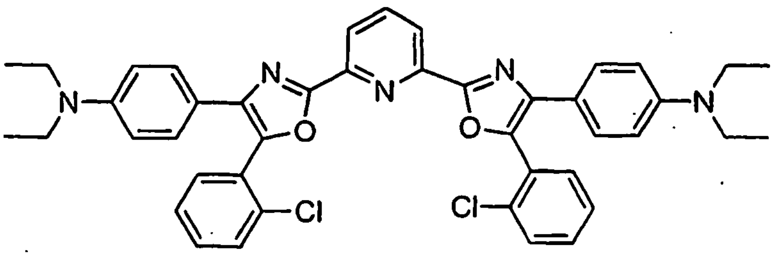

(IXo)

4-(2-(3,5-bis(5-(2-chlorophenyl)-4-(4-(diethylamino)phenyl)oxazole-2-yl)phenyl)-5-(2-chlorophenyl)oxazole-4-yl)-N,N-diethylbenzeneamine

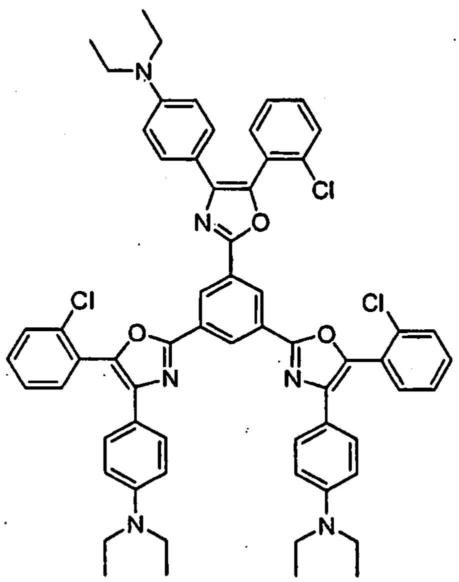

(IXp)

4-(2-((1*E*,9*E*,11*E*)-3,5-bis((*E*)-2-(4-(4-(dimethylamino)phenyl)-5-phenyloxazole-2-yl)vinyl)styryl)-5-phenyloxazole-4-yl)-*N,N*-dimethylbenzeneamine

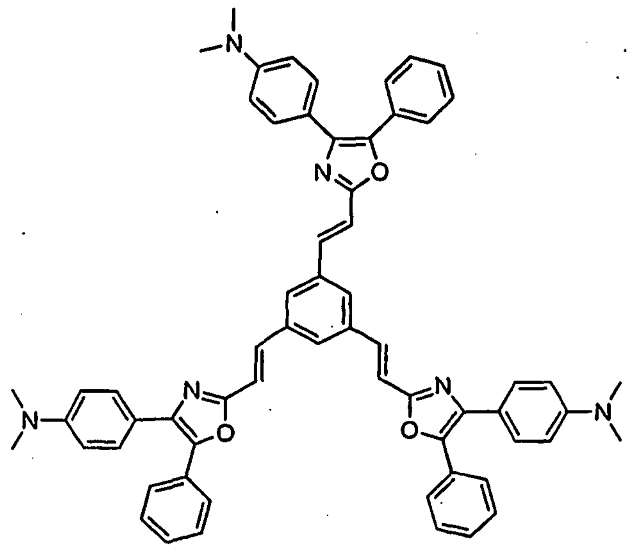

(IXq)

(*E*)-4-(5-(2-chlorophenyl)-2-(2-(5-(2-chlorophenyl)-4-(4-(diethylamino)phenyl)oxazole-2-yl)vinyl)oxazole-4-yl)-*N,N*-diethylbenzeneamine

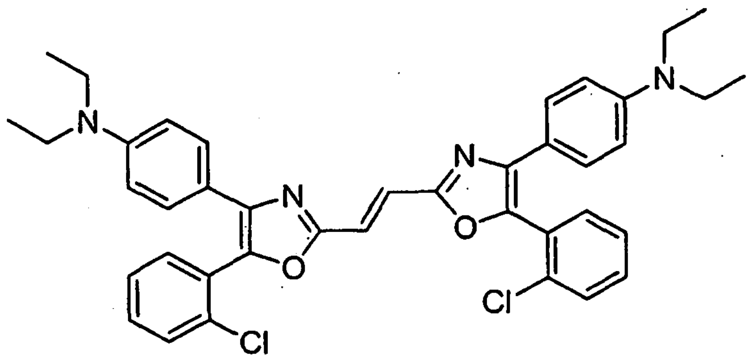

(IXr)

4-(5-(2-chlorophenyl)-2-((1*E*,3*E*)-4-(5-(2-chlorophenyl)-4-(4-(diethylamino)phenyl)oxazole-2-yl)buta-1,3-dienyl)oxazole-4-yl)-*N,N*-diethylbenzeneamine

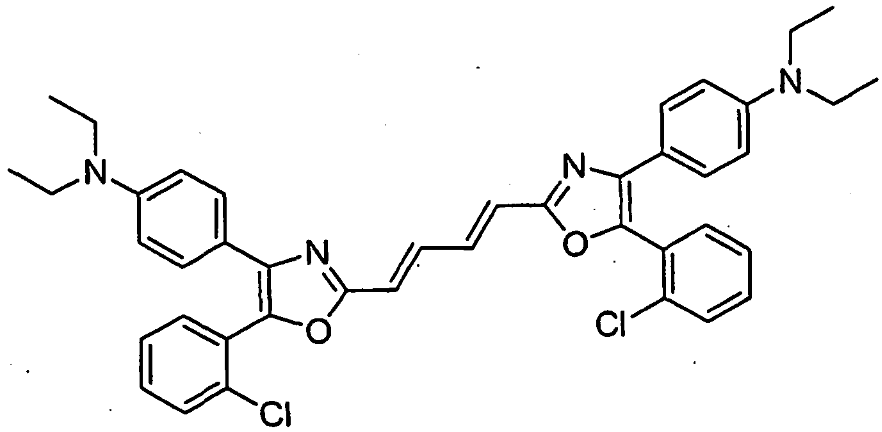

(IXs)

The UV sensitizers of formula (IX) that can be used in the present invention exhibit a strong yellow to greenish fluorescence. They can be prepared according to processes well known to the person skilled in the art, for example analogously to the process described in EP 0 129 059 A1 and US 3,257,203 A; the processes described in these documents can also be used for the synthesis of compounds not explicitly described therein by varying the starting compounds accordingly.

A compound of formula (X) can also be used as UV sensitizer:

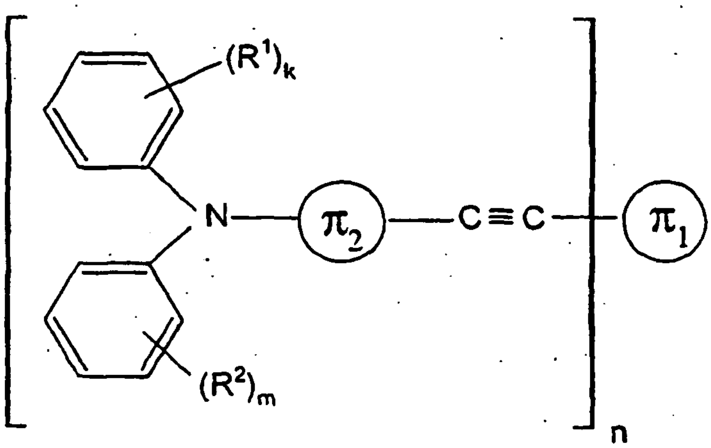

(X)

wherein 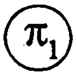 and each 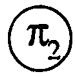 independently represent an aromatic or heteroaromatic unit, each group $R^1$ and $R^2$ is independently selected from a halogen atom, an alkyl group, aryl group or aralkyl group, a group $-NR^4R^5$ or a group $-OR^6$, $R^4$, $R^5$ and $R^6$ are independently selected from an alkyl group, aryl group and aralkyl group and
n is an integer of at least 2 and

k and m independently represent 0 or an integer from 1 to 5. 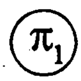 is preferably selected from a benzene, naphthalene, anthracene, fluorene, biphenyl, carbazole, furan, dibenzofuran, thiophene, dibenzothiophene, oxadiazole, thiadiazole, pyridine, pyrimidine and triazine unit as well as any combination of two or more of the above units which may be the same or different.

The unit 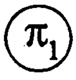 can optionally comprise one or more substituents selected from halogen atoms, alkyl groups, aralkyl groups, alkoxy groups and aryloxy groups.

Each 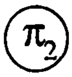 is preferably independently selected from a benzene, naphthalene, anthracene, fluorene, carbazole, thiophene and oxadiazole unit as well as any combination of two or more of the above units which may be the same or different.

Each unit 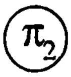 can optionally comprise one or more substituents selected from halogen atoms, alkyl groups, aralkyl groups, alkoxy group and aryloxy groups. It is especially preferred that all units 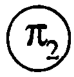 in formula (X) be the same.

Each group $R^1$ and $R^2$ is preferably independently selected from alkyl, alkyl-O- and halogen. $CH_3$, C1 and F are especially preferred.

If k = 1 and/or m = 1, the substituent $R^1$ or $R^2$ is preferably located in para position to the C atom bonded to the N atom in formula (X).

n is preferably an integer of 2 or 3; it is especially preferred that n = 2.

k and m are preferably independently 0 or 1; it is especially preferred that k = m = 0 or 1.

The following compounds are preferred compounds of formula (X):

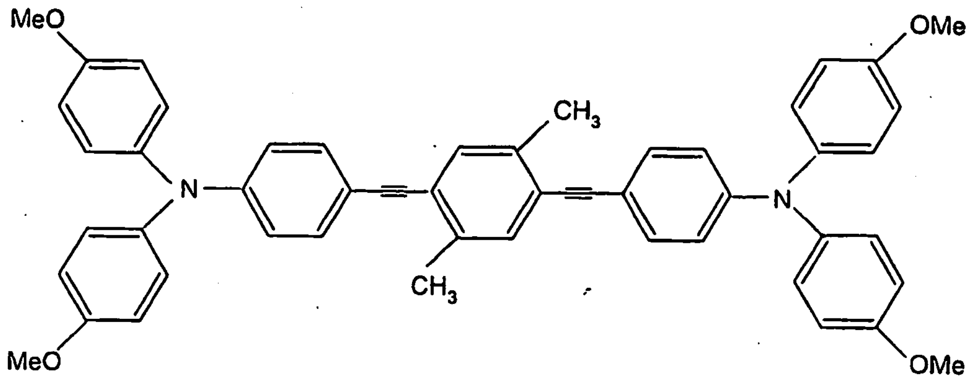

(Xa)

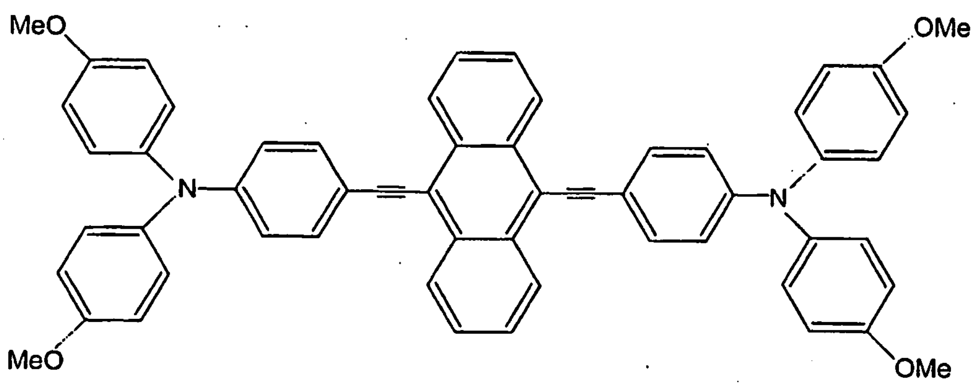

(Xb)

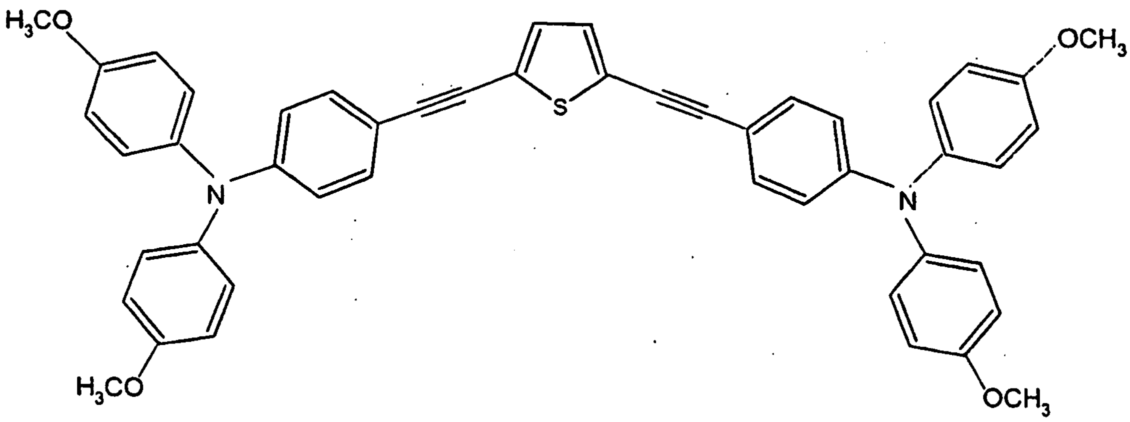

(Xc)

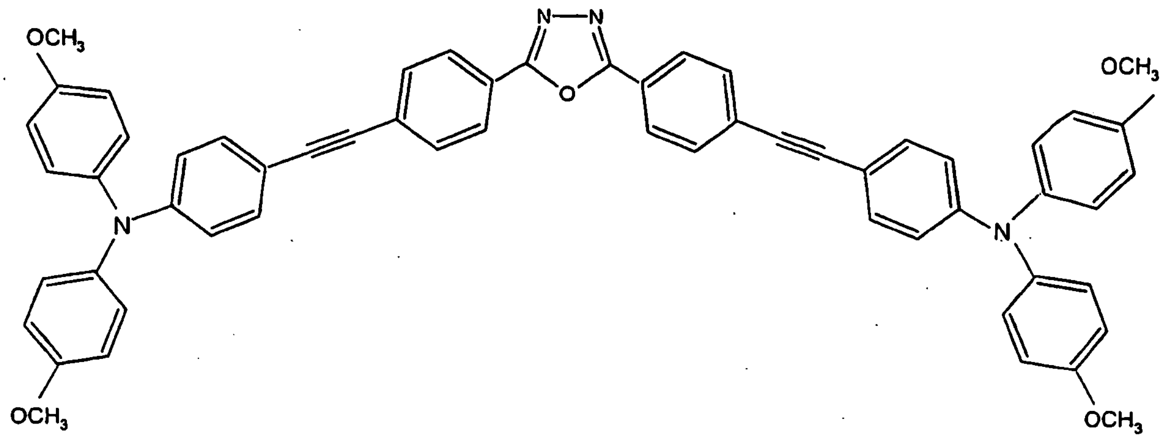

(Xd)

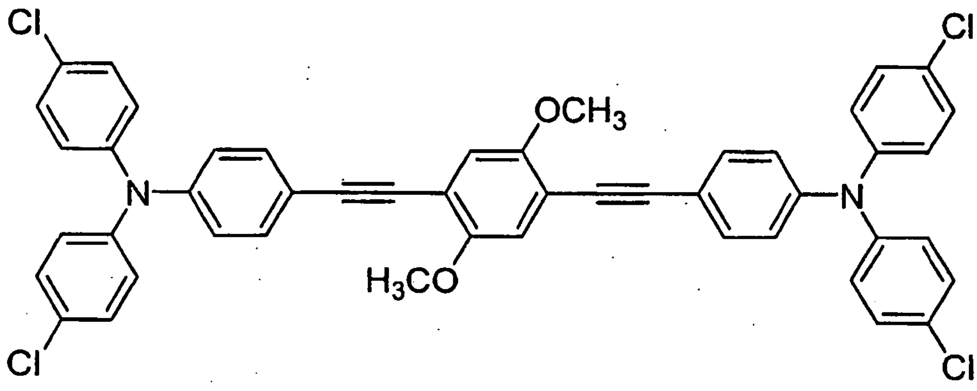

(Xe)

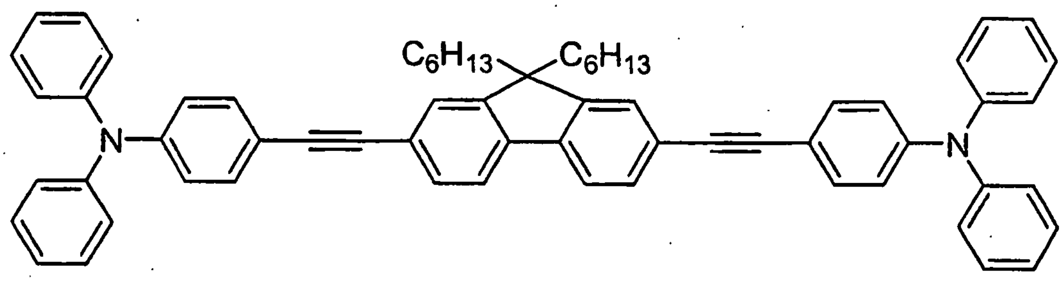

(Xf)

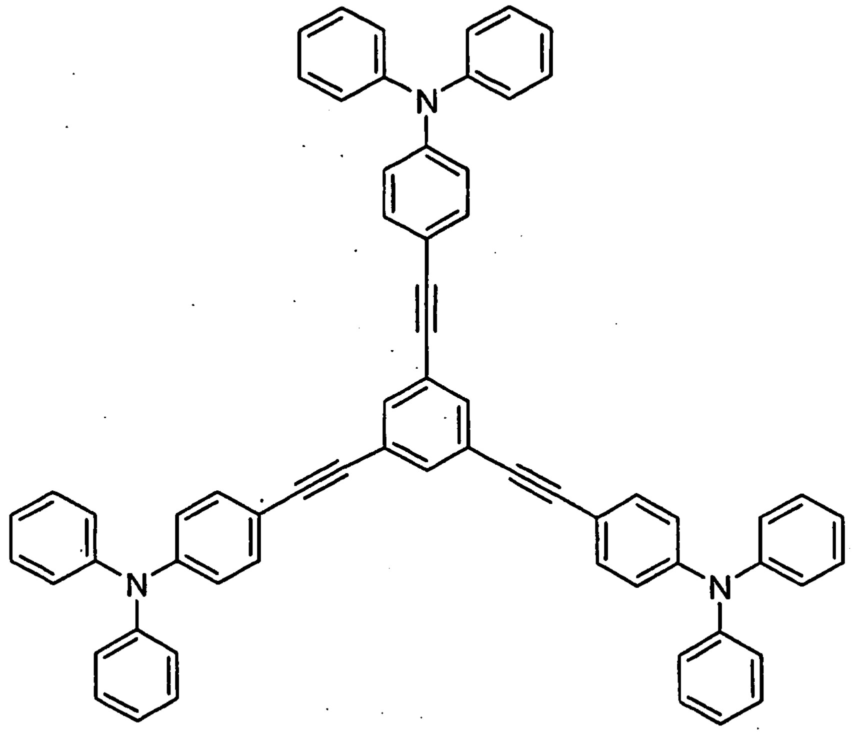

(Xg)

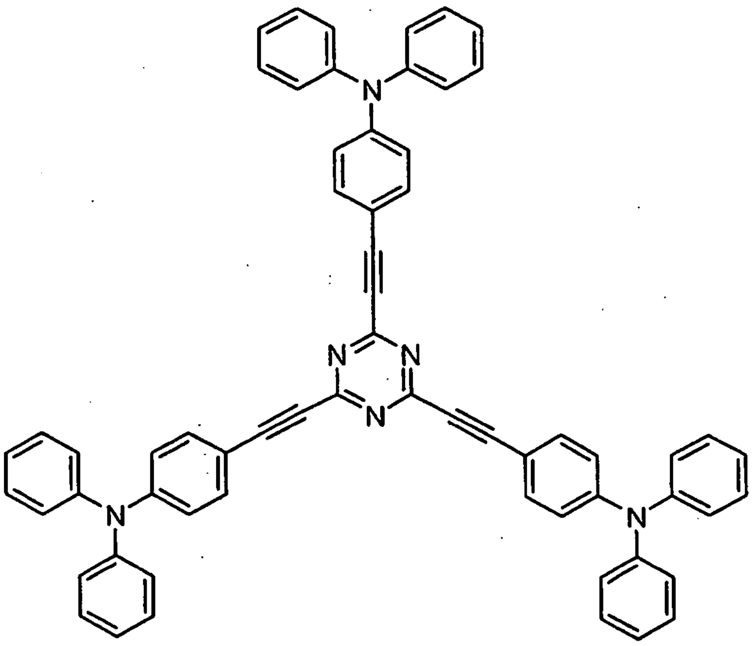

(Xh)

The UV sensitizers of formula (X) that can be used in the present invention exhibit a strong yellow to greenish fluorescence; these compounds are therefore no optical brighteners. They can be prepared according to processes well known to the person skilled in the art , for example analogously to the processes described in C. Lambert, et. al., "Bridge-mediated hopping or superexchange electron-transfer processes in bis(triarylamine) systems", Nature-Materials, 2002, 1, 69, or A. de Meijire, F. Diederich, "Metal Catalyzed Cross-Coupling Reactions", Wiley-VCH, Weinheim, 2004; the processes described therein can also be used for the synthesis of compounds not explicitly disclosed therein by varying the starting compounds accordingly.

An oligomeric or polymeric compound comprising the following structural unit (XI) can also be used as a UV sensitizer in the present invention:

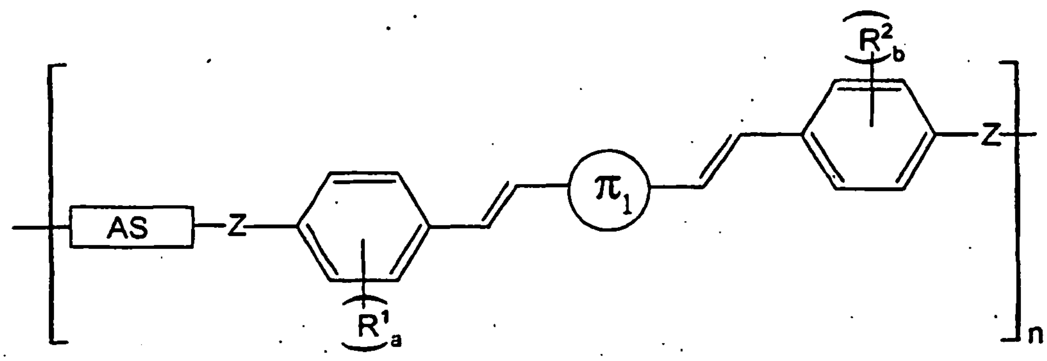

(XI)

wherein 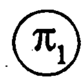 is an aromatic or heteroaromatic unit or a combination of the two so that a conjugated $\pi$-system is present between the two groups Z in structure (XI),

each Z independently represents a heteroatom connecting the spacer AS and the conjugated system,

each $R^1$ and $R^2$ is independently selected from a halogen atom, an alkyl, aryl, alkylaryl or aralkyl group, a group $-NR^3R^4$ and a group $-OR^5$,

each $R^3$, $R^4$ and $R^5$ is independently selected from an alkyl, aryl, alkylaryl and aralkyl group, a and b independently represent 0 or an integer from 1 to 4,

n has a value of >1 and

AS is an aliphatic spacer. 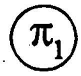 is preferably derived from benzene, naphthalene, anthracene, fluorene, biphenyl, carbazole, furan, dibenzofuran, thiophene, dibenzothiophene, dithienothiophene, oxadiazole, thiadiazole, pyridine, pyrimidine and combinations of two or more of the above groups which may be the same or different.

The aromatic or heteroaromatic unit 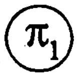 can optionally comprise one or more substituents selected from halogen atoms, alkyl, aralkyl, alkoxy and aryloxy groups.

Z represents a heteroatom which is preferably selected from O, N, S and Si, more preferred, Z is O or S and most preferred Z is O.

$R^1$ and $R^2$ are preferably independently selected from halogen atoms, alkyl and a group $-OR^5$, more preferred from a group $-OR^5$; it is particularly preferred that $R^1$ and $R^2$ be the same.

The groups $R^3$, $R^4$ and $R^5$ are preferably independently selected from alkyl and alkylaryl, especially preferred from $C_1$-$C_6$ alkyl.

a and b are preferably independently 0, 1 or 2, especially preferred 0 or 1; it is particularly preferred that a and b be the same.

n represents an average value and preferably has a value in the range of 2 to 25.

The aliphatic spacer AS is preferably

a group $\{(CH_2)_y-O\}_z-(CH_2)_x\}$, wherein x and y each independently represents an integer of at least 1 (it is especially preferred that y is 2 or 3, x is preferably an integer from 2 to 12) and

z represents an integer $\geq 0$ (it is especially preferred that z is 0, 1, 2, 3 or 4; if $z \neq 0$, x is preferably 2 and if $z = 0$, x is preferably an integer from 4 to 12),

a group

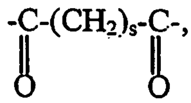

wherein s is an integer of at least 1 (it is especially preferred that s is 2 to 6),

a siloxane unit or a silane unit.

It is especially preferred that the aliphatic spacer is $-CO-(-CH_2-)_4-CO-$, $-(CN_2)_8-$ or $\{(CH_2)_2-O\}_2-(CH_2)_2\}$.

Preferably, the molecular weight of the UV sensitizer with the structural unit (XI) (weight average determined by means of gel permeation chromatography using polystyrene as standard) is at least 500 g/mol, preferably at least 1,000 g/mol, and most preferred in the range of 5,000 to 30,000.

UV sensitizers with structural unit (XI) which only consist of structural units (XI), i.e. do not comprise any other structural units, are especially preferred.

Examples of suitable UV sensitizers with structural unit (XI) are those comprising one or more of the following structural units (XIa) to (XIi) and preferably consisting of only one or more of these units:

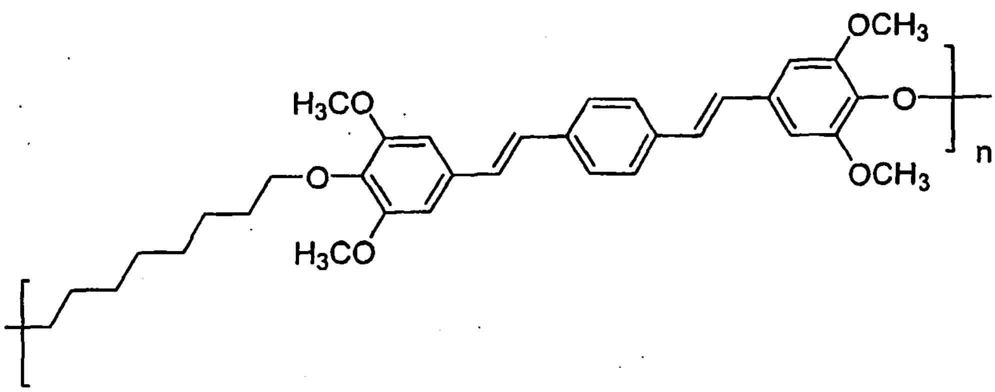

(XIa)

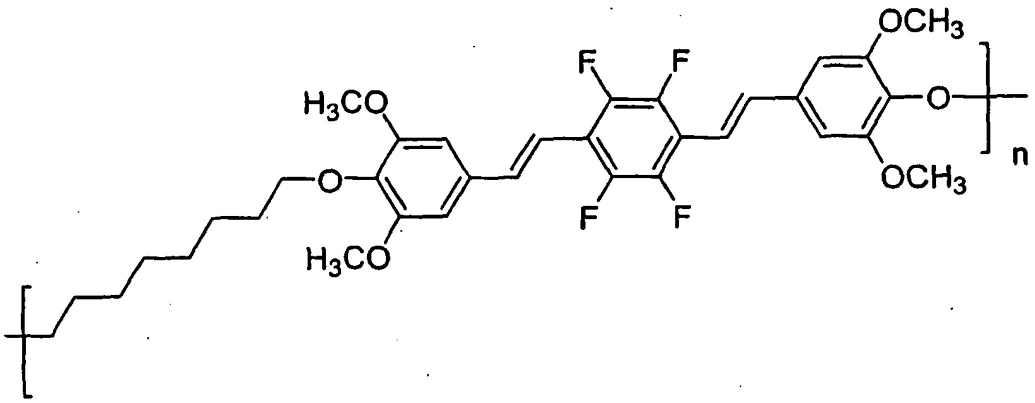

(XIb)

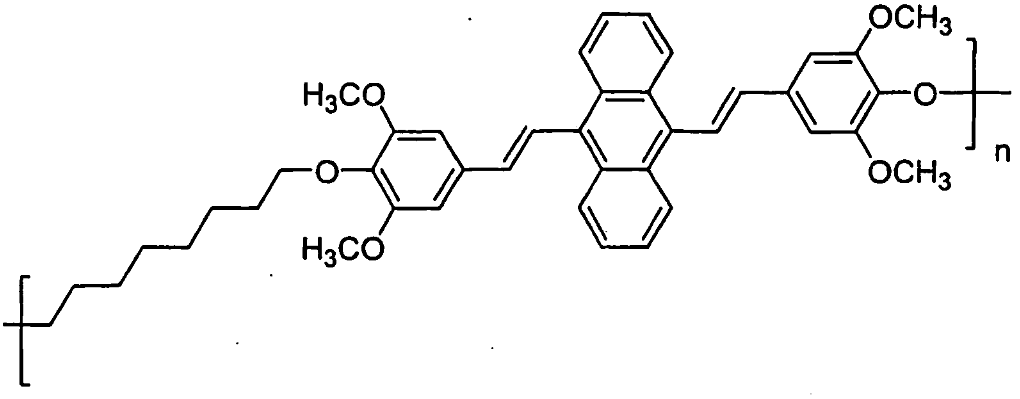

(XIc)

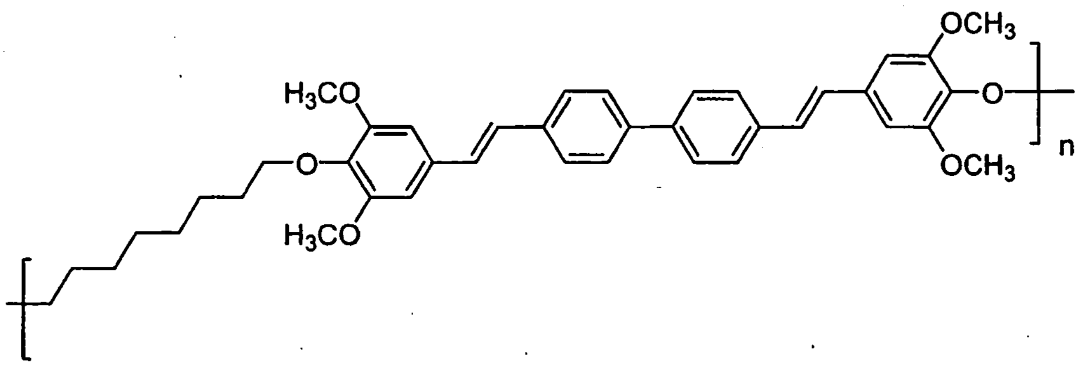

(XId)

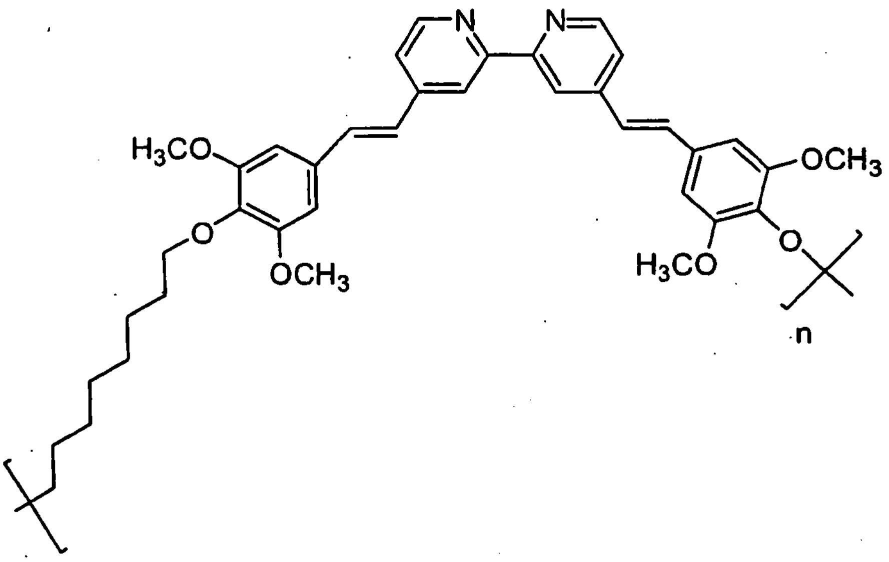

(XIe)

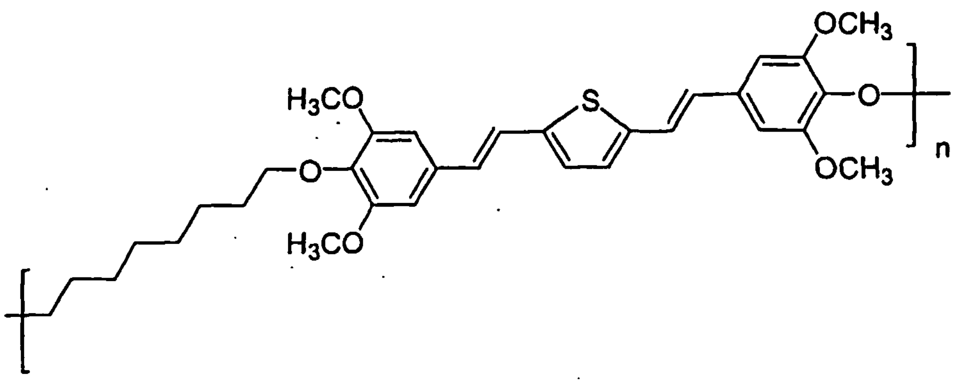

(XIf)

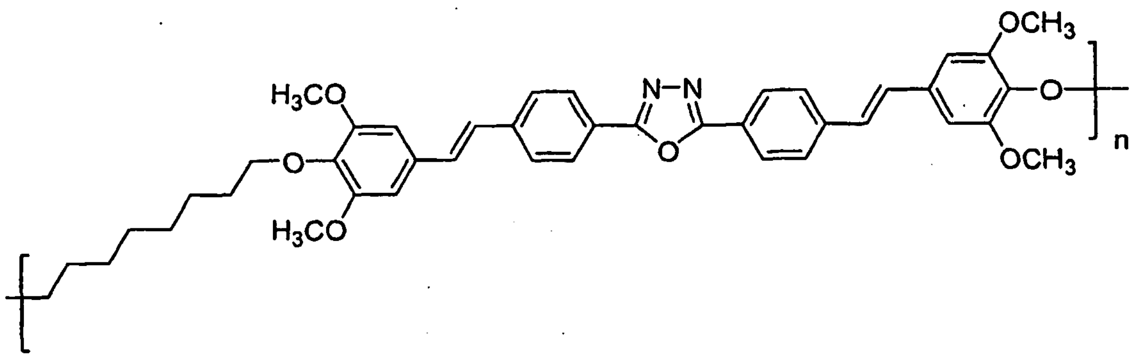

(XIg)

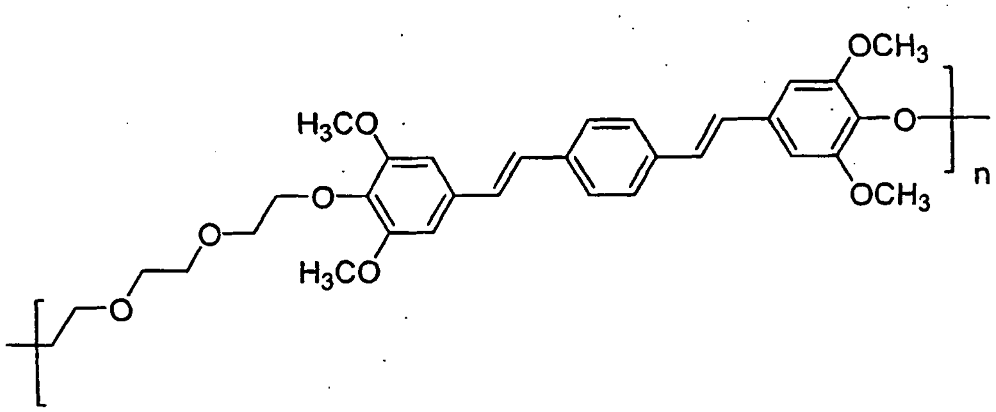

(XIh)

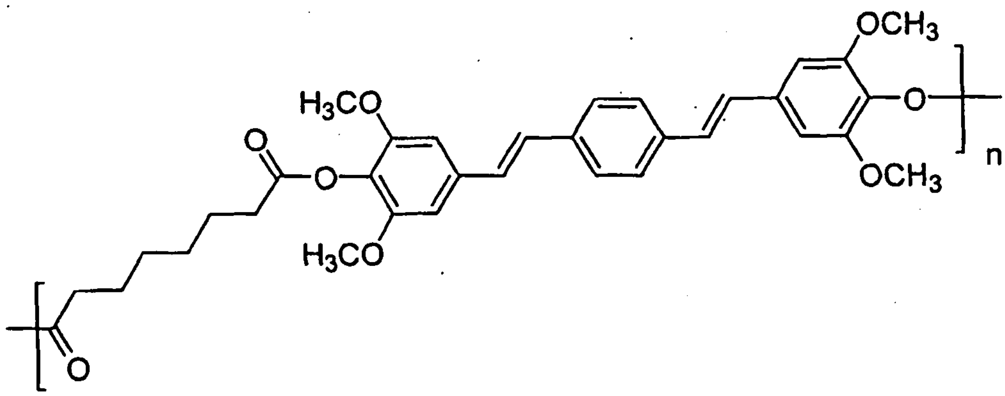

(XIi)

The UV sensitizers with structural unit (XI) that can be used in the present invention exhibit a strong yellow to greenish fluorescence. They can be prepared according to the process of Wittig polymerization well known to the person skilled in the art from a phosphonate and a bisaldehyde, for example analogously to the process described in Macromolecules 1999, 32, 7409-7413; the processes described therein can also be used for the synthesis of compounds not explicitly disclosed therein by varying the starting compounds accordingly. Other process variations on the Wittig polymerization using a phosphonium salt are e.g. described Macromolecules 2001, 33, 7426-7430 and Macromolecules 2001, 34, 4124-4129.

For UV-sensitive coatings (i.e. coatings sensitive to 300 to <480 nm) with UV sensitizers, the coinitiators are for example selected from onium compounds, for example those where the onium cation is selected from iodonium, sulfonium, phosphonium, oxysulfoxonium, oxysulfonium, sulfoxonium, ammonium, diazonium, selenonium, arsenonium and N-substituted N-heterocyclic onium cations wherein N is substituted with an optionally substituted alkyl, alkenyl, alkinyl or aryl; N-arylglycines and derivatives thereof (e.g. N-phenylglycine); aromatic sulfonyl halides; trihalomethylarylsulfones; imides such as N-benzoyl-oxyphthalimide; 9,10-dihydroanthracene derivatives; N-aryl, S-aryl or O-aryl polycarboxylic acids with at least two carboxy groups of which at least one is bonded to the nitrogen, oxygen or sulfur atom of the aryl unit (e.g. aniline diacetic acid and derivatives thereof and other coinitiators described in US 5,629,354 A); hexaarylbiimidazoles; thiol compounds (mercaptothiazoles, mercaptooxadiazoles, mercaptotetrazines, mercaptoimidazoles, mercaptotetrazoles, mercaptopyridines, mercaptooxazoles and mercaptotriazoles; they include 2-mercaptobenzoxazole, 2-mercaptobenzothiazole, 2-mercaptobenzimidazole, pentaerythritol-tetrakis(mercaptoacetate), 4-acetamidothiophenol, mercaptosuccinic acid, dodecanthiol, betamercaptoethanol, 6-ethoxy-2-mercaptobenzothiazole, 4-methyl-4H-1,2,4-triazole-3-thiol, 2-mercapto-1-methylimidazole, 2-mercapto-5-methylthio-1,3,4-thiadiazole, 5-n-butylthio-2-mercapto-1,3,4-thiadiazole, 4-methoxybenzenethiol, 1-phenyl-1H-tetrazole-5-thiol, 4-phenyl-4H-1,2,4-triazole-3-thiol, pentaerythritol-tetrakis(3-mercaptopropionate), trimethylolpropane-tris(mercaptoacetate), 2-mercaptopyridine, 4-mercaptopyridine, 2-mercapto-3H-quinazoline and 2-mercaptothiazoline); polyhalogenalkyl-substituted compounds, such as e.g. 1,3,5-triazine derivatives with 1 to 3 $CX_3$ groups (wherein every X is independently selected from a chlorine or

bromine atom, and is preferably a chlorine atom); oxime ethers and oxime esters, such as for example those derived from benzoin; acrylphosphine oxides, diacylphosphine oxides and peroxides (e.g. those listed in EP 1 035 435 A1 as activators of the type of an organic peroxide).

The negative working radiation-sensitive composition of the present invention does not comprise any metallocenes since it was found that they negatively affect the yellow light stability of the printing plate precursor.

Hexaarylbiimidazoles, onium compounds, thiol compounds and polyhalogenalkyl-substituted compounds are preferred coinitiators for UV sensitizers.

Suitable hexaarylbiimidazoles are for example represented by the following formula (XII):

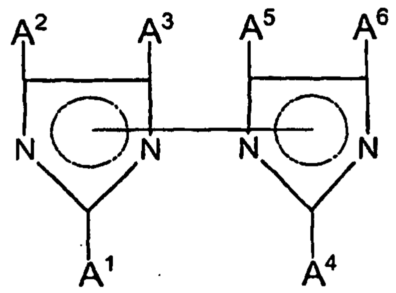

(XII)

wherein $A^1$-$A^6$ are substituted or unsubstituted $C_5$-$C_{20}$ aryl groups which are identical or different from each other and in whose rings one or more carbon atoms can optionally be substituted by heteroatoms selected from O, N and S. Suitable substituents for the aryl groups are those that do not inhibit the light-induced dissociation to triarylimidazolyl radicals, e.g. halogen atoms (fluorine, chlorine, bromine, iodine), -CN, $C_1$-$C_6$ alkyl (optionally with one or more substituents selected from halogen atoms, -CN and -OH), $C_1$-$C_6$ alkoxy, $C_1$-$C_6$ alkylthio, ($C_1$-$C_6$ alkyl) sulfonyl.

Preferred aryl groups are substituted and unsubstituted phenyl, biphenyl, naphthyl, pyridyl, furyl and thienyl groups. Especially preferred are substituted and unsubstituted phenyl groups, and particularly preferred are halogen-substituted phenyl groups.

Examples include:

2,2'-Bis(bromophenyl)-4,4',5,5'-tetraphenylbiimidazole,
2,2'-bis(p-carboxyphenyl)-4,4',5,5"-tetraphenylbiimidazole,
2,2'-bis(o-chlorophenyl)-4,4',5,5'-tetrakis(p-methoxyphenyl)-biimidazole,
2,2'-bis(p-chlorophenyl)-4,4',5,5'-tetrakis(p-methoxyphenyl)-biimidazole,
2,2'-bis(p-cyanophenyl)-4,4'5,5'-tetrakis(p-methoxyphenyl)-biimidazole,
2,2'-bis(2,4-dichlorophenyl)-4,4',5,5'-tetraphenylbiimidazole,
2,2'-bis(2,4-dimethoxyphenyl)-4,4',5,5'-tetraphenylbiimidazole,
2,2'-bis(o-ethoxyphenyl)-4,4',5,5'-tetraphenylbiimidazole,
2,2'-bis(m-fluorophenyl)-4,4',5,5'-tetraphenylbiimidazole,
2,2'-bis(o-fluorophenyl)-4,4',5,5'-tetraphenylbiimidazole,
2,2'-bis(p-fluorophenyl)-4,4',5,5'-tetraphenylbiimidazole,
2,2'-bis(o-hexoxyphenyl)-4,4',5,5'-tetraphenylbiimidazole,
2,2'-bis(o-hexylphenyl)-4,4',5,5'-tetrakis(p-methoxyphenyl)-biimidazole,
2,2'-bis(3,4-methylenedioxyphenyl)-4,4',5,5'-tetraphenylbiimidazole,
3,2'-bis(o-chlorophenyl)-4,4',5,5'-tetrakis(m-methoxyphenyl)biimidazole,
2,2'-bis(o-chlorophenyl)-4,4',5,5'-tetrakis[m-(betaphenoxy-ethoxyphenyl)]biimidazole,
2,2'-bis(2,6-dichlorophenyl)-4,4',5,5'-tetraphenylbiimidazole,
2,2'-bis(o-methoxyphenyl)-4,4',5,5'-tetraphenylbiimidazole,
2,2'-bis(p-methoxyphenyl)-4,4'-bis(o-methoxyphenyl)-5,5'-diphenylbiimidazole,
2,2'-bis(o-nitrophenyl)-4,4',5,5'-tetraphenylbiimidazole,
2,2'-bis(p-phenylsulfonylphenyl)-4,4',5,5'-tetraphenyl-biimidazole,
2,2'-bis(p-sulfamoylphenyl)-4,4',5,5'-tetraphenylbiimidazole,
2,2'-bis(2,4,5-trimethylphenyl)-4,4',5,5'-tetraphenylbiimidazole,
2,2'-di-4-biphenylyl-4,4',5,5'-tetraphenylbiimidazole,
2,2'-di-1-naphthyl-4,4',5,5'-tetrakis(p-methoxyphenyl)-biimidazole,
2,2'-di-9-phenanthryl-4,4',5,5'-tetrakis(p-methoxyphenyl)-biimidazole,
2,2'-diphenyl-4,4',5,5'-tetra-4-biphenylylbiimidazole,

2,2'-diphenyl-4,4',5,5'-tetra-2,4-xylylbiimidazole,
2,2'-di-3-pyridyl-4,4',5,5'-tetraphenylbiimidazole,
2,2'-di-3-thienyl-4,4',5,5'-tetraphenylbiimidazole,
2,2'-di-o-tolyl-4,4',5,5'-tetraphenylbiimidazole,
2,3'-di-p-tolyl-4,4'-di-o-tolyl-5,5'-diphenylbiimidazole,
2,2'-di-2,4-xylyl-4,4',5,5'-tetraphenylbiimidazole,
2,2',4,4',5,5'-hexakis(p-phenylthiophenyl)biimidazole,
2,2',4,4',5,5'-hexa-1-naphthylbiimidazole,
2,2',4,4',5,5'-hexaphenylbiimidazole,
2,2'-bis(2-nitro-5-methoxyphenyl)-4,4',5,5'-tetraphenylbiimidazole,
2,2'-bis(o-nitrophenyl)-4,4',5,5'-tetrakis(m-methoxyphenyl)biimidazole,
2,2'-bis(2-chloro-5-sulfophenyl)-4,4',5,5'-tetraphenylbiimidazole,
2,2',5-Tris(2-chlorophenyl)-4-(3,4-dimethoxyphenyl)-4,5'diphenylbiimidazole,
2,2'-bis(o-chlorophenyl)-4,4',5,5'-tetraphenylbiimidazole,
2,2'-bis(o-chlorophenyl)-4,4',5,5'-tetra(p-fluorophenyl)biimidazole,
2,2'-bis(o-bromophenyl)-4,4',5,5'-tetra(p-iodophenyl)biimidazole,
2,2'-bis(o-chlorophenyl)-4,4',5,5'-tetra(p-chloronaphthyl)biimidazole,
2,2'-bis(o-chlorophenyl)-4,4',5,5'-tetra(p-chlorophenyl)biimidazole,
2,2'-bis(o-bromophenyl)-4,4',5,5'-tetra(p-chloro-p-methoxyphenyl)biimidazole,
2,2'-bis(o-chlorophenyl)-4,4',5,5'-tetra(o,p-dichlorophenyl)biimidazole,
2,2'-bis(o-chlorophenyl)-4,4',5,5'-tetra(o,p-dibromophenyl)biimidazole,
2,2'-bis(o-bromophenyl)-4,4',5,5'-tetra(o,p-dichlorophenyl)biimidazole or
2,2'-bis(o,p-dichlorophenyl)-4,4',5,5'-tetra(o,p-dichlorophenyl)biimidazole.

Suitable hexaarylbiimidazoles are for example described in US-A-4,565,769 and US-A-3,445,232 and can be prepared according to known methods, such as e.g. the oxidative dimerization of triarylimidazoles.

The term "polyhalogenalkyl-substituted compound" as used in the present invention refers to compounds comprising either one polyhalogenated or several monohalogenated alkyl substituents. The halogenated alkyl group preferably comprises 1 to 3 carbon atoms; a halogenated methyl group is especially preferred. Fluorine, chlorine and bromine atoms are preferably used as halogen atoms, with chlorine and bromine atoms being especially preferred.

Examples of especially suitable polyhalogenalkyl-substituted compounds for use as coinitiators in the present invention include: Trihalogenmethylarylsulfones and trihalogenmethylhetarylsulfones, such as e.g. tribromomethylphenylsulfone and tribromo-methyl-2-pyridylsulfone; 2-phenyl-4,6-bis(trichloromethyl)-s-triazine, 2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis-trichloromethyl-s-triazine, 2-(4-ethoxy-naphtho-1-yl)-4,6-bis(trichloromethyl)-s-triazine and 2-[4-(2-ethoxyethyl)-naphtho-1-yl]-4,6-bis(trichloromethyl)-s-triazine; other heterocycles with at least one $C(Hal)_3$ group, such as e.g. 2-trichloromethylbenzoxazole, 2-trichloromethylbenzthiazole, 2-trichloromethyl-5-phenyl-1,3-oxazole; 1,2,3,4-tetrabromo-butane.

The IR-sensitive elements (i.e. elements sensitive to the spectral range of >750 to 1,100 nm) comprise at least one IR sensitizer and one or more coinitiators.

In the present invention, the IR absorbers are preferably selected from the class of triarylamine dyes, thiazolium dyes, indolium dyes, oxazolium dyes, cyanine dyes, polyaniline dyes, polypyrrol dyes, polythiophene dyes and phthalocyanine dyes and pigments. However, other IR absorbers, e.g. those described in US 2002/0025489 A1, can be used as well.

Suitable IR absorbers include e.g. the following compounds:

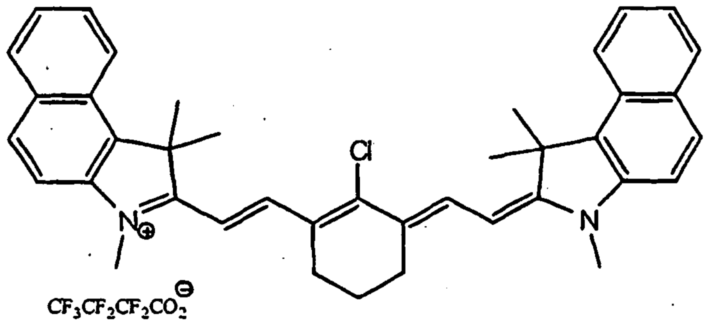

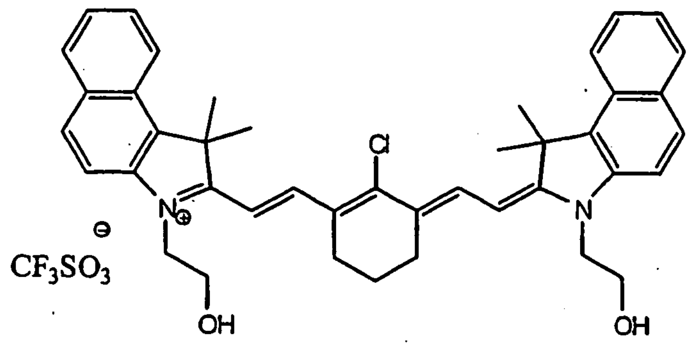

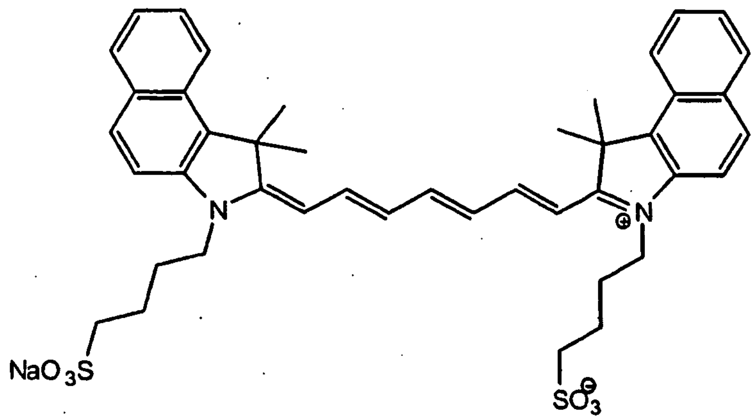

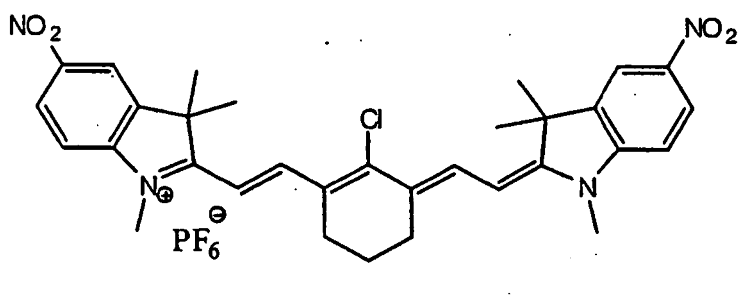

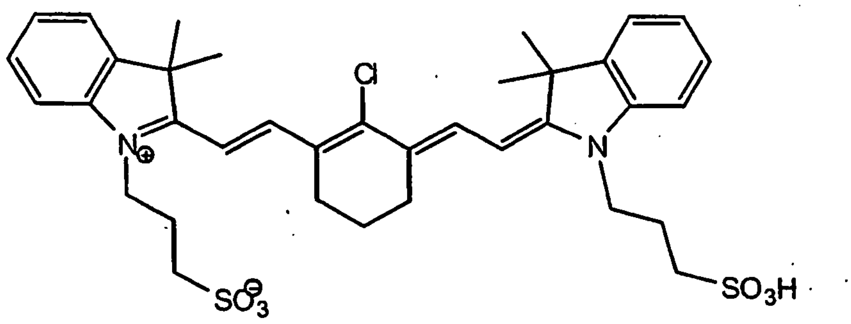

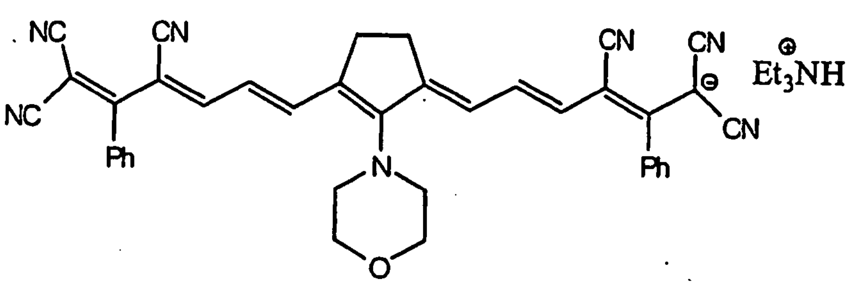

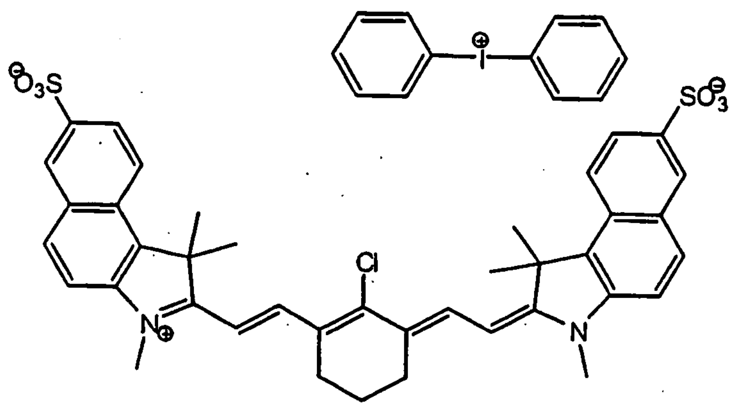

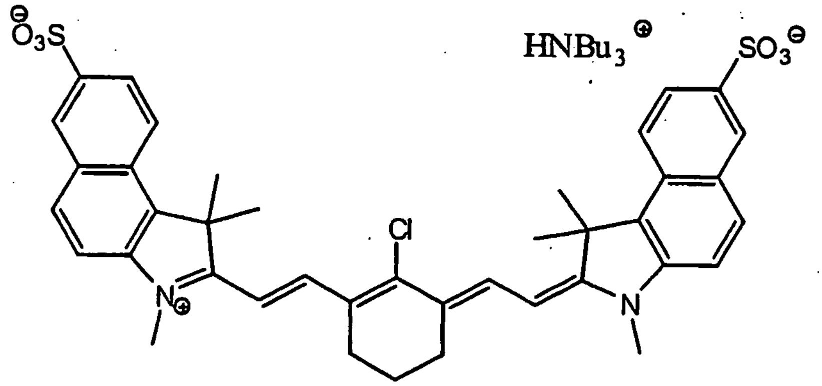

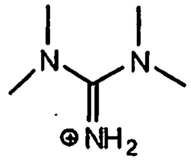

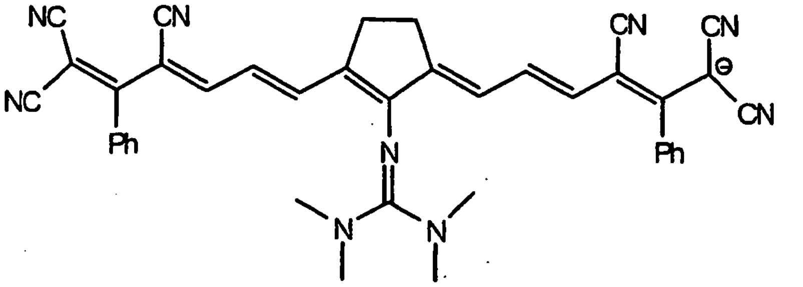

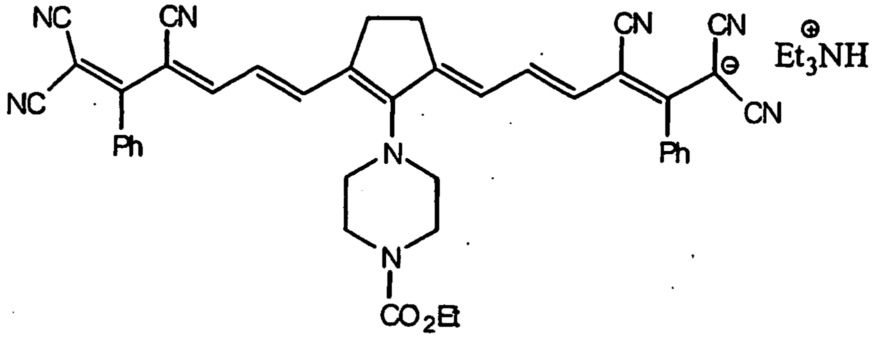

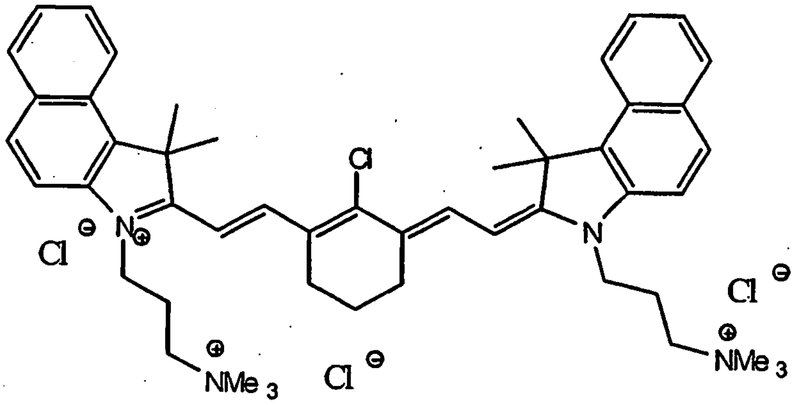

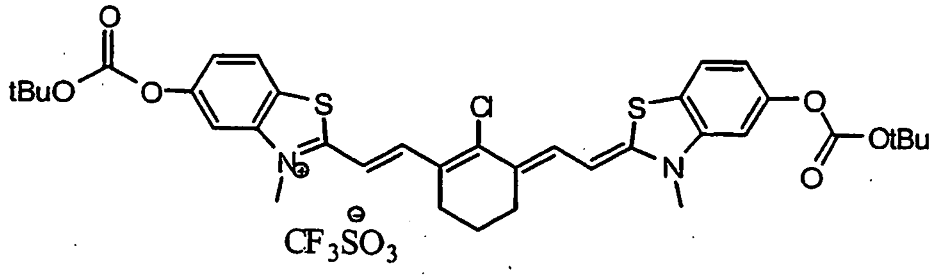

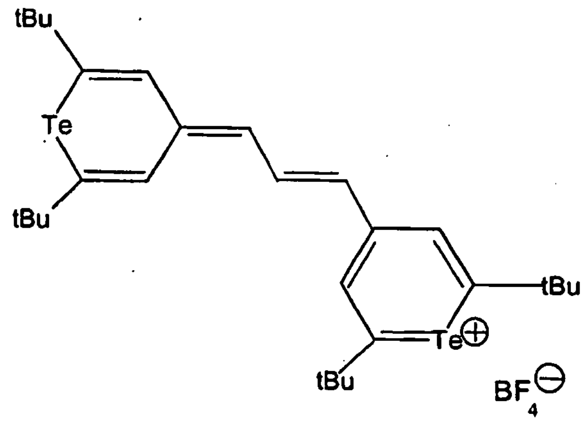

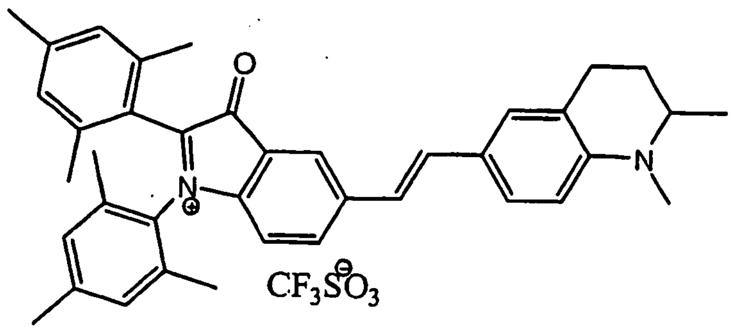

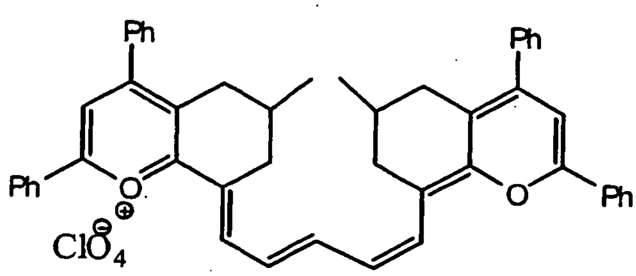

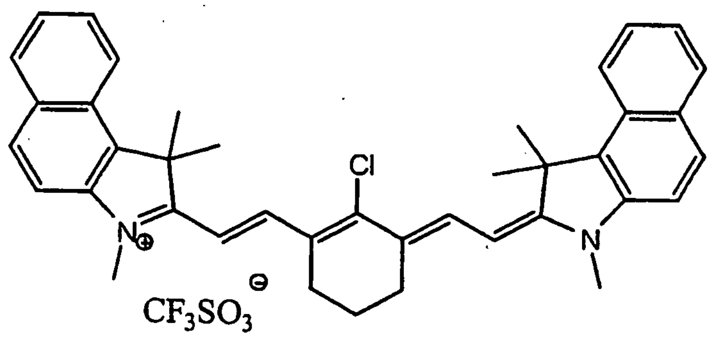

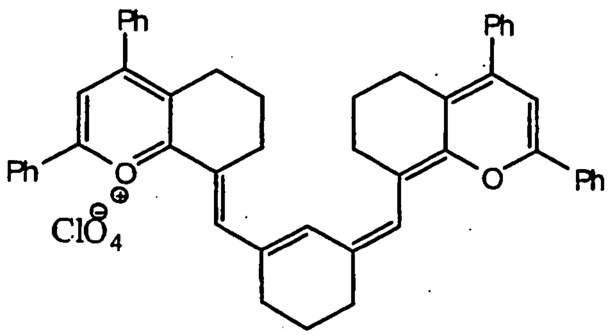

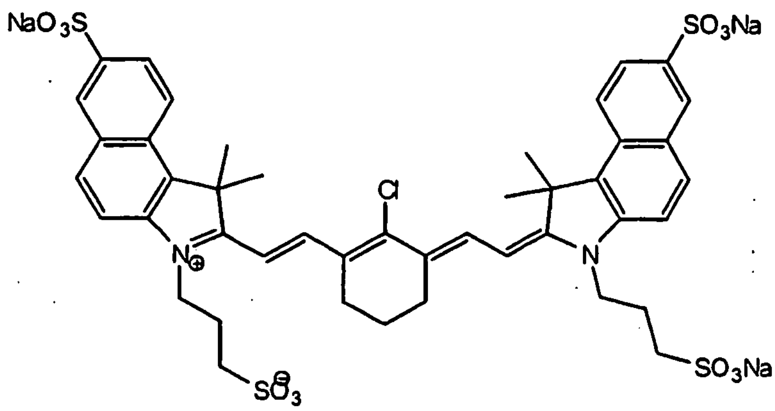

According to another embodiment of the present invention, an IR sensitizer of formula (XIII) is used.

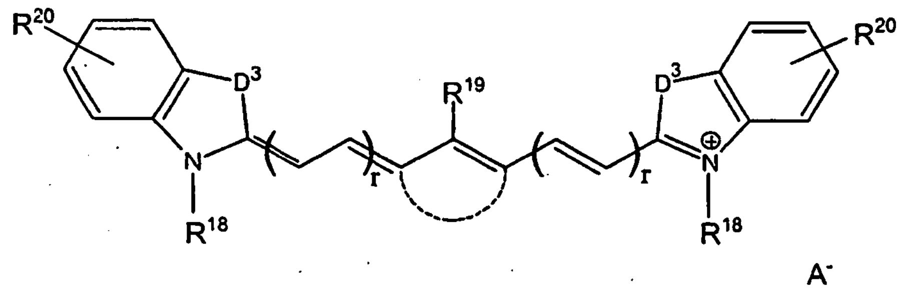

(XIII)

wherein
each $D^3$ independently represents S, O, $NR^{12}$ or $C(alkyl)_2$;
each $R^{18}$ independently represents an alkyl group;
$R^{19}$ represents a halogen atom, $SR^{12}$, $OR^{12}$ or $NR^{12}_2$;
each $R^{20}$ independently represents a hydrogen atom, an alkyl group, $OR^{12}$, $SR^{12}$ or $NR^{12}_2$ or a halogen atom; $R^{20}$ can also be a benzofused ring;
$A^-$ represents an anion;
--- represents an optionally present carbocyclic five- or six-membered ring;
$R^{12}$ represents an alkyl or aryl group; in the case of $NR^{12}_2$, one group $R^{12}$ can also represent H;
each r can independently be 0, 1, 2 or 3.

These IR sensitizers absorb in the range of 800 to about 1,100 nm; those of formula (XIII) absorbing in the range of 810 to 860 nm are especially preferred.

$D^3$ is preferably a $C(alkyl)_2$ group, wherein the alkyl group preferably comprises 1 to 3 carbon atoms.
$R^{18}$ is preferably an alkyl group with 1 to 4 carbon atoms.
$R^{19}$ is preferably $SR^{12}$.
$R^{20}$ is preferably a hydrogen atom.
$R^{12}$ is preferably a phenyl group.

It is preferred that the dotted line represens a ring group with 5 or 6 carbon atoms.

The counterion $A^-$ is preferably a chloride ion or a tosylate anion.

Of the IR absorbers of structure (XIII), those with a symmetrical structure are especially preferred.

Examples of especially preferred IR absorbers of structure (XIII) include:

[2-[2-Phenylsulfonyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,
2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride,
2-[2-[2-thiophenyl-3-[2-(1,3-dihydro-1,3,3-trimethyl-2H-indole-2-ylidene)-ethylidene]-1-cyclopentene-1-yl]-ethenyl]-1,3,3-trimethyl-3H-indoliumtosylate,
2-[2-[2-chloro-3-[2-(1,3-dihydro-1,3,3-trimethyl-2H-benzo[e]-indole-2-ylidene)-ethylidene]-1-cyclohexene-1-yl]-ethenyl]-1,3,3-trimethyl-1H-benzo[e]-indolium-tosylate and 2-[2-[2-chloro-3-[2-ethyl-3H-benzthiazol-2-ylidene)-ethylidene]-1-cyclohexene-1-yl]-ethenyl]-3-ethyl-benzthiazolium-tosylate.

Basically, all coinitiators mentioned above in connection with UV-sensitive systems can be used as coinitiators for IR-sensitive systems, preferably polyhalogenalkyl-substituted compounds, onium salts and other compounds described in US 6,309,792 B1. Polyhalogenalkyl-substituted compounds, thiol compounds, N-arylglycines and derivatives thereof, N-aryl, S-aryl or O-aryl polycarboxylic acids with at least two carboxy groups of which at least one is bonded to the nitrogen, oxygen or sulfur atom of the aryl unit and onium compounds as mentioned in connection with the coinitiators for UV-sensitive initiator systems are especially suitable.

In particular polycarboxylic acids of the general formula (XIV) are suitable polycarboxylic acids

$$R^{21}\text{-}(CR^{22}R^{23})_a\text{-}A\text{-}CH_2COOH \qquad (XIV)$$

wherein:

A is selected from O, S or $NR^{24}$, wherein $R^{24}$ represents a hydrogen atom, a $C_1$-$C_6$ alkyl group, a group $CH_2CH_2COOH$ or a $C_1$-$C_5$ alkyl group substituted with -COOH;

$R^{21}$, $R^{22}$ and $R^{23}$ are independently selected from a hydrogen atom, $C_1$-$C_6$ alkyl group, substituted or unsubstituted aryl group, -COOH or $NR^{25}CH_2COOH$, wherein $R^{25}$ is selected from $-CH_2COOH$, $-CH_2OH$ and $-(CR_2)N(CH_2)COOH$; and

a is 0, 1, 2 or 3,

wherein A, $R^{21}$, $R^{22}$ and $R^{23}$ are selected such that in addition to the group COOH shown in formula (XIV) at least one further group COOH is present in the molecule.

N-aryl-polycarboxylic acids are especially preferred; in particular those of formula (XIVa) below:

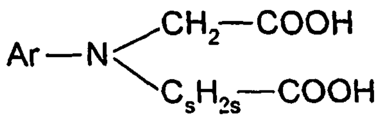

(XIVa)

wherein Ar represents a mono- or polysubstituted or unsubstituted aryl group and s is an integer of 1 to 5,
and of formula (XIVb)

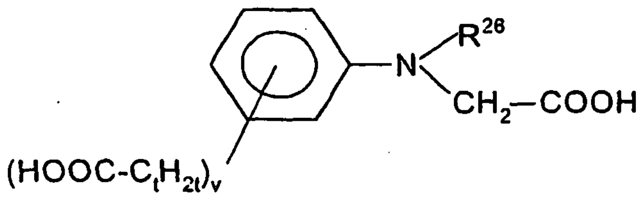

(XIVb)

wherein $R^{26}$ represents a hydrogen atom or a $C_1$-$C_6$ alkyl group and t and v are each an integer from 1 to 5.

Possible substituents of an aryl group are $C_1$-$C_3$ alkyl groups, $C_1$-$C_3$ alkoxy groups, $C_1$-$C_3$ thioalkyl groups and halogen atoms. The aryl group can comprise 1 to 3 identical or different substituents.

Ar preferably represents a phenyl group.

In formula (XIVb), v is preferably 1 and $R^{26}$ preferably represents a hydrogen atom.

Examples of suitable polycarboxylic acids include:

(p-Acetamidophenylimino)diacetic acid
3-(bis(carboxymethyl)amino)benzoic acid
4-(bis(carboxymethyl)amino)benzoic acid
2-[(carboxymethyl)phenylamino]benzoic acid
2-[(carboxymethyl)phenylamino]-5-methoxybenzoic acid
3-[bis(carboxymethyl)amino]-2-naphthalenecarboxylic acid
N-(4-aminophenyl)-N-(carboxymethyl)glycine
N,N'-1,3-phenylene-bisglycine
N,N'-1,3-phenylene-bis[N-(carboxymethyl)]glycine
N,N'-1,2-phenylene-bis[N-(carboxymethyl)]glycine
N-(carboxymethyl)-N-(4-methoxyphenyl)glycine
N-(carboxymethyl)-N-(3-methoxyphenyl)glycine
N-(carboxymethyl)-N-(3-hydroxyphenyl)glycine
N-(carboxymethyl)-N-(3-chlorophenyl)glycine
N-(carboxymethyl)-N-(4-bromophenyl)glycine
N-(carboxymethyl)-N-(4-chlorophenyl)glycine
N-(carboxymethyl)-N-(2-chlorophenyl)glycine
N-(carboxymethyl)-N-(4-ethylphenyl)glycine
N-(carboxymethyl)-N-(2,3-dimethylphenyl)glycine
N-(carboxymethyl)-N-(3,4-dimethylphenyl)glycine
N-(carboxymethyl)-N-(3,5-dimethylphenyl)glycine
N-(carboxymethyl)-N-(2,4-dimethylphenyl)glycine
N-(carboxymethyl)-N-(2,6-dimethylphenyl)glycine
N-(carboxymethyl)-N-(4-formylphenyl)glycine

N-(carboxymethyl)-N-ethylanthranilic acid
N-(carboxymethyl)-N-pyropylanthranilic acid
N-(carboxymethyl)-N-benzylglycine
5-bromo-N-(carboxymethyl)anthranilic acid
N-(2-carboxyphenyl)glycine
o-dianisidine-N,N,N',N'-tetraacetic acid
4-carboxyphenoxyacetic acid
catechol-O,O'-diacetic acid
4-methylcatechol-O,O'-diacetic acid
resorcinol-O,O'-diacetic acid
hydroquinone-O,O'-diacetic acid
α-carboxy-o-anisic acid
2,2'-(dibenzofuran-2,8-diyldioxy)diacetic acid
2-(carboxymethylthio)benzoic acid
5-amino-2-(carboxymethylthio)benzoic acid
3-[(carboxymethyl)thio]-2-naphtalenecarboxylic acid
ethylene diaminotetraacetic acid
nitrilotriacetic acid

The most preferred polycarboxylic acid is anilino diacetic acid. In IR-sensitive systems, these polycarboxylic acids can additionally increase storage stability.

In the present invention, one coinitiator or a mixture of coinitiators can be used. A coinitiator mixture comprising a thiol compound and another of the mentioned coinitiators is especially preferred. In the case of the sensitizer as well, one sensitizer or a mixture of two or more can be used.

Systems which are both UV and IR-sensitive due to an appropriate combination of sensitizers are also possible; however, they are not preferred.

The amount of coinitiator(s) is not particularly restricted; however, it is preferably in the range of 0.2 to 25 wt.-%, based on the dry layer weight, especially preferred 0.5 to 15 wt.-%. The amount of sensitizer(s) is not particularly restricted; however, it is preferably also in the range of 0.2 to 25 wt.-%. The optimum amount of sensitizer depends on various factors such as its extinction coefficient at the emitted wavelength, or the emitted wavelengths of the radiation source, the thickness of the radiation-sensitive layer of the radiation-sensitive element and its molar mass. Typically, they are used in amounts of 0.5 to 15 wt.-%, based on the dry layer weight of the radiation-sensitive coating. These values apply to initiator systems of both groups, i.e. those for the range of 300 to <480 nm and those for the range of >750 to 1,100 nm. Each initiator system has an optimum value for the molar ratio ($n_M$= Mol Sens : Mol Coinit) of sensitizer (Sens) and coinitiator (Coinit). It is usually between 0.1 and 2.

The radiation-sensitive composition furthermore comprises at least one binder with acid groups. The binder is preferably selected from polyvinyl acetals, acrylic polymers, polyurethanes and copolymers thereof. It is preferred that the binder contains carboxyl groups as acid groups. Most preferred are acrylic polymers. The binders preferably have acid values in the range of 20 to 180 mg KOH/g polymer. Optionally, the binder can comprise groups capable of undergoing a cycloaddition reaction (e.g. a 2+2 photocycloaddition) and/or free-radical polymerization. The amount of binder is not particularly restricted and is preferably in the range of 0 to 90 wt.-%, especially preferred 5 to 60 wt.-%, based on the dry layer weight.

The UV or IR-sensitive composition can optionally also comprise small amounts of a thermopolymerization inhibitor. Suitable examples of inhibitors of an undesired thermopolymerization include hydroquinone, p-methoxyphenol, di-t-butyl-p-cresol, pyrrogallol, t-butylcatechol, benzoquinone, 4,4'-thio-bis-(3-methyl-6-t-butylphenol), 2,2'-methylene-bis-(4-methyl-6-t-butylphenol) and N-nitrosophenylhydroxylamine salts. The amount of thermopolymerization inhibitor is preferably 0 to 5 wt.-%, based on the dry layer weight, especially preferred 0.01 to 2 wt.-%. Such inhibitors are often introduced into the radiation-sensitive composition via commercial monomers or oligomers and are therefore not expressly mentioned.

Furthermore, the UV or IR-sensitive composition of the present invention can comprise dyes or pigments for coloring the layer (contrast dyes and pigments). Examples of colorants include e.g. phthalocyanine pigments, azo pigments, carbon black and titanium dioxide, triarylmethane dyes, such as ethyl violet and crystal violet, azo dyes, anthraquinone dyes and cyanine dyes. The amount of colorant is preferably 0 to 20 wt.-%, based on the dry layer weight, especially preferred 0.5 to 10 wt.-%.

For improving the physical properties of the hardened layer, the UV or IR-sensitive composition can additionally comprise further additives such as plasticizers or inorganic fillers. Suitable plasticizers include e.g. dibutyl phthalate, dioctyl phthalate, didodecyl phthalate, dioctyl adipate, dibutyl sebacate, triacetyl glycerin und tricresyl phosphate. The amount of plasticizer is not particularly restricted, however, it is preferably 0 to 10 wt.-%, based on the dry layer weight,

especially preferred 0.25 to 5 wt.-%. Suitable inorganic fillers include for example $Al_2O_3$ and $SiO_2$; they are preferably present in an amount of 0 to 20 wt.-%, based on the dry layer weight, especially preferred 0.1 to 5 wt.-%.

The UV or IR-sensitive composition can also comprise known chain transfer agents. They are preferably used in an amount of 0 to 15 wt.-%, based on the dry layer weight, especially preferred 0.5 to 5 wt.-%.

Furthermore, the UV or IR-sensitive composition can comprise leuco dyes such as e.g. leuco crystal violet and leucomalachite green. They are preferably present in an amount of 0 to 10 wt.-%, based on the dry layer weight, especially preferred 0.5 to 5 wt.-%.

Additionally, the UV or IR-sensitive composition can comprise surfactants (flow improvers). Suitable surfactants include siloxane-containing polymers, fluorine-containing polymers and polymers with ethylene oxide and/or propylene oxide groups. They are preferably present in an amount of 0 to 10 wt.-%, based on the dry layer weight, especially preferred 0.2 to 5 wt.-%.

Exposure indicators, such as e.g. 4-phenylazodiphenylamine, can also be present as optional components of the UV or IR-sensitive composition; they are preferably present in an amount of 0 to 5 wt.-%, especially preferred 0 to 2 wt.-%, based on the dry layer weight.

The UV or IR-sensitive composition used in the present invention is substantially not sensitive to radiation from the range of 480 to 750 nm. This means that in the spectral range of 480 to about 600 nm no image can be generated on the printing plate precursor with an energy of 0.2 $mJ/cm^2$, i.e. no polymerization of the exposed areas is initiated to a degree sufficient for allowing a distinction between exposed and unexposed areas during developing. In the spectral range of about 600 to 750 nm, no image can be obtained with an energy of 200 $mJ/cm^2$.

In the production of a lithographic printing plate of the present invention, a lithographic printing plate precursor is first produced which is then image-wise exposed and subsequently developed. The precursor is produced by applying a radiation-sensitive coating onto a lithographic substrate. A dimensionally stable plate or foil-shaped material, including a material in the form of a press element which is known as a suitable lithographic substrate, is used as a lithographic substrate. Examples of such substrates include paper, paper coated with plastic materials (such as polyethylene, polypropylene, polystyrene), a metal plate or foil, such as e.g. aluminum (including aluminum alloys), zinc and copper plates, plastic films made e.g. from cellulose diacetate, cellulose triacetate, cellulose propionate, cellulose acetate, cellulose acetatebutyrate, cellulose nitrate, polyethylene terephthalate, polyethylene, polystyrene, polypropylene, polycarbonate and polyvinyl acetate, and a laminated material made from paper or a plastic film and one of the above-mentioned metals, or a paper/plastic film that has been metallized by vapor deposition. Among these substrates, an aluminum plate or foil is especially preferred since it shows a remarkable degree of dimensional stability, is inexpensive and furthermore exhibits excellent adhesion to the coating. Furthermore, a composite film can be used wherein an aluminum foil has been laminated onto a polyethylene terephthalate film.

The lithographic substrate either has a naturally hydrophilic surface or is subjected to a treatment generating such a surface.

A metal substrate, in particular an aluminum substrate, is preferably subjected to at least one treatment selected from graining (e.g. by brushing in a dry state or brushing with abrasive suspensions, or electrochemical graining, e.g. by means of a hydrochloric acid electrolyte), anodizing (e.g. in sulfuric acid or phosphoric acid) and hydrophilizing.

In order to improve the hydrophilic properties of the surface of the metal substrate that has been grained and optionally anodized in sulfuric acid or phosphoric acid, the metal substrate can be subjected to an aftertreatment with an aqueous solution of sodium silicate, calcium zirconium fluoride, polyvinylphosphonic acid or phosphoric acid.

The details of the above-mentioned substrate pre-treatment are known to the person skilled in the art.

For producing a lithographic printing plate precursor, the radiation-sensitive composition is applied to the hydrophilic surface of the substrate by means of common coating processes (e.g. spin coating, spray coating, dip coating, coating by means of a doctor blade). It is also possible to apply the radiation-sensitive composition on both sides of the substrate; however, for the process of the present invention, it is preferred that the radiation-sensitive coating be only applied to one side of the substrate.

Usually, the radiation-sensitive composition is applied from an organic solvent or solvent mixture.

Suitable solvents include low alcohols (e.g. methanol, ethanol, propanol and butanol), glycolether derivatives (e.g. ethylene glycol monomethylether, ethylene glycol dimethylether, propylene glycol monomethylether, ethylene glycol monomethylether acetate, ethylene glycol monoethylether acetate, propylene glycol monomethylether acetate, propylene glycol monomethylether acetate, ethylene glycol monoisopropylether acetate, ethylene glycol monobutylether acetate, diethylene glycol monomethylether, diethylene glycol monoethylether), ketones (e.g. diacetone alcohol, acetyl acetone, acetone, methyl ethyl ketone, cyclohexanone, methyl isobutyl ketone), esters (e.g. methyl lactate, ethyl lactate, ethyl acetate, 3-methoxypropyl acetate and butyl acetate), aromatics (e.g. toluene and xylene), cyclohexane, 3-methoxy-2-propanol, 1-methoxy-2-propanol, methoxymethoxyethanol, γ-butyrolactone and dipolar aprotic solvents (e.g. THF, dimethylsulfoxide, dimethylformamide and N-methylpropyrrolidone) and mixtures thereof. The solids content of the radiation-sensitive mixture to be applied depends on the coating method that is used and is preferably 1 to 50 wt.-%.

The dry layer weight of the radiation-sensitive layer is preferably 0.5 to 4 $g/m^2$, more preferably 0.8 to 3 $g/m^2$.

The additional application of a water-soluble oxygen-impermeable overcoat onto the radiation-sensitive layer can be advantageous. The polymers suitable for such an overcoat include, inter alia, polyvinyl alcohol, polyvinyl alcohol/polyvinyl acetate copolymers, polyvinyl pyrrolidone, polyvinyl pyrrolidone/polyvinyl acetate copolymers, polyvinyl methylethers, ring-opened copolymers of maleic acid anhydride and a comonomer such as methylvinylether, polyacrylic acid, cellulose ether, gelatin, etc.; polyvinyl alcohol is preferred. Preferably, the composition for the oxygen-impermeable overcoat is applied in the form of a solution in water or in a solvent miscible with water; in any case, the solvent is selected such that the radiation-sensitive coating already present on the substrate essentially does not dissolve upon application of the overcoat composition. The layer weight of the overcoat can e.g. be 0.1 to 6 $g/m^2$, preferably 0.5 to 4 $g/m^2$. However, the printing plate precursors according to the present invention show excellent properties even without an overcoat. The overcoat can also comprise matting agents (i.e. organic or inorganic particles with a particle size of 2 to 20 $\mu$m) which facilitate the planar positioning of the film during contact exposure. In order to improve adhesion of the overcoat to the radiation-sensitive layer, the overcoat can comprise adhesion promoters such as e.g. poly(vinylpyrrolidone)poly(ethyleneimine) and poly(vinylimidazole).

Suitable overcoats are described for example in WO 99/06890.

If the sensitizer distinctly absorbs radiation of a wavelength in the range of 300 to <480 nm, and preferably exhibits an absorption maximum in its absorption spectrum in that range, image-wise irradiation can be carried out by means of common lamps for these wavelengths such as carbon arc lamps, mercury lamps, xenon lamps and metal halide lamps or lasers or laser diodes known to the person skilled in the art. Laser radiation can be digitally controlled via a computer, i.e. it can be turned on or off so that an image-wise exposure of the elements can be effected via stored digitized information in the computer. Lithographic printing plate precursors of that type are therefore referred to as computer-to-plate (CTP) printing plates. UV laser diodes emitting UV radiation in the range of about 405 nm (e.g. 405 $\pm$ 10 nm) are of particular interest as a UV radiation source.

If the initiator/initiator system absorbs IR radiation, i.e. distinctly absorbs radiation of a wavelength in the range of >750 to 1,100 nm, and preferably exhibits an absorption maximum in its absorption spectrum in that range, image-wise irradiation can be carried out by means of IR radiation sources. For instance, IR-sensitive elements of the present invention can be imaged by means of semi-conductor lasers emitting in the range of about 800 to 1,100 nm. Semiconductor laser diodes which emit in the wavelength range of 810 to 830 nm and solid lasers such as Nd-YAG lasers which emit at 1,064 nm are especially preferred.

After image-wise exposure, but prior to developing, a heat treatment can be carried out at 50 to 180°C, preferably 90 to 150°C, if desired.

The developer used in the present invention has a pH value in the range of 9 to 14 and comprises as essential components

(i) water,
(ii) one or more alkali hydroxides MOH (M = alkali metal) in an amount sufficient for adjusting a pH value of 9 to 14, and
(iii) 1 to 30 wt.-% of at least one compound of formula (I)

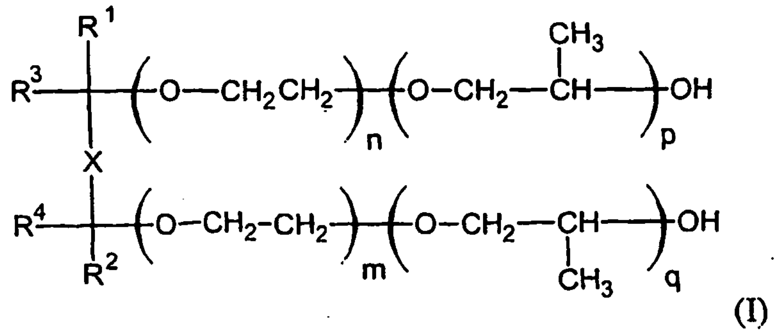

(I)

wherein $R^1$, $R^2$, $R^3$ and $R^4$ are each independently selected from $C_1$-$C_{12}$ straight-chain, branched and cyclic alkyl groups and aryl groups,
X is selected from -CH=CH-, -C≡C-,

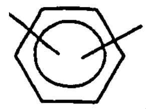, 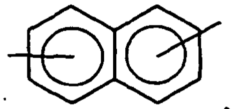,

and

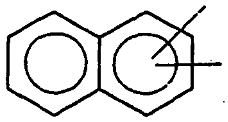,

n + m results in a value from 2 to 30 and
p + q results in a value from 0 to 30.

The developer is an aqueous alkaline developer which, however, can optionally comprise up to 10 wt.-% organic solvents such as e.g. glycols, glycol ethers, glycol ether esters, higher-boiling alcohols such as benzyl alcohol or phenoxy ethanol and similar solvents.

The alkaline pH value of the developer (9 to 14, preferably 10 to 12.5) is achieved by the use of one or more alkali hydroxides MOH, preferably KOH. In other words: The alkali hydroxides are the only alkaline components of the developer; thus, the developer does not contains silicates, metasilicates, ammonium hydroxide, tertiary amines etc. whose use in alkaline developers is known (see for example EP 0 732 628 A1 and EP 1 115 035 A1).

The essential component (iii) of the developer is present in the developer in an amount of 1 to 30 wt.-%, preferably 1.5 to 20 wt.-%, particularly preferred 2 to 10 wt.-%.

The groups $R^1$, $R^2$, $R^3$ and $R^4$ are preferably selected from straight-chain alkyl groups; it is especially preferred that $R^1$=$R^2$=$R^3$=$R^4$= methyl.

X is preferably selected from -CH=CH- and -C≡C-; it is especially preferred that X represent -C≡C-.

When $p + q \neq 0$, the ethylene oxide and propylene oxide units shown in formula (I) can either be present as blocks or randomly distributed; both forms should be considered as being encompassed by the present invention.

It is especially preferred that $n + m < 15$ and $p + q < 10$.

Especially preferred components (iii) of the developer are those of formula (Ia)

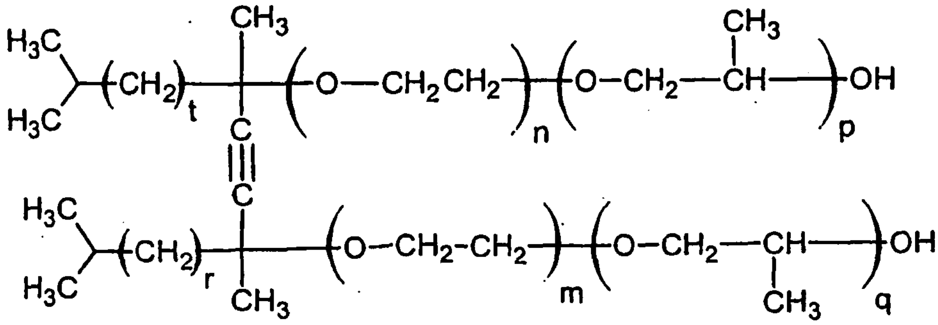

**(Ia)**

wherein m, n, p and q are as defined for formula (I) and
t and r are independently integers from 1 to 10, preferably 1 or 2; it is especially preferred that t=r.

Compounds of formulas (I) and (Ia) can be prepared according to known processes by ethoxylation/propoxylation of the corresponding dialcohol with ethylene oxide/propylene oxide; in this connection, reference is made for example to US 6,313,182 B2. Some of those compounds are also commercially available. Specific examples of suitable compounds are ethoxylated or ethoxylated/propoxylated products of 2,4,7,9-tetramethyl-dec-5-ine-4,7-diol (formula (Ia) wherein t = r =1) and 2,5,8,11-tetramethyl-dodec-6-ine-5,8-diol (formula (Ia) wherein t = r = 2).

In addition to the essential components mentioned above, the developer can furthermore comprise one or more optional components selected from hydrotropes, free radical inhibitors and filter dyes. Polyoxyalkylene arylether tensides

are not suitable developer components in the present invention.

Suitable hydrotropes are for examples salts of phosphoric acid esters, ethoxylated quaternary fatty amines, alkyl glycosides, alkylimino dipropionate, complex coconut acid iminoglycinates, complex coconut acid iminodipropionates, alkanolpolyglycol phosphoric acid alkylester and alkali salts of arylsulfonic acids. They are preferably present in the developer in an amount of 0 to 20 wt.-%, especially preferred up to 15 wt.-% and particularly preferred up to 10 wt.-%; if they are present, they are preferably used in amounts of at least 1 wt.-%, especially preferred at least 2 wt.-%.

The addition of one or more free radical inhibitors to the developer of the present invention can possibly further suppress the formation of sludge in the processor since they prevent the polymerization of the monomers which are released into the processor during developing when the non-irradiated areas of the printing plate precursor are removed. Basically, all substances can be used as free radical inhibitors which (1) react with free radicals to form products that do not initiate the polymerization of monomers, (2) are soluble in the developer, (3) are stable in the developer and (4) affect neither the developer nor the printing plate precursors to be developed. Without being restricted to these compounds, such inhibitors include compounds with quinone or hydroquinone units, in particular benzoquinone and substituted benzoquinones, hydroquinone and substituted hydroquinones, such as 2,6-dimethylhydroquinone; ethers of hydroquinones, in particular of hydroquinones and substituted hydroquinones such as hydroquinone monomethylether (4-methoxphenol), *t*-butylhydroquinone (4-*t*-Butylphenol, TBHQ), and *t*-butylhydroxyansol (BHA); resorcinol; pyrrogallol; phosphite esters; and sterically hindered phenols and bisphenols, such as 2,6-di-*t*-butyl-4-methylphenol (BHT), 2,6-di-*t*-butyl-4-methoxyphenol and 2,4,6-tri-*t*-butylphenol; stable free radicals such as di-*t*-butylnitroxide and 2,2,6,6-tetramethyl-4-pyridonenitroxide; nitro-substituted aromatics, aminophenol; phenothiazine and secondary diarylamines, such as substituted diphenylamines, N,N'-diphenyl-*p*-phenylenediamine and N-phenylnaphthylamine. Quinones, hydroquinones, ethers of hydroquinones and sterically hindered phenols are preferred free radical inhibitors. More preferred are ethers of hydroquinones, in particular ethers of hydroquinone and sterically hindered phenols. Hydroquinone monomethylether (4-methoxphenol), 2,6-di-*t*-butyl-4-methylphenol and 2,4,6-tri-*t*-butylphenol are preferred compounds.

The amount of free radical inhibitors is not particularly restricted, however, they are preferably present in an amount of 0 to 3.0 wt.-%, more preferred 2 wt.-% and particularly preferred 1.5 wt.-%; if they are present, they are preferably used in amounts of at least 0.1 wt.-%, especially preferred at least 0.5 wt.-%.

As described in WO 02/31599 A2, it was found that the use of filter dyes in the developer also has a positive effect on the prevention of sludge in the processor if the plate is UV-sensitive. The filter dye should be selected such that it absorbs in the same wavelength range as the initiator/initiator system used in the coating of the UV-sensitive plate precursor. The filter dye should be soluble and stable in the developer and not enter into chemical reaction or interact with the other components of the developer; particularly, it should not form free radicals upon irradiation or activate the initiator system of the coating of the non-irradiated areas removed by the developer. Dyes comprising one or more sulfonic acid substituents usually show sufficient solubility. Preferred dyes are yellowish, yellow, orange and red dyes comprising sulfonic acid substituents; sulfonated azo dyes are especially preferred. Examples include the following: Metanil yellow (C.I. 13065), methyl orange (C.I. 13025), tropaeolin O (C.I. 14270), tropaeolin OO (C.I. 13080), tartrazine (C.I. 19140); oxonol yellow K (Riedel-de-Haen); yellow dyes such as C.I. 13900, C.I. 14170, C.I. 18835, C.I. 18965, C.I. 18890, C.I. 18900, C.I. 18950, C.I. 22910 and C.I. 25135; and red dyes such as C.I. 14710, C.I. 14900, C.I. 17045, C.I. 18050, C.I. 18070 and C.I. 22890.

The developed elements can be treated with a preservative ("gumming") using a common method. The gumming agents are aqueous solutions of hydrophilic polymers, wetting agents and other additives and generally known in the technical field.

It can furthermore be advantageous to increase the mechanical strength of the portions of the coating remaining after developing by subjecting them to a heat treatment (what is referred as "baking") and/or a combination of baking and overall exposure (e.g. to UV light). For this purpose, prior to the treatment, the developed element is treated with a solution that protects the non-image areas such that the heat treatment does not cause these areas to accept ink. A solution suitable for this purpose is e.g. described in US-A-4,355,096. Baking takes place at a temperature in the range of 150 to 250°C. When both baking and overall exposure are carried out, the two treatment steps can be performed simultaneously or one after the other.

The invention will be explained in more detail in the following examples; however, they shall not restrict the invention in any way.

## Examples

### Examples 1 to 6 and Comparative Examples 1 to 12

An electrochemically grained (with HCl) and anodized aluminum foil (average roughness 0.55 μm; aluminum oxide layer 3.2 g/$m^2$) was subjected to a treatment with an aqueous solution of polyvinylphosphonic acid (PVPA) and, after drying, was coated with a filtered solution as described in Tables 1 to 5 and dried.

**Table 1:**

| | |
|---|---|
| 1.2 g | of a terpolymer prepared by polymerization of 470 parts by weight styrene, 336 parts by weight methyl methacrylate and 193 parts by weight methacrylic acid, 30% solution in propylene glycol monomethylether |
| 0.1 g | Kayamer PM-2 (1 mole phosphoric acid esterified with 1.5 moles hydroxyethyl methacrylate from Coa Corp. Ltd., Japan) |
| 0.2 g | mercapto-3-triazole |
| 3.92 g | of an 80% methyl ethyl ketone solution of a urethane acrylate prepared by reacting Desmodur N 100® (available from Bayer) with hydroxyethyl acrylate and pentaerythritol triacrylate; amount of double bonds: 0.5 double bonds per 100 g when all isocyanate groups have completely reacted with the acrylates containing hydroxy groups |
| 0.45 g | ditrimethylolpropane tetraacrylate |
| 1.25 g | of a dispersion in propylene glycol monomethylether comprising 7.25 wt.-% copper phthalocyanine and 7.25 wt.-% of a polyvinylacetal binder comprising 39.9 mole-% vinyl alcohol groups, 1.2 mole-% vinyl acetate groups, 15.4 mole-% acetal groups derived from acetaldehyde, 36.1 mole-% acetal groups derived from butyric aldehyde and 7.4 mole-% acetal groups derived from 3-formylbenzoic acid |
| 0.7 g | 2-phenyl-4-(2-chlorophenyl)-5-(4-N,N-diethylaminophenyl)oxazole-1,3 |
| 0.19 g | 2,2-bis-(2-chlorophenyl)-4,5,4',5'-tetraphenyl-2'H-[1,2']biimidazolyl |
| 20 ml | propylene glycol monomethylether |
| 16 ml | methanol |
| 25 ml | methyl ethyl ketone |

**Table 2:**

| | |
|---|---|
| 0.22 g | of a copolymer comprised of 80 mole-% allylmethacrylate and 20 mole-% methacrylic acid with an acid value of 95 mg KOH/1 g |
| 0.1 g | Kayamer PM-2 (1 mole phosphoric acid esterified with 1.5 moles hydroxyethyl methacrylate from Coa Corp. Ltd., Japan) |
| 0.31 g | mercapto-1,2,4-triazole |
| 2.3 g | of a dispersion in propylene glycol monomethylether comprising 21.1 wt.-% copper phthalocyanine and 2.1 wt.-% of a polyvinylacetal binder comprising 39.9 mole-% vinyl alcohol groups, 1.2 mole-% vinyl acetate groups, 15.4 mole-% acetal groups derived from acetaldehyde, 36.1 mole-% acetal groups derived from butyric aldehyde and 7.4 mole-% acetal groups derived from 3-formylbenzoic acid |
| 15.25 g | a 29.8% monomer solution prepared by reacting 16.82 g hexamethylene diisocyanate, 13.01 g hydroxyethyl methacrylate, 6.46 g 2-(2-hydroxyethyl)-piperidine in 85 g methyl ethyl ketone using a 0.1 g dibutyltin dilaurate catalyst |
| 0.7 g | 2-phenyl-4-(2-chlorophenyl)-5-(4-N,N-diethylaminophenyl)oxazole-1,3 |
| 0.17 g | 2,2-bis-(2-chlorophenyl)-4,5,4',5'-tetraphenyl-2'H-[1,2']biimidazolyl |
| 22.8 ml | propylene glycol monomethylether |
| 16.3 ml | methanol |
| 26 ml | methyl ethyl ketone |

**Table 3:**

| | |
|---|---|
| 3.0 g | Ioncryl 683® (acrylic acid copolymer of the company SC Johnson & Son Inc. with an acid value of 180 mg KOH/g) |

(continued)

| | |
|---|---|
| 4.4 g | AC 50® (methacrylic acid copolymer of the company PCAS with an acid value of 48 mg KOH/g, 70 wt.-% solution in methyl glycol) |
| 8.4 g | of an 80% solution of a urethane acrylate in methyl ethyl ketone, prepared by reacting Desmodur N100® (available from Bayer) with hydroxyethyl acrylate and pentaerythritol triacrylate having a double-bond content of 0.50 double bonds/100 g when all isocyanate groups have completely reacted with the acrylates containing hydroxy groups |
| 1.4 g | dipentaerythritol pentaacrylate |
| 0.75 g | 2-(4-methoxyphenyl)-4,6-bis-(trichloromethyl)-s-triazine |
| 0.3 g | Renol Blue B2G HW® (copper phthalocyanine pigment formulation with polyvinylbutyral from Clariant) |
| 0.4 g | anilino diacetic acid |
| 0.25 g | 2-[2-[2-thiophenyl-3-[2-(1,3-diliydro-1,3,3-trimethyl-2H-indole-2-ylidene)-ethylidene]-1-cyclohexene-1-yl]-ethenyl]-1,3,3-trimethyl-3H-indoliumchloride |
| 30 ml | methyl glycol |
| 45 ml | methanol |
| 25 ml | methyl ethyl ketone |

**Table 4:**

| | |
|---|---|
| 6.3 g | Ioncryl 683® |
| 9.0 g | AC50® (70 wt.-% solution in ethylene glycol monomethylether) |
| 1.4 g | dipentaerythritol pentaacrylate |
| 16.8 g | of an 80% methyl ethyl ketone solution of a urethane acrylate prepared by reacting Desmodur N 100® (available from Bayer) with hydroxyethyl acrylate and pentaerythritol triacrylate; amount of double bonds: 0.5 double bonds per 100 g when all isocyanate groups have completely reacted with the acrylates containing hydroxy groups |
| 1.8 g | 2-(4-ethenyl)benzyl-5-mercapto-1,3,4-thiadiazole |
| 0.45 g | 2-[2-[2-thiophenyl-3-[2-(1,3-dihydro-1,3,3-trimethyl-2H-indole-2-ylidene)-ethylidene]-1-cyclohexene-1-yl]-ethenyl]-1,3,3-trimethyl-3H-indoliumchloride |
| 2.5 g | 2-(4-methoxyphenyl)-4,6-bis-(trichloromethyl)-1,3,5-triazine |
| 0.4 g | Basonyl Violet 610 (Basic Violet 3, C.I. 42555; available from Bayer) |
| 30 ml | methyl glycol |
| 45 ml | methanol |
| 25 ml | methyl ethyl ketone |

**Table 5:**

| | |
|---|---|
| 1.2 g | of a terpolymer prepared by polymerization of 470 parts by weight styrene, 336 parts by weight methyl methacrylate and 193 parts by weight methacrylic acid, 30% solution in propylene glycol monomethylether |
| 0.1 g | Kayamer PM-2 |
| 0.2 g | mercapto-3-triazole |
| 3.92 g | of an 80% methyl ethyl ketone solution of a urethane acrylate prepared by reacting Desmodur N 100® (available from Bayer) with hydroxyethyl acrylate and pentaerythritol triacrylate; amount of double bonds: 0.5 double bonds per 100 g when all isocyanate groups have completely reacted with the acrylates containing hydroxy groups |

(continued)

| | |
|---|---|
| 0.45 g | ditrimethylolpropane tetraacrylate |
| 1.25 g | of a dispersion in propylene glycol monomethylether comprising 7.25 wt.-% copper phthalocyanine and 7.25 wt.-% of a polyvinylacetal binder comprising 39.9 mole-% vinyl alcohol groups, 1.2 mole-% vinyl acetate groups, 15.4 mole-% acetal groups derived from acetaldehyde, 36.1 mole-% acetal groups derived from butyric aldehyde and 7.4 mole-% acetal groups derived from 3-formylbenzoic acid |
| 0.7 g | 2-phenyl-4-(2-chlorophenyl)-5-(4-N,N-diethylamino-phenyl)-oxazole-1,3 |
| 0.19 g | 2,2-bis-(2-chlorophenyl)-4,5,4',5'-tetraphenyl-2'H-[1,2']biimidazolyl |
| 0.2 g | bis(cyclopentadienyl)-bis-[2,6-difluoro-3-(pyrr-1-yl)-phenyl]-titanium |
| 20 ml | propylene glycol monomethylether |
| 16 ml | methanol |
| 25 ml | methyl ethyl ketone |

The respective solutions were filtered, applied to the lithographic substrate and the coating was dried for 4 minutes at 90°C. The dry layer weight of the photopolymer layer was about 1.5 g/m$^2$ in each case.

The resulting plates were provided with an overcoat layer by coating them with an aqueous solution of poly (vinylalcohol) (Celvol® 203 from Celanese, degree of hydrolysis 88%); after drying at 90°C for 4 minutes, the overcoat layer had a dry layer weight of about 3 g/m$^3$.

The printing plate precursors of Examples 1 to 4 and Comparative Examples 1 to 8 were exposed with an Andromeda® image-setter from Lithotec (30 mW violet laser diode with 405 nm). Immediately after exposure, the plates were heated for 2 minutes at 90°C in an oven.

The printing plate precursors of Examples 5 and 6 were exposed with a Creo Trendsetter® 3244 image-setter (830 nm laser diode; laser energy 50-75 mJ/cm$^2$ and 100 mJ/cm$^2$ respectively); a UGRA/FOGRA Postscript Strip Version 2.0 EPO was used which contains different elements for evaluating the print quality. Immediately after exposure, the plates were heated for 2 minutes in a 90°C oven.

Then the overcoat layers were washed with water and the plates were treated for 30 seconds with the developer listed in Table 7 for each example. The individual developer compositions can be inferred from Table 6.

**Table 6:**

| | Components | Amounts | pH |
|---|---|---|---|
| Developer D1 | Water<br>KOH solution (45 wt.-%)<br>Surfynol 465 1) | 94.84 wt.-%<br>0.169 wt.-%<br>4.992 wt.-% | 12±0.1 |
| Developer D2 | Water<br>KOH solution (45 wt.-%)<br>Surfynol 2502 2) | 94.84 wt.-%<br>0.169 wt.-%<br>4.992 wt.-% | 12±0.1 |
| Developer D3 | Water<br>KOH solution (45 wt.-%)<br>Surfynol 2502 2) Triton H66 3) | 89.958 wt.-%<br>0.531 wt.-%<br>4.733 wt.-%<br>4.779 wt.-% | 12±0.1 |
| Comp. Developer CD1 | Water<br>KOH solution (45 wt.-%) | 99.831 wt.-%<br>0.169 wt.-% | 12±0.1 |
| Comp. Developer CD2 | Water<br>Surfynol 465 1) | 95.009 wt.-%<br>4.992 wt.-% | 8 |
| Comp. Developer CD3 | Water<br>$N(CH_3)_4$ OH solution (25 wt.-%)<br>Surfynol 465 1) | 94.567 wt.-%<br>0.441 wt.-%<br>4.992 wt.-% | 12±0.1 |
| Comp. Developer CD4 | Water<br>Triethanolamine | 94.825 wt.-%<br>0.183 wt.-% | 12±0.1 |

(continued)

| | Components | Amounts | pH |
|---|---|---|---|
| | Surfynol 465 1) | 4.992 wt.-% | |
| Comp. Developer CD5 | Water<br>KOH solution (45 wt.-%)<br>Newcol B 13 4) | 94.84 wt.-%<br>0.169 wt.-%<br>4.992 wt.-% | 12±0.1 |
| Comp. Developer CD6 (EP 732,628) | Water<br>Sodium metasilicate<br>Surfynol 465 1)<br>Triton H66 4)<br>Hexamethaphosphate | 87.25 wt.-%<br>8 wt.-%<br>0.25 wt.-%<br>2.5 wt.-%<br>2 wt.-% | 12±0.1 |
| Comp. Developer CD7 | Water<br>KOH solution (45 wt.-%)<br>PC1199 5) | 94.84 wt.-%<br>0.169 wt.-%<br>4.992 wt.-% | 12±0.1 |
| Comp. Developer CD8 (IP 2003-162072, Ex. 1) | Water<br>KOH<br>$K_2CO_3$<br>Rewopal® MGP40 6)<br>Triton B 7)<br>Surfynol 465 1) | 94.15 wt.-%<br>0.15 wt.-%<br>0.1 wt.-%<br>5 wt.-%<br>0.1 wt.-%<br>0.5 wt.-% | 12±0.1 |
| Comp. Developer CD9 | Water<br>KOH<br>$K_2CO_3$<br>Trilon B 7)<br>Surfynol 465 1) | 99.15 wt.-%<br>0.15 wt.-%<br>0.1 wt.-%<br>0.1 wt.-%<br>0.5 wt.-% | 12±0,1 |

1) ethoxylated products of 2,4,7,9-tetramethyl-dec-5-ine-4,7-diol (formula (2), r = t = 1) with 10 mole-% ethylene oxide content; from Airproducts
2) ethoxylated/propoxylated products of 2,4,7,9-tetramethyl-5-dec-5-ine-4,7-diol (formula (2), r = t = 1); from Airproducts
3) hydrotope: anionic polyether phosphate; from Dow Chemicals
4) ethoxylated (n = 13) beta-naphthol; from Nippon Nyukazai Co., Ltd.
5) ethoxylated/propoxylated $C_{10}$-$C_{12}$ monoalcohol; from Polygon
6) polyoxyethylene phenylether from Rewo Chemical Group
7) complexing agent

Then the developer solution was again rubbed over the surface for another 30 seconds using a tampon and then the entire plate was rinsed with water. After this treatment, the exposed portions remained on the plate. For the assessment of its photosensitivity, the plate was inked up in a wet state with printing ink.

For the evaluation of developability, unexposed 5 cm x 30 cm plate strips were heated in an oven for 2 minutes at 90°C and the overcoat layer was subsequently washed away with water and dried. The plate strips were then partially immersed in the corresponding developer, whereby every 5 seconds an additional 4 cm of the strip were immersed. After a total dwell time of 50 seconds, the strips were removed from the developer and the point in time was noted where the photopolymer layer had been completely removed for the first time.

For the evaluation of the formation of sludge during developing, the following method was used: A Raptor Polymer HW type processor from Glunz & Jensen was used to heat the plates to 110°C (measured at the uncoated back side of the plate), wash away the overcoat layer with tap water, develop the plates with the help of two brushes at 23°C for 20 seconds using the corresponding developers (see Tables 6 and 7) and finally treat the plates with the gumming solution 850 S from Kodak Polychrome Graphics.

After the individual developer baths had been loaded with 15 $m^2$ of the corresponding unexposed plates per liter of developer, the process was evaluated for (1) residual sludge and (2) cleanliness of the processor by simple rinsing with water; the evaluation was carried out using the following scale:

(A) no or very little formation of sludge
(B) formation of sludge which could easily be removed by rinsing with tap water
(C) formation of sludge which could only be removed after prolonged rinsing with tap water
(D) formation of sludge which could not be removed by rinsing with tap water but required the use of dipropylene glycol monomethylether.

For the preparation of a lithographic printing plate, an imaging layer was applied to an aluminum foil, as explained above, exposed, heated, developed, and after rinsing with water, the developed plate was rubbed and gummed with an aqueous solution of 0.5% phosphoric acid and 6% gum arabic. The thus prepared plate was loaded in a sheet-fed offset printing machine and an abrasive printing ink (Offset S 7184 available from Sun Chemical, containing 10% potassium carbonate) was used. The non-image areas were examined for toning.

The relative dot sharpening was determined as follows:

The term "dot sharpening" describes the change in the tonal values of a linearized plate during printing. Linearization means that deviations from a predetermined set tonal value (STV) is compensated for by means of RIP software (RIP = raster image processor). The accessible measured values are the tonal values before printing (TVB) and the tonal values after printing (TVA) on the printing form. For determining the loss in tonal value, the linearized tonal values before printing (TVB) are measured. The linearized and developed printing plate is used in a printing machine for 10,000 prints, cleaned and then again subjected to a tonal value examination, which shows the tonal values after printing (TVA). Then the dot sharpening is calculated using equation 1 integrating all predetermined set tonal values (STV).

$$\textit{dot sharpening} = \int_0^{100} [TVB - STV]dSTV - \int_0^{100} [TVA - STV]dSTV \qquad (1)$$

Ideally, the dot sharpening should converge toward zero. In other words: The lower the dot sharpening, the better the plate.

The plate of Comparative Example 7, i.e. a plate with a considerable dot sharpening during printing at different tonal values, is used as a reference. The relative dot sharpening is calculated using equation (2) below:

$$\text{relative dot sharpening} = \frac{\text{dot sharpening (sample)}}{\text{dot sharpening (reference)}} \bullet 100\,\% \qquad (2)$$

The yellow light stability was examined as follows:

The plates were irradiated with a yellow light source (G10 from Encapsulite) with an intensity of 200 lux, measured on the plate surface. After the irradiation the plates were heated and developed with the various developers as described above. The developed plates were examined for coating residues in the non-image areas.

Furthermore, the stability of the regenerate pumps whose valves were sealed with EPDM rubber was examined. For this purpose, developer according to the present invention was pumped for 15 minutes and then the pumps were stopped for 15 minutes; this cycle was repeated until the pumps no longer functioned correctly. For controlling the correct function of the pumps, the developer stream was measured every 24 hours and it was examined whether the pumps draw in developer in an empty state.

The results for the various plates developed with the various developers are summarized in Table 7. The examples show that the process of the present invention results in a high developing speed and a low formation of sludge in the processor, and the developed plates surprisingly exhibit no toning problems on the press. Furthermore, the developers of the present invention do not attack the EPDM valve seals. Surprisingly, it was found that the developer influences the dot sharpening during printing. The developers used in the present invention all lead to an improvement in the dot sharpening compared to Comparative Developer 7; Comparative Developer 7 moreover causes a high degree

of sludging in the processor and the sludge is difficult to remove. Although the Comparative Developer 6 also improves the dot sharpening, it leads to toning problems during printing.

The use of component (iii) of the developer in an amount of <1 wt.-% (see Comparative Example 11) leads to a clear decrease in the developing speed. The additional use of a polyoxyethylene phenylether and of $K_2CO_3$ or $K_2CO_3$ alone does not provide all the desired effects, either (see Comparative Examples 8 to 10).

It can be inferred from Comparative Examples 3 and 4 - compared with Example 1 - that the type of alkaline reagent surprisingly has a considerable influence on the dot sharpening during printing.

Comparative Examples 5 and 7 show that the use of an ethoxylated monoalcohol leads to clearly different results than the ethoxylated dialcohol of formula (I) or (Ia) used according to the present invention.

Comparative Example 12 furthermore shows that the developer used according to the present invention is not suitable for positive working plates.

**Table 7:**

| Example | Photopolymer layer according to table | Developer | Exposure wavelength/ energy | Developability | Sludge formation in processor | Relative dot sharpening | Toning on printing machine | Attack of EPDM pump valves | Yellow light stability |
|---|---|---|---|---|---|---|---|---|---|
| Example 1 | 1 | D1 | 405 nm/ 40μJ/cm$^2$ | 5 s | A | 72 | no | > 3 months | > 60 min |
| Example 2 | 1 | D2 | 405 nm/ 40μJ/cm$^2$ | 5 s | A | 95 | no | > 3 months | > 60 min |
| Example 3 | 1 | D3 | 405 nm/ 40μJ/cm$^2$ | 5 s | A | 67 | no | > 3 months | > 60 min |
| Example 4 | 2 | D1 | 405 nm/ 40μJ/cm$^2$ | 5 s | A | 88 | no | > 3 months | > 60 min |
| Example 5 | 3 | D1 | 830 nm/ 100mJ/cm$^2$ | 5 s | A | 92 | no | > 3 months | > 60 min |
| Example 6 | 4 | D1 | 830 nm/ 75mJ/cm$^2$ | 5 s | B | 10 | no | > 3 months | > 60 min |
| Comp. Example 1 | 1 | CD1 | 405 nm/ 40μJ/cm$^2$ | > 60 s | n.d.[1)] | n.d. [1)] | n.d.[1)] | > 3 months | n.d. [1)] |
| Comp. Example 2 | 1 | CD2 | 405 nm/ 40μJ/cm$^2$ | > 60 s | n.d.[1)] | n.d. [1)] | n.d.[1)] | > 3 months | n.d. [1)] |
| Comp. Example 3 | 1 | CD3 | 405 nm/ 40μJ/cm$^2$ | 10 s | B | 350 [2)] | no | > 3 months | > 60 min |
| Comp. Example 4 | 1 | CD4 | 405 nm/ 40μJ/cm$^2$ | 10 s | B | 420 [2)] | no | > 3 months | > 60 min |
| Comp. Example 5 | 1 | CD5 | 405 nm/ 40μJ/cm$^2$ | 10 s | B | 270 | no | > 3 months | > 60 min |
| Comp. Example 6 | 1 | CD6 | 405 nm/ 40μJ/cm$^2$ | 5 s | A | 80 | yes | > 3 months | > 60 min |
| Comp. Example 7 | 1 | CD7 | 405 nm/ 40μJ/cm$^2$ | 5 s | C | 100 | no | Pump defect after 4 weeks | > 60 min |

(continued)

| Example | Photopolymer layer according to table | Developer | Exposure wavelength/ energy | Developability | Sludge formation in processor | Relative dot sharpening | Toning on printing machine | Attack of EPDM pump valves | Yellow light stability |
|---|---|---|---|---|---|---|---|---|---|
| Comp. Example 8 | 5 | CD8 | 405 nm/ $40\mu J/cm^2$ | 15s | C | 140 | no | Pump defect after 5 weeks | 20 s |
| Comp. Example 9 | 1 | CD8 | 405 nm/ $40\mu J/cm^2$ | 10 s | C | 120 | no | Pump defect after 5 weeks | >60 min |
| Comp. Example 10 | 1 | CD9 | 405 nm/ $40\mu J/cm^2$ | > 60 s | n.d. [1] | n.d. [1] | n.d. [1] | >3 months | n.d. [1] |
| Comp. Example 11 | 1 | CD 10 | 405 nm/ $40\mu J/cm^2$ | >60 s | n.d. [1] | n.d. [1] | n.d. [1] | >3 months | n.d. [1] |
| Comp. Example 12 | [3] | EI | 400 $mJ/cm^2$ [4] | entire coating removed | n.d. [1] | n.d. [1] | n.d. [1] | >3 months | n.d. [1] |

[1] n.d.: not determined since the plate could not be developed

[2] strong dot sharpening at 2% and 5% points

[3] A conventional commercially available positive plate (Easy Print von Kodak Polychrome Graphics) was used whose coating comprises naphthoquinone diazide and a cresol-formaldehyde novolak (cf. DE 322 33 86)

[4] Exposure with Hg metal halide lamp (emission in the range of 350 to 450 nm) in conventional vacuum copying frame

## Claims

**1.** A process for the production of lithographic printing plates comprising

(a) providing a lithographic substrate with a hydrophilic surface;
(b) applying a negative working radiation-sensitive composition onto the hydrophilic surface, wherein the composition comprises:

(i) one or more types of monomers and/or oligomers and/or polymers, each comprising at least one ethylenically unsaturated group accessible to a free-radical polymerization,
(ii) at least one sensitizer which in the presence of at least one coinitiator and upon irradiation with radiation of a wavelength of 300 to <480 nm or >750 to 1,100 nm initiates the free-radical polymerization of component (i); and
(iii) at least one binder with acidic functional groups and is not particularly sensitive to the wavelength range of 480 to 750 nm; wherein the composition does not contain metallocenes;

(c) image-wise exposure of the resulting negative working lithographic printing plate precursor to radiation selected from the wavelength range of 300 to <480 nm or >750 to 1,100 nm depending on the sensitizer or initiator system used; and
(d) removing the non-irradiated areas by means of a treatment with an alkaline developer with a pH value in the range of 9 to 14 comprising

(i) water,
(ii) one or more alkali hydroxides in an amount sufficient for adjusting a pH value in the range of 9 to 14, and
(iii) 1 to 30 wt.-% of at least one compound of formula (I)

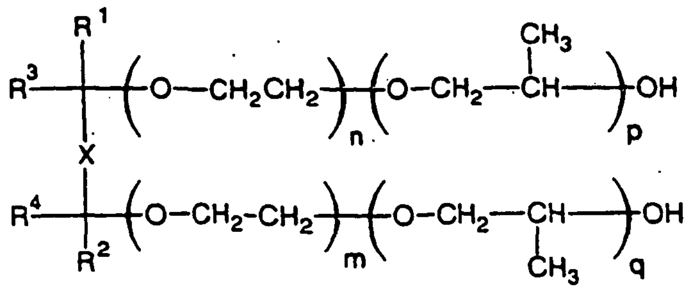

(I)

wherein $R^1$, $R^2$, $R^3$ and $R^4$ are each independently selected from $C_1$-$C_{12}$ alkyl groups and aryl groups,
X is selected from -CH=CH-, -C≡C-,

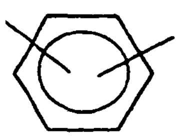
,
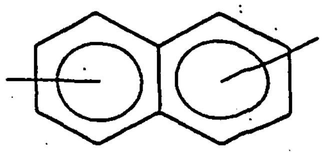
,

and

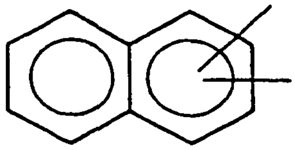

,

n + m results in a value of 2 to 30 and
p + q results in a value of 0 to 30, wherein in the case of p + q ≠ 0 the ethylene oxide and propylene oxide units are present as blocks or randomly distributed; wherein the developer does not contain silicates.

2. Process according to claim 1, wherein the sensitizer absorbs radiation of a wavelength in the range of 300 to <480 nm and forms free radicals together with the coinitiator, or the sensitizer absorbs radiation of a wavelength in the range of >750 to 1,100 nm and forms free radicals together with the coinitiator.

3. Process according to claim 2, wherein the UV-absorbing sensitizer is selected from 1,4-dihydropyridines, oxazoles, bisoxazoles and analogues and coumarins, or the IR-absorbing sensitizer is selected from the class oftriarylamine dyes, thiazolium dyes, indolium dyes, oxazolium dyes, cyanine dyes, polyaniline dyes, polypyrrol dyes, polythiophene dyes and phthalocyanine dyes and pigments.

4. Process according to any of claims 1 to 3, wherein in formula (I) of component (iii) of the developer X represents -C≡C-.

5. Process according to any of claims 1 to 4, wherein p + q results in a value >0.

6. Process according to any of claims 1 to 5, wherein component (iii) of the developer has the formula (Ia)

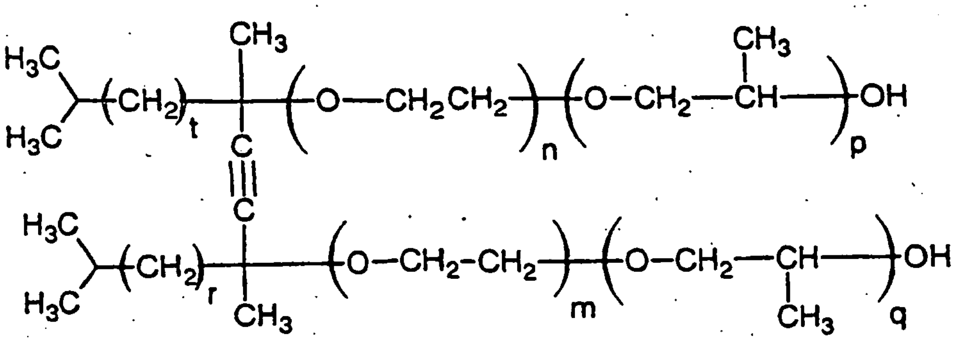

(Ia)

wherein m, n, p and q are as defined in claim 1 and
t and r are independently integers from 1 to 10.

7. Process according to any of claims 1 to 6, wherein component (iii) of the developer is present in an amount of 2 to 10 wt-%.

8. Process according to any of claims 1 to 7, wherein prior to step (c), an oxygen-impermeable overcoat layer was applied to the negative working radiation-sensitive coating.

9. Process according to any of claims 1 to 8, wherein the exposed precursor obtained in step (c) is heated prior to step (d).

10. An imaged printing form obtained by the process of any of claims 1 to 9.

## Patentansprüche

1. Verfahren zur Herstellung von Lithographie-Druckplatten, umfassend

(a) Bereitstellen eines lithographischen Trägers mit hydrophiler Oberfläche;
(b) Aufbringen einer negativ arbeitenden strahlungsempfindlichen Zusammensetzung auf die hydrophile Oberfläche, wobei die Zusammensetzung:

(i) ein oder mehrere Arten Monomere und/oder Oligomere und/oder Polymere mit jeweils mindestens einer ethylenisch ungesättigten Gruppe, die einer radikalischen Polymerisation zugänglich ist,
(ii) mindestens einen Sensibilisator, der in Gegenwart mindestens eines Coinitiators und bei Bestrahlung mit Strahlung einer Wellenlänge von 300 bis $<480$ nm oder $>750$ bis 1100 nm die radikalische Polymerisation von Komponente (i) einleitet; und
(iii) mindestens ein Bindemittel mit sauren funktionellen Gruppen umfasst und für den Wellenlängenbereich von 480 bis 750 nm nicht wesentlich empfindlich ist; wobei die Zusammensetzung keine Metallocene enthält;

(c) bildweises Bestrahlen des erhaltenen negativ arbeitenden Lithographie-Druckplattenvorläufers mit einer in Abhängigkeit vom verwendeten Sensibilisator oder Initiatorsystem ausgewählten Strahlung aus dem Wellenlängenbereich von 300 bis $<480$ nm oder $>750$ bis 1100 nm; und
(d) Entfernen der nichtbestrahlten Bereiche durch Behandlung mit einem alkalischen Entwickler mit einem pH-Wert im Bereich von 9 bis 14, umfassend

(i) Wasser,
(ii) ein oder mehrere Alkalihydroxide in einer Menge, die ausreicht, um einen pH-Wert im Bereich von 9 bis 14 einzustellen, und
(iii) 1 bis 30 Gew.% mindestens einer Verbindung der Formel (I)

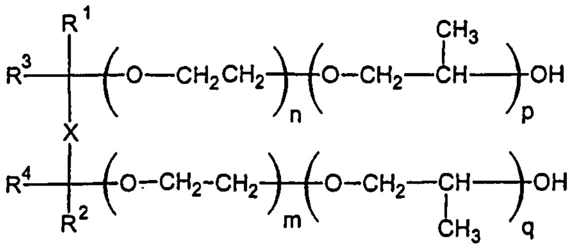

(I)

wobei $R^1$, $R^2$, $R^3$ und $R^4$ jeweils unabhängig aus $C_1$-$C_{12}$-Alkylresten und Arylresten ausgewählt werden,
X ausgewählt wird aus -CH=CH-, -C≡C-,

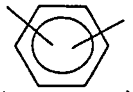
,
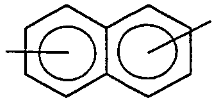
,

und

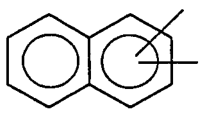
,

n + m einen Wert von 2 bis 30 ergibt und
p + q einen Wert vom 0 bis 30 ergibt, wobei die Ethylenoxid- und Propylenoxideinheiten bei p + q ≠ 0 blockweise oder in statistischer Verteilung vorliegen;
wobei der Entwickler keine Silikate enthält.

2. Verfahren gemäß Anspruch 1, wobei der Sensibilisator Strahlung mit einer Wellenlänge aus dem Bereich von 300 bis <480 nm absorbiert und zusammen mit dem Coinitiator Radikale bildet, oder der Sensibilisator Strahlung mit einer Wellenlänge aus dem Bereich von >750 bis 1100 nm absorbiert und zusammen mit dem Coinitiator Radikale bildet.

3. Verfahren gemäß Anspruch 2, wobei der UV-absorbierende Sensibilisator ausgewählt wird aus 1,4-Dihydroxypyridinen, Oxazolen, Bisoxazolen und Analogen und Coumarinen, oder der IR-absorbierende Sensibilisator ausgewählt wird aus der Klasse der Triarylaminfarbstoffe, Thiazoliumfarbstoffe, Indoliumfarbstoffe, Oxazoliumfarbstoffe, Cyaninfarbstoffe, Polyanilinfarbstoffe, Polypyrrolfarbstoffe, Polythiophenfarbstoffe und Phthalocyaninfarbstoffe und -pigmente.

4. Verfahren gemäß einem der Ansprüche 1 bis 3, wobei in Formel (I) der Komponente (iii) des Entwicklers X für -C=C- steht.

5. Verfahren gemäß einem der Ansprüche 1 bis 4, wobei p + q einen Wert >0 ergeben.

6. Verfahren gemäß einem der Ansprüche 1 bis 5, wobei die Komponente (iii) des Entwicklers die Formel (Ia) aufweist

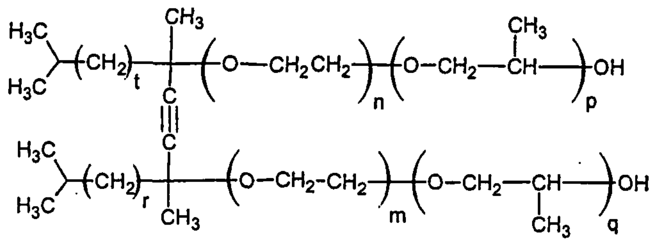

(Ia) ,

in der m, n, p und q wie in Anspruch 1 definiert sind und t und r unabhängig voneinander ganze Zahlen von 1 bis 10 sind.

7. Verfahren gemäß einem der Ansprüche 1 bis 6, wobei die Komponente (iii) des Entwicklers in einer Menge von 2 bis 10 Gew.% vorhanden ist.

8. Verfahren gemäß einem der Ansprüche 1 bis 7, wobei auf die negativ arbeitende strahlungsempfindliche Beschichtung vor Schritt (c) eine sauerstoffsperrende Deckschicht aufgebracht wird.

9. Verfahren gemäß einem der Ansprüche 1 bis 8, wobei der in Schritt (c) erhaltene bestrahlte Vorläufer vor Schritt (d) erwärmt wird.

10. Bebilderte Druckform, die durch das Verfahren gemäß einem der Ansprüche 1 bis 9 erhalten wird.

## Revendications

1. Procédé de production de plaques d'impression lithographiques consistant à :

(a) former un substrat lithographique ayant une surface hydrophile ;
(b) appliquer une composition sensible aux rayonnements à effet négatif sur la surface hydrophile, la composition comprenant :

(i) un ou plusieurs types de monomères et/ou d'oligomères et/ou de polymères, chacun contenant au moins

un groupe à insaturation éthylénique pouvant faire l'objet d'une polymérisation radicalaire,

(ii) au moins un sensibilisateur qui, en présence d'au moins un co-initiateur et après irradiation par un rayonnement d'une longueur d'onde de 300 à < 480 nm ou de > 750 à 1 100 nm, initie la polymérisation radicalaire du composant (i) ; et

(iii) au moins un liant ayant des groupes fonctionnels acides,

et n'étant pas particulièrement sensible à l'intervalle de longueurs d'onde de 480 à 750 nm ;

où la composition ne contient pas de métallocènes ;

(c) exposer, conformément à l'image, le précurseur de plaque d'impression lithographique à effet négatif obtenu au rayonnement sélectionné dans l'intervalle de longueurs d'onde de 300 à < 480 nm ou de > 750 à 1 100 nm, selon la sensibilisateur ou le système initiateur utilisé ; et

(d) éliminer les zones non irradiées par un traitement au moyen d'un révélateur alcalin à une valeur de pH de 9 à 14 et comprenant

(i) de l'eau,

(ii) un ou plusieurs hydroxydes alcalins en quantité suffisante pour ajuster une valeur de pH de 9 à 14, et

(iii) de 1 à 30% en poids d'au moins un composé de formule (I)

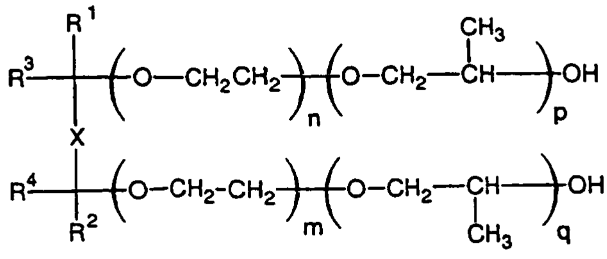

(I)

où $R^1$, $R^2$, $R^3$ et $R^4$ sont chacun indépendamment sélectionnés dans le groupe contenant les groupes alkyle en $C_1$-$C_{12}$ et les groupes aryle,

X est sélectionné parmi les groupes -CH=CH-, -C≡C-,

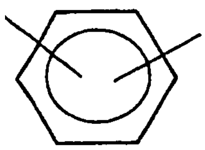

,

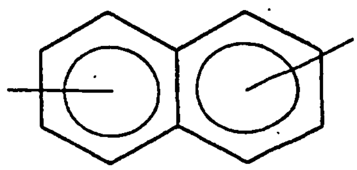

et

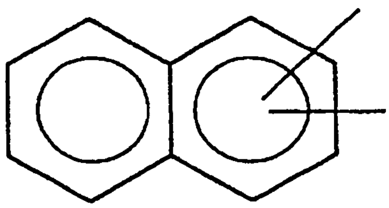

n + m ont une valeur de 2 à 30, et

p + q ont une valeur de 0 à 30, où dans le cas de p + q ≠ 0, les unités d'oxyde d'éthylène et d'oxyde de propylène sont présentes sous la forme de blocs ou sont réparties de façon aléatoire ;

où le révélateur ne contient pas de silicates.

2. Procédé selon la revendication 1, dans lequel le sensibilisateur absorbe le rayonnement d'une longueur d'onde de 300 à < 480 nm et forme des radicaux libres avec le co-initiateur, ou le sensibilisateur absorbe le rayonnement d'une longueur d'onde de > 750 à 1 100 nm et forme des radicaux libres avec le co-initiateur.

3. Procédé selon la revendication 2, dans lequel le sensibilisateur absorbant le rayonnement UV est sélectionné dans le groupe contenant les 1,4-dihydropyridines, les oxazoles, les bisoxazoles, et leurs analogues et les coumarines ou le sensibilisateur absorbant le rayonnement IR est sélectionné dans le groupe contenant la classe des colorants triarylamine, des colorants thiazolium, des colorants indolium, des colorants oxazolium, des colorants cyanine, des colorants polyaniline, des colorants polypyrrol, des colorants polythiophène et des colorants et des pigments phtalocyanine.

4. Procédé selon l'une quelconque des revendications 1 à 3, dans lequel, dans la formule (I) du composant (iii) du révélateur, X représente un groupe -C≡C-.

5. Procédé selon l'une quelconque des revendications 1 à 4, dans lequel p + q ont une valeur > 0.

6. Procédé selon l'une quelconque des revendications 1 à 5, dans lequel le composant (iii) du révélateur est représenté par la formule (Ia)

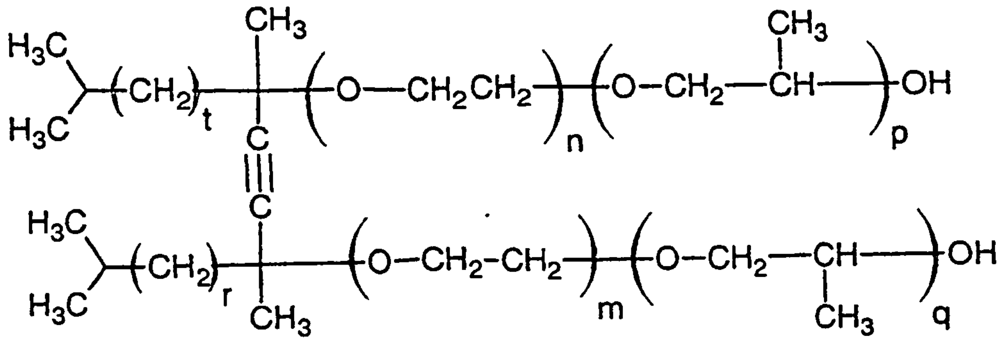

(Ia)

dans laquelle m, n, p et q sont tels que définis dans la revendication 1, et
t et r sont indépendamment des nombres entiers de 1 à 10.

7. Procédé selon l'une quelconque des revendications 1 à 6, dans lequel le composant (iii) du révélateur est présent en une quantité de 2 à 10% en poids.

8. Procédé selon l'une quelconque des revendications 1 à 7, dans lequel, avant l'étape (c), on applique une surcouche imperméable à l'oxygène sur le revêtement sensible aux rayonnements à effet négatif.

9. Procédé selon l'une quelconque des revendications 1 à 8, dans lequel le précurseur exposé obtenu dans l'étape (c) est chauffé avant l'étape (d).

10. Forme d'impression imagée obtenue par le procédé selon l'une quelconque des revendications 1 à 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- DE 3223386 A1
- EP 1115035 A1
- US 6455234 B1
- EP 1253472 A2
- EP 0732628 A1
- JP 2000056480 A
- DE 4411176 A1
- EP 1199606 A1
- EP 1353235 A1
- US 6686126 B2
- EP 1172699 A1
- US 3586504 A
- EP 1346843 A1
- US 6641980 B2
- US 4098712 A
- US 4959296 A
- EP 0111136 A2
- EP 0269760 A1
- US 20040053172 A1
- JP 8286386 A
- JP 2000194135 A
- JP 10171128 A
- JP 2003162072 A
- EP 1260867 A1
- US 6638687 B2
- EP 1213619 A1
- WO 0231599 A
- DE 19845605 A1
- EP 0080042 A1
- DE 4311738 A
- DE 3332640 A
- US 6746820 B
- EP 1176007 A1
- DE 4217495 A1
- DE 4418645 C1
- DE 3801065 C2
- EP 1041074 A1
- DD 287796 A
- DE 120875 A1
- EP 129059 A1
- EP 0129059 A1
- US 3257203 A
- US 5629354 A
- EP 1035435 A1
- US 4565769 A
- US 3445232 A
- US 20020025489 A1
- US 6309792 B1
- WO 9906890 A
- US 6313182 B2
- WO 0231599 A2
- US 4355096 A
- DE 3223386


### Non-patent literature cited in the description


- **K.K. DIETLIKER.** Chemistry & Technology of UV &EB formulation for coatings, inks & prints. SITA Technology, 1991, vol. 3
- *J. Org. Chem.,* 1965, vol. 30, 1914
- *Angew. Chem. [Applied Chemistry] (Intern.,* 1981, vol. 20, 762
- **A. DORLARS et al.** *Angew. Chemie [Applied Chemistry,* 1975, vol. 87, 693-707
- **C. LAMBERT.** Bridge-mediated hopping or superexchange electron-transfer processes in bis(triarylamine) systems. *Nature-Materials,* 2002, vol. 1, 69
- **A. DE MEIJIRE ; F. DIEDERICH.** Metal Catalyzed Cross-Coupling Reactions. Wiley-VCH, 2004
- *Macromolecules,* 1999, vol. 32, 7409-7413
- *Macromolecules,* 2001, vol. 33, 7426-7430
- *Macromolecules,* 2001, vol. 34, 4124-4129